(19) Europäisches Patentamt
European Patent Office
Office européen des brevets

(11) Publication number: **0 085 397**
**B1**

(12) # EUROPEAN PATENT SPECIFICATION

(45) Date of publication of patent specification: **27.04.88**

(51) Int. Cl.$^4$: **C 30 B 25/16**

(21) Application number: **83100728.1**

(22) Date of filing: **27.01.83**

(54) **Semiconductor vapor phase growing apparatus.**

(30) Priority: **28.01.82 JP 11997/82**
**28.06.82 JP 111131/82**

(43) Date of publication of application:
**10.08.83 Bulletin 83/32**

(45) Publication of the grant of the patent:
**27.04.88 Bulletin 88/17**

(84) Designated Contracting States:
**DE FR GB IT SE**

(56) References cited:

**PATENTS ABSTRACTS OF JAPAN, vol. 4, no. 170, (E-35) (652), November 22, 1980**
**PRODUCT ENGINEERING, January 1977, pages 21-23, "Microprocessor logic that's almost free has big effect on machine control"**

**JOURNAL OF THE ELECTROCHEMICAL SOCIETY, vol. 121, no. 9, September 1974, pages 1233-1237, K. SUGAWARA et al.: "In situ monitoring of film deposition using He-Ne-laser system"**

(73) Proprietor: **TOSHIBA KIKAI KABUSHIKI KAISHA**
**2-11, Ginza 4-Chome Chuo-ku**
**Tokyo-To (JP)**

(72) Inventor: **Ebata, Hitoshi**
**8-22, Kiyozumi-Cho**
**Mishima-Shi Shizuoka-Ken (JP)**
Inventor: **Matunaga, Shigetugu**
**279-4, Osaka**
**Gotenba-Shi Shizuoka-Ken (JP)**

(74) Representative: **Reichel, Wolfgang, Dipl.-Ing. et al**
**Reichel und Reichel Parkstrasse 13**
**D-6000 Frankfurt am Main 1 (DE)**

**EP 0 085 397 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention relates to a semiconductor vapor phase growing apparatus. So called vapor phase growing apparatus in which vapor phase growth is performed on a semiconductor wafer has called attention in recent years because semiconductor chips are used in various industrial fields.

A vapor phase growing apparatus is, for example, described in "Patents Abstracts of Japan", Vol. 4, No. 170, (E-35) (652) November 22, 1980. A high-frequency heating coil is provided around a reaction furnace coupled to a reactant gas feeder and provided with a pipe line network for interconnecting said furnace and said feeder. A portion of a material gas is extracted, the quantity of the extracted gas is measured and the measured value is fed back to an auxiliary gas supply. A microcomputer is used to calculate the concentration of the material gas from outputs of an analysis chamber for said feedback. Although this system provides a concentration control, important quantities like furnace temperature and timing of the process of vapor phase growth are not taken into consideration.

In another vapor phase growing apparatus now being used, a sequence program (hereinafter termed a process program) indicative of the progress in a reaction furnace is executed by a system in which the progress of the sequence is designated by a pin board switch or the like, and the flow quantity of the gas used and the furnace temperature are designated by setting variable resistors contained in a control device by an operator.

Fig. 1 is a block diagram explaining the conventional manner of controlling the progress of the process in a reaction furnace with a pin board switch system.

In Fig. 1, pins are inserted into a set panel of a pin board switch according to an order of execution of a process program PPi (i=1—17), and the set panel is constructed such that the sequence times of the process program of the respectively designated orders can be set in the units of hours, minutes and seconds.

To a relay ladder circuit B are applied instructions corresponding to the order of a sequence, that is instructions that make effective the contents of process programs pp2, pp3, pp4, pp6, pp5 and pp6 corresponding to steps ①, ②, . . ., ⑥, ⑦ so as to give control signals to valves or like means corresponding to respective instructed processes. With such pin board system, however, only the times of respective process sequences can be set, but the flow quantity of the gas used and the furnace temperature must be set with other measures, for example variable resistors.

In addition to the pin board system shown in Fig. 1, a control device utilizing a general purpose sequence controller has also been proposed. In such control device too, the flow quantity and the furnace temperature are not designated by directly programmed data so that such setters as variable resistors are necessary.

Furthermore, in the pin board system described above, only one group of a series of programs corresponding to one cycle of the reaction furnace, that is only one set of

$$pp2 \rightarrow pp3 \rightarrow pp1 \rightarrow pp4 \rightarrow pp6 \rightarrow pp5 \rightarrow pp7$$

shown in Fig. 1 can be loaded so that in order to operate a plurality of reaction furnaces a plurality of pin board panel units corresponding thereto should be provided. In this regard, since the general purpose controller contains a timer, only a problem of time designation program is involved. Where the general purpose program is used, since its process program is not constructed to designate the gas flow quantity and the furnace temperature, setters of these parameters have been used. Principal reasons are as follows.

1. Although the system program of a general purpose sequence controller is prepared by its maker, just like the pin board system, the decoding items of the content of the process program according to its system program lack the items regarding gas flow quantity used and the reaction furnace designation temperature. For this reason, the gas flow quantity and the furnace temperature are set by such independent setters as variable resistors or the like manipulated by the operator.

2. From the standpoint of the operator, manipulation of the general purpose sequence controller, the ability of directly controlling the gas flow quantity and the furnace temperature are equivalent to those of the pin board system so that the operator can operate the reaction furnace without any caution. Especially, correction of set values can be made readily.

3. From the standpoint of the maker, where manual setters for the gas quantity and the furnace temperature are omitted, it is necessary to modify the system program so as to include a program for correcting the content of the process program as a portion of the system program.

Since the reaction temperature in the furnaces is about 1200°C, at start, the furnace temperature is raised to 1200°C from room temperature. However, when the temperature is raised rapidly the wafers crack resulting in a so-called slip phenomenon. Accordingly, it is necessary to control the output V of a high frequency source of the reaction furnace such that the temperature of the furnaces varies linearly, as shown in Fig. 25.

Such control is made with a control unit to be described later such that it merely applies control signals for controlling valves of various gases and cooling water, and for supplying and interrupting heating power.

In contrast, the flow quantities of the gases and the furnace temperature, the most important factors in

actual operation, are set by such setters as variable resistors. In other words, these important factors are not controlled by the control device.

For example, an inclination angle θ (Fig. 25) of the source output is set by a setter so as to gradually increase the source output as shown in Fig. 25 while only the heating time is controlled by the sequence controller.

However, the temperature of a support adapted to support wafer rises slowly as shown by a heavy line in Fig. 25 due to the heat capacity of the support, thus failing to follow up the increase in the source output. More particularly, the temperature of the support increases very slowly at the start of the heating and then rises abruptly. Accordingly, the wafers are subjected to this abrupt temperature variation, thus causing slip. These problems have been solved by thickening the support or by gradually increasing the furnace temperature. However, these measures prolong the vapor phase growing time, thus increasing the cost of the products.

Another method of solving these problems utilizes a commercial temperature controller. This method can eliminate the defects of the first method in which the inclination angle θ is set by a variable resistor. More particularly, as shown in Fig. 26, the heating time required for the support to reach the operating temperature 1200°C, is divided into a plurality of sections $P_1$, $P_2$, . . ., $P_n$ by taking into consideration the temperature characteristic of the support, and rates of temperature variations of respective sections are preset so that the output increase rate of the source will become high in time zones in which the rate of temperature rise of the support is low, whereas the output increase rate will be low in time zones in which the rate of temperature rise of the support is high.

Although this method enables to linearly control the temperature of the support, it is necessary to set the rate of change at many points and to measure the actual temperature characteristic of the support for setting the temperature change rates. Such troublesome measurement and setting must be made each time the support is exchanged.

Where the temperature is repeatedly raised and lowered in one process sequence and where the selected inclination angle θ differs in respective sequences, it is necessary to provide the temperature controllers of the same number as that of the sequences, thus increasing the cost of the control system.

It is a principal object of this invention to provide vapor phase growing apparatus provided with an improved program control device prestoring the contents of all process instructions so as to simplify the setting operation of the operator where a plurality of reaction furnaces are operated alternately.

Another object of this invention is to provide vapor phase growing apparatus in which a modifying program that corrects the contents of the process program is included in the system program.

Still another object of this invention is to provide vapor phase growing apparatus wherein where a group of process programs corresponding to a one cycle operation of a reaction furnace is prestored in an external memory medium, there is provided an input device combined with the external memory medium to receive therefrom a group of the process programs.

A further object of this invention is to provide vapor phase growing apparatus wherein where induction heating coils in a plurality of reaction furnaces are connected to a common high frequency source via a transfer switch, the timings of supplying electric powers to respective reaction furnaces are adjusted to efficiently supply high frequency powers to respective reaction furnaces from the high frequency source.

Still further object of this invention is to provide vapor phase growing apparatus provided with a system program comprising a program for forming a process program adapted to form a group of process programs corresponding to one cycle of a reaction furnace based on an operating table of the cycle.

Another object of this invention is to provide improved semiconductor vapor phase growing apparatus capable of efficiently growing semiconductor layers on semiconductor wafers by uniformly increasing the temperature thereof at a high speed without causing slip of the wafers.

According to this invention, there is provided semiconductor vapor phase growing apparatus comprising a reaction furnace for vapor phase growing a semiconductor on a semiconductor substrate; means for heating the substrate; sources of various gases necessary for vapor phase growth; a pipe line network for interconnecting the reaction furnace and the sources; valve means connected in the pipe line network for supplying predetermined quantities of the gases to the reaction furnace; and control means for supplying control signals to the valve means; the control means including a first memory region for storing a process program group comprising a group of process programs including informations regarding a time for designating a process of vapor phase growth in the reaction furnace, gases utilized, flow quantities thereof and furnace temperature, and a second memory region storing a system program that decodes the program groups for producing control signals for the valve means.

Further objects and advantages of the invention will be more fully understood from the following detailed description taken in conjunction with the accompanying drawings, in which:

Fig. 1 is a block diagram useful to explain the operation of prior art vapor phase growth control apparatus;

Fig. 2 is a perspective view showing the outline of one embodiment of this invention;

Fig. 3 is a block diagram for explaining the flow of informations in a control system shown in Fig. 2;

Fig. 4 is a block diagram showing a control system for vapor phase growth according to this invention;

Fig. 5 is a front view showing the detail of the panel of the control apparatus shown in Fig. 2;

Fig. 6 is a longitudinal sectional view of a reaction furnace containing an induction heating coil;

Fig. 7 is a block diagram showing pipe lines interconnecting the reaction furnace shown in Fig. 6 and sources of various gases;

Fig. 8 is a block diagram showing the relation among a mass flow meter connected between a flow quantity controller and a control device for detecting the gas flow quantity and peripheral devices;

Fig. 9 is a table showing the flow quantities in pipe lines;

Fig. 10 is a timing chart where two reaction furnaces R1 and R2 are operated alternately;

Fig. 11 is a block diagram showing a time calculating unit at the time of alternate operation;

Figs. 12a and 12b are tables useful to explain the data construction of a process program and a group of process programs;

Fig. 13 is a flow chart showing the processing steps of the system program utilized in this invention;

Fig. 14 is a flow chart showing the detail of the subroutine ST3 shown in Fig. 13;

Fig. 15 is a flow chart showing the detail of the subroutine ST7 shown in Fig. 13;

Fig. 16 is a flow chart showing the detail of the subroutine ST10 shown in Fig. 13;

Fig. 17 is a flow chart showing the detail of the subroutine ST13 shown in Fig. 13;

Fig. 18 is a flow chart showing the detail of the subroutine ST15 shown in Fig. 13;

Fig. 19 is a flow chart showing the detail of the subroutine ST17 shown in Fig. 13;

Fig. 20 is a flow chart showing the detail of the subroutine ST19 shown in Fig. 13;

Fig. 21 is a flow chart showing the detail of the subroutine ST21 shown in Fig. 13;

Fig. 22 is a flow chart showing a second processing program related to the subroutine ST23 shown in Fig. 13;

Fig. 23 is a flow chart showing a waiting time calculation;

Fig. 24 is a diagrammatic representation of a reaction furnace of the lamp heating type;

Fig. 25 is a graph showing an ideal temperature rise and an actual temperature rise;

Fig. 26 is a graph showing a prior art method of controlling the temperature rise of the support;

Fig. 27 is a graph showing the variation of the target value of the temperature control according to a modification of this invention;

Fig. 28 is a flow chart showing the input routine of a ramp control information of a modification of this invention;

Fig. 29 is a flow chart showing a ramp control routine; and

Fig. 30 is a flow chart showing a second processing program.

The semiconductor vapor phase growing apparatus of this invention shown in Fig. 2 comprises a high frequency generator 11, reaction furnaces R1 and R2, and a control device 14 which controls the gas flow quantities to respective reaction furnaces and the temperature thereof. The control device 14 is provided with a control panel 14A including an operating key input unit 14A-1, a display unit 14A-2, etc., and the detail of the control device 14 is shown in Fig. 5. There are also provided operating boards for controlling the operation of the reaction furnaces R1 and R2.

Basic elements necessary for operating the vapor phase growing apparatus shown in Fig. 2 are diagrammatically shown in Fig. 3 in which a process program given by operating a key circuit 14A-1, a process program prestored in a cassette magnetic tape 15, or an inner memory unit 17 in the control device 14 is applied to a processor 14-1. The apparatus is constructed so that in response to the inputted process program, the operation of valves provided for a machine drive unit 16 and the degree of opening of the valves will be controlled.

The content of the processings executed by the processor 14-1 and the input informations to the processor 14-1 are displayed by a display device 14A-2. Reference character 12(13) represents the main body of the apparatus corresponding to Fig. 2, and quantities of gases set by the machine drive unit 16 are supplied to reaction furnaces R1 and R2. The machine drive unit 16, necessary pipings, valves etc. are provided on the rear side and bottom side of the vapor phase growing apparatus 12 and 13.

In a block diagram of the control system showing a preferred embodiment of this invention and shown in Fig. 4, 21 designates a central processing unit CPU of a master computer and data bus line 22 and an i/o bus line 23 are connected to the CPU21. To the data bus line 22 are connected a memory device (ROM) 24 prestoring a group of process programs to be executed in the reaction furnaces R1 or R2, a CRT RAM 25 for temporarily storing the contents to be displayed on a display device CRT29, a temporary memory device (RAM)26 and a memory device 27 for storing various system programs necessary to operate the system of this invention.

The temporary memory device 26 is utilized to store data utilized during the operation of the system, for example, input data from a keyboard 31, ON and OFF informations of various switches, and a group of process programs given from such external memory medium as a cassette tape or the like. A CRT interface 28 is connected to the i/o bus line 23 to give a content to be displayed on CRT29. Further, input modules 30 and 32 are provided for temporarily storing input data signals from the keyboard 31, and signals from a pressure switch RS and a limit switch LS respectively.

Output modules 34, 36 and 38 are connected to the i/o bus line 23 so as to give output instructions to an output unit 35 of lamps, LED's, and to valves, process gas valves 37 and a relay driver 39. 40 represents electric motors and valves driven by the relay driver 39, the motors and valves being used to rotate a support or "suscepta" of respective reaction furnaces R1 and R2 and to drive cylinders for opening and closing the lids of the furnaces.

Furthermore, a D/A conversion module (DAM)41, and an A/D conversion module (ADM)43 are connected to the i/o bus line 23, the DAM41 giving a control voltage (in an analogue quantity) designating the gas flow quantities flowing through flow quantity control valves MFC, TiC and VCl. The ADM43 is connected to receive an analogue signal as a feedback signal, from a detector that detects flow quantities flowing through respective control valves for converting the received analogue signal into a digital signal.

A sub-CPU46 operates to transfer and store a group of process programs stored in a cassette, magnetic tape (CMT)51 to a temporary memory device (RAM)53 via an interface 49 and to write a group of process programs stored in the RAM53 into CMT51 according to the system program stored in the memory device ROM52. RAM53 and sub-CPU46 are interconnected by a data bus line 48, while an i/o bus line 54 is provided to interconnect the interface 49, a high speed memory data transfer unit (HMT)50 and sub-CPU46.

Another high speed memory data transfer unit (HMT)45 is connected to the i/o bus line 23, the two high speed memory data transfer units 45 and 50 being interconnected by a data highway 47 so that the content of RAM53 can be transferred to RAM26 and vice versa. With this connection, the problems that the computation speed of CPU21 is limited, the time required for reading out process program data from CMT51 or magnetic card or the like and for writing the read out data into CMT51 is long, can be solved.

Of course, instead of using circuit elements 46—54, the data can be exchanged between an input/output module connected to the i/o bus line 23.

Among the system programs stored in ROM27 may be mentioned:

i. A system or process program which controls CPU21 to sequentially read out a group of process programs (PPG) stored in the RAM26 and then decode the read out process programs into corresponding sequence instructions.

ii. A modifying program (MODIFY) which controls CPU21 so as to modify the PPG stored in RAM26.

iii. A process program forming a program (PROCESS) for forming a new PPG by inputting necessary data by using the keyboard 31.

iv. A RUN system program displaying on CRT29 a process now being executed.

v. A system program STEP that converts any process program PPi, the group of process programs PPG, into another process program PP(j).

vi. A system program (STORE) for storing PPG stored in RAM26 into an external memory medium, for example CMT51, via RAM53.

vii. A system program (SORT) performing reverse performance to STORE.

viii. Verifying program (VERIFY) for verifying PPG stored in RAM26 before executing the PPG with the system program PROCESS · C,

ix. A system program that performs a self-diagnosis during the operation of the system of this invention.

x. A system program (USED TIME) for calculating the processing time used for the execution of one group of the process programs, and

xi. A system program for executing various tests.

By designating one of them by CPU21, the CPU21 executes a necessary calculation according to the designated system program.

The detail of the operations of various system programs stored in ROM27 shown in Fig. 4 will be described later in detail with reference to flow charts.

The panel operating board shown in Fig. 5 of the control device shown in Fig. 2 comprises a display device 61, in the form of a cathode ray tube CRT for example, a cassette tape mounting device (CMT)62 which mounts a cassette magnetic tape, a keyboard or key input device 63, and a temperature controller 64 including a furnace temperature setting switch 64-1 and a temperature setting switch 64-2, and a display device 65 showing the type of the process program group PPG. An alarm buzzer 66-1 and an alarm reset button 66-2 are installed in an area 66, while a program start push button 67-1, a gas selection transfer switch 67-2, a thumb wheel switch 67-3 for a reaction furnace selection pattern, and a PPG selection designation thumb wheel switch 67-4 are provided in a data input area 67. The transfer switch 67-3 is constructed to have three positions, i.e. 0 at which only furnace R1 is used, 1 at which only furnace R2 is used and 2 at which both furnaces R1 and R2 are used. 67-5 designates a push button which is effective when depressed simultaneously with a push button 67-1.

A start switch 68-1, and a stop switch 68-2 are provided in an area 68, the former being used to issue an instruction for starting a sequence process of one PPG. There are also provided a switch 68-3 for controlling the induction heating furnace and a switch 69 for sequentially lighting LED's corresponding to the types of the processes in which the reaction is progressing. Each PPG comprises suitable combinations of 1—17 sequence processes and LED's $A_1$—$A_9$ for displaying alarms are provided at the lower portion of the area 68.

Fig. 6 shows a vertical sectional view of the reaction furnace R1 or R2. As shown an inlet pipe 72 for supplying gas used for vapor phase growth in the furnace extends vertically through the center of a bottom plate 71. Thus, the gas rises upwardly through a pipe 74 and ejects into the interior of the furnace through an opening 73 at the top of the pipe 74. A rotary member 76 driven by a motor 77 with a reduction gearing is disposed to surround the pipe 74 to support a support 75. An induction heating coil 79 covered by a cover 78 is located beneath the support 75. An insulating plate 80 is secured above the base plate 71 by bolts 81 for supporting the coil 79. The induction heating coil 79 is connected to an external high frequency source,

not shown, through terminals 82 and 83. Cooling water is passed through the coil 79 for preventing temperature rise thereof caused by heat generated by high frequency current. A dome or lid 90 covering the heating coil 79 is made up of three layers, e.g. an inner quartz layer 84, a first stainless steel layer 85 and a second stainless steel layer 86. These layers are spaced by air gaps. A clamping member 88 operated by an air piston-cylinder device 89 is provided to clamp the flange 87 of the dome against the bottom plate 71.

The dome 90 is provided with a window 92 for observing support 75 and wafers 91 supported thereby, and a temperature detection window 93 in which is mounted a sensor TS which detects the temperature of the wafers 91 and support 75 by sensing light passing through a quartz layer 84.

A bracket 94 is integrally formed with the dome 90 and arranged to be moved downwardly by the piston of a cylinder, not shown, so as to open the dome 90 when mounting and dismounting the wafers.

Fig. 7 is a block diagram showing a gas piping network or system connected to reaction furnaces R1 and R2. Gases of $N_2$, $H_2$, DN (a N type dopant), DP (a P type dopant) and HCl are supplied to respective furnaces R1 and R2 through gas chambers 101, 102, 103, 104 and 105 respectively shown on the bottom side of Fig. 7. 106 designates a bubbling chamber containing liquid $SiCl_4$ or $SiHCl_3$.

A pipe line extending upwardly from chamber 101 is provided with a pressure switch PS1, a normal open valve $\overline{PV1}$ (a bar on PV1 shows normal open type) and a valve PV7.

In the same manner, a pipe line extending upwardly from gas chamber 102 is provided with a pressure switch PS2, valves PV2 and PV8. Outputs of valves PV7 and PV8 are combined and combined gases are supplied to pipe lines PL1 and PL2 respectively through mass flow valves MFC1 and MFC2.

Between pipe line PL1 and the furnace R1 are connected gas admixing valves PV19 and PV20 so as to combine gases supplied through pipes PL1A and PL2A with the gas supplied through pipe line PL1.

In the same manner, gas admixing valves PV21 and PV22 are provided between pipe line PL2 and the reaction furnace R2 to admix gases supplied through pipes PL1A and PL2A with the gas supplied through pipe line PL2.

Two pipe lines are provided between a valve VC1 and gas chamber 106 via a valve PV3. $H_2$ is admitted into port P0 of valve VC1 and then enters into the bubbling chamber 106 via port P2, pipe PL3 and valve PV3 for bubbling liquid $SiCl_4$ contained in the bubbling chamber 106. Consequently, a gaseous mixture of $H_2$ and $SiCl_4$ is formed in the upper space of the bubbling chamber 106 and the mixture is admitted into port P3 of valve VC1 via valve PV3 and a pipe line PL3′. The gas mixture is then sent to pipe line PL6A through port P1 of valve VC1.

$D_N$ gas acting as a dopant is supplied from gas chamber 103 to mass flow valves MFC4, MFC5 and MFC6 through a valve PV5. $H_2$ gas is supplied to the input ports of these mass flow valves through valve PV9 so that a mixture of $H_2$ and $D_N$ is supplied to the gas admixing valve PV19.

Similar circuit is provided for a gas chamber 104 containing $D_P$ acting as a dopant and includes mass flow valves MFC8, MFC9 and MFC10 and valve PV23.

A pipe line PL2A extending from the gas chamber 105 containing HCl includes a valve PV6A, and a mass flow valve MFC7 and the upper end of the pipe line PL2A is connected to the inlets of admixing valves PV20 and PV22. The upstream side of the mass flow valve MFC7 is connected to pipe line PL5 via a normal open valve $\overline{PV6B}$.

As shown in Fig. 8, instructions are applied to mass flow valves MFC1—MFC10 from a control device including the master CPU21 respectively via D/A converters 123. Outputs of flow quantity detectors attached to respective mass flow valves are sequentially applied to an analog multiplexer 122, and the output thereof is supplied to the controller via an analog digital converter 121.

Referring now to Fig. 9, digits 1—17 on the leftmost column correspond to respective process programs and the duration times of the sequences are shown in the next column in minutes and seconds. In a gas flow column, are listed gas flow quantities of the gases utilized in the sequences, while a temperature setting column designating the temperature θ°C in the reaction furnace is provided at the rightmost column.

A case wherein the operating table shown in Fig. 9 is applied to the connection diagram shown in Fig. 7 will be described as follows. In Fig. 9, the content of the process program PP(1) is to purge $N_2$ in which $N_2$ is passed at a rate of FN 1 l/min. $N_2$ gas is supplied to the reaction furnace R1 from gas chamber 101 (Fig. 7) via valves PV1, PV7, MFC1, PV19 and PV20 to purge this furnace. The flow quantity FN 1 l/min is given as a voltage instruction value to MFC1. The process program PP(2) is used to purge $H_2$, thus setting 3 minutes and a flow quantity of FH 2 l/min. $H_2$ gas enters into the reaction furnace R1 via valves PV2, PV8, MFC1, PV19 and PV20 and then discharged in the same manner as in the $N_2$ purge. In the above, FN 1l and FH 2l designate special codes utilized for executing the program.

The next process program PP(3) (hereinafter PP(i)) is used to HEAT ON(1). At this time, the quantity of $H_2$ supplied to the reaction furnace R1 is FH 2 l/min and the states of various valves are not altered. The induction heating furnace is set to a first level and heated for three minutes so as to obtain a first set temperature θ1.

At the next process program PP(4) the same flow quantity of $H_2$ is set and the furnace R1 is heated for 3 minutes to attain a second level of set temperature of θ2. The next process step PP(5) is used to VENT HCl. In this case, the heating time is set to 3 minutes and the flow quantities of $H_2$ and HCl are FH 2 l/min and FHCl 1 l/min respectively. HCl flows to a vent opening, not shown, via valves PV6A and MFC7. The flow quantity of HCl is set by an instruction voltage supplied to MFC7.

The next PP(6) is used to ETCH with HCl and continues for 3 min, and HCl is admixed with $N_2$ at gas admixing valve PV20 and the mixture is supplied to reaction furnace R1.

At the next PP(7) $H_2$ is again purged for 3 min.

PP(8) is a HEAT DOWN process in which the furnace temperature is changed from θ2 to θ3. Upon completion of PP(8) process lasting 3 min, preparation of the vapor phase growth is substantially completed and the process is advanced to PP(9). PP(9) is used as EPi VENT(1) lasting 3 min, in which $H_2$ is supplied at a rate of FH 2 l/min, dopant gas Dp at a rate of FDp cc/min, and $SiCl_4$ at a rate of $FSiCl_4$ 1 g/min. $H_2$ gas is supplied to chamber 106 via valves PV2, VC1 and PV3, and a gaseous mixture of $H_2$ and $SiCl_4$ is supplied to pipe line PL6A from chamber 106 via valves PV3 and VC1. Since dopant gas Dp is supplied from chamber 104 through valves PV23, MFC8, MFC9 and MFC10, the mixture of the dopant gas Dp, and gases $H_2$ and $SiCl_4$ reached the pipe line PL6A is exhausted through a vent opening.

PP(10) is used as EPi DEPO (a code meaning epitaxial deposition) in which the flow quantities of gases are the same as PP(9) but valve PV19 is opened. Consequently, gases Dp, $H_2$ and $SiCl_4$ are admixed by PV19 and then supplied to furnace R1 to form P type semiconductors on the wafers 91 supported by the support 75. The growing reaction at this time is a reversible hydrogen reduction reaction as shown by the following equation.

$$SiCl_4+2H_2 \rightleftarrows Si+4HCl$$

In this manner, Si is accumulated on respective wafers. Usually, phosphine ($PH_3$) is used as the dopant gas Dp.

As the dopant gas $D_N$ for growing N type semiconductors, is generally used diborane ($B_2H_4$). When 3 min elapses at PP(10), the vapor phase growth completes and at PP(11), $H_2$ is passed for 3 min at a rate of FH 2 l/min for purging.

PP(12), PP(13) and PP(14) are not used and PP(15) is used as HEAT OFF to deenergize the induction heating coil. 3 minutes are selected for decreasing the furnace temperature. During this interval, $H_2$ is supplied at a rate of FH 2 l/min.

At PP(16), $H_2$ is purged for 3 min. Then, at PP(17), $N_2$ is passed for 3 min at a rate of FN 17 l/min for effecting $N_2$ purge.

In Fig. 9, where dopant gas $D_N$ is used for forming layers of N type semiconductors, it can readily be noted from Fig. 7 that $D_N$ is supplied from chamber 103 through valves PV5, MFC4, MFC5 and MFC6.

Where reaction furnace R2 is used instead of R1, valves PV21 and PV22 are used instead of PV19 and PV20.

Fig. 10 is a diagram showing alternate operation of reaction furnaces R1 and R2.

The graph shown on the upper side of Fig. 10 shows the relation between the temperature θ°C of the furnace R1 and the progress of respective process programs PP(i), while the graph on the lower side shows the progress of respective process programs PP(i) regarding the furnace R2. When a start switch S1 of the furnace R1 is closed at time t0, the process program group PPG(1) starts and when process programs PP(1) and PP(2) are finished, at PP(3) the induction coil is energized until PP(15).

Immediately upon completion of the PP(15) for furnace R1, supply of the power to the induction coil of furnace R2 is commenced. Thus, the switch S2 for starting the furnace R2 is closed after time T4 has elapsed after closure of switch S1.

Denoting the interval between the closure of switch S2 and start of the first process program PP(1) of the process program group PPG2 by T3(R2) and the interval between PP(1) and PP(3) by T2(R2), to effect alternate running the following relation must be satisfied.

$$T1(R1)=T4(R2)+T3(R2)+T2(R2).$$

Since the time of closing switch S2 is arbitrary it is difficult to predetermine the actual starting time of PPG(2). (Usually, switch S2 is closed at time t1 when preparation including mounting of the wafers on which semiconductors are to be grown in the furnace is completed). To realize alternate running shown in Fig. 10 without this problem, a system as shown in Fig. 11 is used. In Fig. 10 time intervals T1(R1) and T2(R2) are known and time data already programmed. In Fig. 11, a register 131 is stored with a difference between intervals T1 and T2. A counter 132 is provided to count the number of counting pulses per second between closures of switches S1 and S2. Another counter 133 is set with the difference T3 between the count (T1—T2) of the register 131 and the count (T4) of the counter 132 at the time of closing the switch S2, and the count of the counter 133 is decremented by the counting pulse. When the counter 133 counts out, PPG(2) is actually started.

Although not shown, according to another method, a counter is provide preset with time T1, and after closure of switch S1, the count is decremented according to a counting pulse. When switch S2 is closed, time T2 is subtracted, and the difference is further decremented according to the timing pulse. When the count of the counter 133 reduces to zero, a start signal is given to PPG(2).

Figs. 12(a) and 12(b) show the data constructions of a process program PP processed by the system program of this invention, and a process program group PPG comprising a group of the process programs PP, respectively. Fig. 12a shows the content of one process program in which the process sequence

number i is stored in the first memory region, and the total data of the succeeding memory regions is stored in the second memory region.

As the data, are shown the lasting time of the process sequence in the unit of minutes and seconds. In the next memory region is stored an 8 bit data bit code, and the concrete example thereof will be shown later. The furnace temperature among output data is stored in the next memory region.

The next memory region is set with the flow quantity of $H_2$. Where the temperature and $H_2$ are given as the output data, the leftmost bit and a bit spaced therefrom by 2 bits are both "1". Although Fig. 12a shows an example of one PP(i), where there is no temperature designation, and where a plurality of various gases are simultaneously used as the output data, corresponding bits are made to be "1" respectively, whereby the flow quantities of the gases to be sequentially supplied are stored in the memory regions.

Fig. 12b shows the data constructions of process program groups PPG(1) and PPG(2) corresponding to the alternate running shown in Fig. 10. Thus, PPG(1) corresponding to the furnace R1 is stored in the first memory region of the left column.

Alternate running time T1 and initial alternate time T2 are set in the second and third memory regions. In Fig. 10, for PPG(1), this initial alternate time T2 is the sum of the sequence times PP(1) and PP(2). Following the initial alternate time T2, successive process program data of PP(1), PP(2), . . ., PP(17) are stored in the succeeding memory regions. The last memory region stores a code END OF PROGRAM.

Fig. 13 is a flow chart showing the processing procedure of the system program of this invention. At step 1 following the start of the program steps, a flag corresponding to system programs (some of them are shown in Fig. 4) designated by a key input such as a set value of switch 67-4 shown in Fig. 5, or an input from the key input unit (3, for example $ PROCESS, C, $ RUN, $ FETCH, . . ., etc.) is set in the flag memory region of RAM27. Then at step 2, the flag bit of a process control flag (meaning inputting of $ PROCESS, C) is checked. When the result of check is YES, at step 3 the process is controlled, whereas when the result is NO, the program is advanced to step 4 where check is made as to whether various operating switches of furnaces R1 and R2 (for example, opening/closing push buttons and motors of the furnaces) are ON or not. When the result of check is YES, at step 5 instructions for executing the states of corresponding switches are issued.

When the result of step 4 is NO, the program is advanced to step 6, and step 6 through step 25 correspond to respective system programs of from MODIFY TO TEST in ROM 27 shown in Fig. 4. Usually, only one of the steps 6 through 25 is selected.

Fig. 14 is a detailed flow chart showing the process control corresponding to a subroutine ST3 shown in Fig. 13. At step ST3-1, when the start switch of the reaction furnace R1 is being closed, the program is advanced to step ST3-2 where check is made as to whether the remaining time of the sequence of the process program PP(i) now being executed among the process program group PPG(1) related to the furnace R1 is zero or not. As shown by the flow chart of a second system program shown in Fig. 22, the sequence remaining time can be determined by setting the sequence time of one PP(i) in a register and then by decrementing the content thereof at each second.

When the sequence remaining time is zero at step ST3-2, at the next step ST3-4, the next process program PP(i) is designated to take in its data. Then, at the step ST3-5, the sequence time of the newly designated sequence time is set. As a consequence, the second system program described above is executed. Then at step ST3-6, the output data, that is data regarding designated gas flow quantities, furnace temperature, etc. are outputted, and at step ST3-7, ON, OFF instructions are issued for various valves. Finally at step STP-8, i is incremented by one for preparing next sequence setting.

At step ST3-1, when the start switch of the furnace R1 is OFF, the program is advanced to step ST3-3 where check is made whether the start switch of the furnace R2 is ON or OFF. When the result of step ST3-3 is YES, at step ST3-9 check is made as to whether the sequence remaining time of the process program now being executed among the process program group PPG(2) regarding the furnace R2 is zero or not. Then, contents of the following steps ST3-10 through ST3-14 correspond to those of the steps ST3 through ST3-8.

When the result of step ST3-2 is NO, the program is transferred to step STP-3 through a junction ①.

Further, when the results of steps ST3-3 and ST3-9 are NO, the program is jumped directly to END, thus completing the processing of the subroutine ST7.

Fig. 15 shows a detailed flow chart of the subroutine ST7 shown in Fig. 13. At the time of modification, when a flag $ MODIFY is inputted by the key, the system displays on the CRT29 a message of the content

"MODIFY BELL—JAR="

For furnaces R1 and R2, R1→L, and R2→R are inputted where R means right and L left. Then as additional informations, process names (PPG(i) EPi, etc.) prepared after modification, date of edition, name of editor, etc. are registered. Then a check is made as to whether what type of process program groups PPG should be modified to prepare the next program pattern, and the result of the check is inputted. Then a process program group PPG which the operator wants to modify is inputted to the control unit 14.

The system issues the next message, and informations necessary thereto are registered to modify a process program.

A message corresponding to a given PP and a modified state thereof are shown as follows:

SEQUENCE=PP(3)

$N_2$=50 45

TIME=300 230.

This example shows that the flow quantity of $N_2$ is modified from 50 l/min to 45 l/min, and that the flow time is modified from 3 min 00 sec to 2 min 30 sec.

Fig. 15 shows the detail of the flow chart of modification processing. At step ST7-1, a modified process program PP(i) is inputted. Then at step ST7-2, a check is made as to whether the inputted PP(i) belongs to a corresponding PPG or not. When the result of check at step ST7-2 is NO at step ST7-3, a check is made whether modification has completed or not, and when the result of check is YES, the subroutine ST7 is terminated. On the other hand, when the result of step ST7-3 is NO, at step ST7-4, an alarm instruction is given to an operator. When the result of step ST7-2 is YES, at step ST7-5 time data (sequence time) are taken out and displayed among the output data. At step ST7-6, a check is made whether it is necessary to modify the time data. When the result of step ST7-6 is YES, the time data are modified as above described at step ST7-7. Since this requires alternation of alternative running time, at step ST7-8 the alternate running time is calculated and the calculated time is stored in the memory area for the alternate running time of PPG. Then at step ST7-9, a check is made as to whether there are temperature data or not, and at the step ST7-10, a check is made as to whether it is necessary to modify the temperature data. When the result of check at step ST7-10 is YES, the temperature data are modified at step ST7-11. At step ST7-12, a check is made as to whether there are flow data of PP(i) or not, and at step ST7-13, a check is made as to whether it is necessary to modify the gas flow quantity or not. When the result of step ST7-13 is YES, at step ST7-14 the data are modified. Thereafter, necessary modifications are made by sequentially designating necessary process programs PP(i) in the given PPG.

To inform the termination of the modification a flag Ⓢ is inputted.

The subroutine ST9 shown in Fig. 13 will now be described. The term PROCESS means a processing performance that forms a process program group to be executed. When PROCESS is inputted, the system produces the following message to be displayed on CRT29

"PROCESS BELL—JAR="

Then, a program for furnace R1 or R2 to be used is inputted with the key. (L or R or (L+R) is inputted). When these inputs are received by the system satisfactorily no problem would be caused, but when erroneous inputs are applied, the system issues an error message, and the message described above is displayed again to request reinputting. In this manner, correct inputting can be assured like a mutual conversation. Then process names, date of forming the same, and the name of an editor are directly registered as additional informations.

Then what type of the process is to be executed is inputted as a process pattern. In the case of a N type vapor phase growth, the following display is inputted.

PROCESS PATTERN=EPiN (1)

in which the underlined portion is inputted. When various informations are inputted in this manner, a program PP to be executed next is prepared. Then, the system issues the following message, and informations necessary therefor are inputted to sequentially form and complete process programs that constitute EPiN.

SEQUENCE=PP(1) (2)

$N_2$=50

TIME=300

where (2) designates the sequence name, (3) and (4) show informations necessary for the sequence. In the case of (3), $N_2$ is used and the inputted flow quantity is 50 l/min. In (4) the execution time necessary for the sequence is inputted.

Fig. 16 is a flow chart showing a $RUN. When information $RUN is inputted with the key, the newest information of respective state variations of a process now being executed (corresponding to one process program) is displayed. When a process is being executed in furnace R1 or R2, the following displays are made, for example.

**RUN BELL—JAR=R1

SEQUENCE=EPi 1 DEPO

SET TIME=1234

**CURRENT DATA

TIME=1200

$H_2$=55

$D_N$=10

$SiCl_4$=22

TIME=59 (subtraction)

**RUN BELL—JAR=R2

SEQUENCE=$N_2$ PURGE

SET TIME=300

**CURRENT DATA

$N_2$=55

TIME=59

When one process has been completed, process termination ($$$) is displayed. The displayed contents described above are executed by the processing steps of the procedure shown in the flow chart shown in Fig. 16. Respective steps shown in Fig. 16 will now be described.

First, at ST11-1, a check is made as to whether the process is now being executed or not. If not, at step ST11-1 a process termination ($$$) is displayed. When the result of check at step ST11-1 is YES, at step ST11-3, the name of the process program PP(i) that is a sequence now being executed is displayed. Then, at step ST11-4, the sequence time (SET TIME) of the sequence PP(i) now being executed is displayed, and at the next step ST11-5, a check is made as to whether the sequence is interrupted or not. When the result of the check is YES, at step ST11-7, the interruption time of the sequence PP(i) being executed is interrogated and displayed. The sequence interruption occurs when the operator commands sequence interruption due to some sort of abnormals occurring during the automatic running, and during normal automatic running sequence interruption would never occur. When the result of step ST11-5 is NO, at step ST11-6, the elapsed time of the sequence being executed is displayed.

Then, at ST11-8, a check is made as to whether the sequence being executed is supervising the temperature or not. When the result of check at step ST11-8 is YES, at ST11-9, the presently measured furnace temperature is displayed. When the result of step ST11-8 is NO, at step ST11-10, a check is made as to whether the sequence PP(i) being executed is supervising the gas flow quantity or not. When the result of step ST11-10 is YES, at step ST11-11, the present flow quantity is displayed. On the contrary, when the result of step ST11-10 is NO, the program is returned to the junction ①.

The system program STEP shown in Fig. 4 will now be described. This system program STEP is prepared for charging the order of respective process programs PP(i) in a given process program group PPG(i) and when $STEP is inputted with the key it is displayed as follow

STEP BELL—JAR=R1

in which underlined portion shows the furnace R1 and inputted by the operator with the key. Then, the detail of the process program group, date of edition and the name of editor are registered as necessary directory items. Then the system interrogates that orders of what type of PPG should be changed. This display is as follows

PROCESS PATTERN=EPiN

in which the underlined portion is the input by the operator and shows a N type vapor phase growth.

As shown in the following, since respective process programs PP(i) in EPiN (one process program

group) are sequentially shown by the system, informations necessary therefor are inputted to the right side of the equations with the key.

SEQUENCE=PP(1)

SEQUENCE=PP(2)

SEQUENCE=PP(3)

SEQUENCE=PP(4)

. .

. .

. .

. .

SEQUENCE=PP(17)

In order to terminate the STEP, $ is inputted.

Fig. 17 is a flow chart showing the detail of the subroutine ST13 shown in Fig. 13. More particularly, as $ STEP is inputted, at step ST13-1 a memory region for the STEP is ensured. Then at step ST13-2, a sequence number i is inputted. Thereafter, at step ST13-3, a check is made whether sequence number is i or not. When the result of check at step ST13-3 is YES, the data regarding PP(i) are transferred to the ensured memory region.

If the result of step STP13-5 was NO, at step STP13-5, a check is made whether the STEP has ended or not. When the result is YES, the program is terminated, whereas when the result is NO, at step ST13-6, an alarm is displayed for the operator on the assumption that there is a sequence number actually present, thus terminating the STEP processing.

STORE in ROM27 shown in Fig. 4 will now be described. The purpose of the system program STORE is to transfer a processed or modified process program group PPG to such external memory medium as a cassette magnetic tape, minifloppy disc, and bubble memory device.

Fig. 18 is a flow chart showing the detail of the subroutine ST15 shown in Fig. 13. At step ST15-1, the head process program (PP(i), i=1) of a program group PPG(K) to be stored in the external memory medium is set, and then at step ST15-2 the external recording medium (CMT51) to be used is initialized to check whether the memory medium can be used or not. After that, at step ST15-3 a judgement is made as to whether all PP(i) have been transferred from RAM26 to RAM53 or not. When the result of judgement is YES, it means that all data regarding one PPG(K) have been transferred from RAM26 to RAM53. Then, at step ST15-4, transfer of data from RAM53 to CMT51 is executed according to the program stored in ROM52. Upon completion of the transfer to CMT51 at step ST15-5, termination is informed to the operator. On the other hand, when the result of step ST15-3 is NO, at step ST15-6, the data of PP(i) are transferred to RAM53.

Then at step ST15-7, a check is made as to whether there is an abnormal or not, and when the result is YES, at step ST15-9, generation of abnormal is informed to the operator. If the result of step ST15-7 is NO, at step ST15-8 i is incremented by one so as to designate the next sequence PP(i+1). Upon completion of the step ST15-8, the program is returned back to step ST15-3 to repeat the steps following thereto. As can be noted from the block diagram shown in Fig. 4, according to the process of STORE, PPG(i) stored in RAM26 is transferred to RAM53 through i/o bus line 23, high speed data transfer unit (HMT)45, data highway 47, HMT50 and data bus line 48. The PPG(K) stored in RAM53 is stored in an external recording medium, e.g. the cassette magnetic tape 51 (CMT) via bus line 48, SUB-CPU 46, bus line 54 and cassette magnetic tape interface 49.

The system program SORT shown in Fig. 4 will now be described. This program SOFT functions oppositely to the program STORE. That is the PPG(K) stored in CMT51 is transferred to RAM26 via RAM53.

A detailed flow chart of the subroutine ST17, Fig. 13, corresponding to process SORT is shown in Fig. 19. Thus, at step ST17-1, an external memory medium not storing any process program group PPG(K) but to be stored later therewith is designated. Then at step ST17-2, a check is made as to whether PPG(K) is actually stored in the designated external memory medium CMT51 or not. When the result of check is NO, at step ST17-3 this fact is informed to the operator. When the result of step ST17-2 is YES, at step ST17-4 data regarding a PPG(K) are transferred from CMT51 to RAM53. (Through ROM52 and CPU46).

After that, at step STP17-5, a check is made whether the transfer of the data from CMT51 to RAM53 has been completed or not. When the result is NO, the program is returned to step ST17-4. On the other hand, when the result is YES, at step ST17-6 data of respective PP(i) are transferred to RAM26 acting as the main memory device.

Then at step ST17-7, a check is made whether there is an abnormal or not, and if there is an abnormal it is informed to the operator at step ST17-8.

If there is no abnormal, at step ST17-7, i is incremented by one to prepare a next sequence PP(i+1). Then, at step ST17-10, a check is made whether transfer of data from RAM53 to RAM26 has completed or not. When the result is YES, it means that processing of SORT has been completed and $$$ is displayed. When the result of step ST17-10 is NO, the program is returned to step ST17-6 and the loop is executed again.

The VERIFY system program shown in Fig. 4 will now be described. This system program is utilized to display on the CRT29 a process program group stored in RAM26 for the purpose of being verified by the operator.

When $ VERIFY is inputted, a message

"VERIFY NAME="

is issued so as to output the content of the process program group PPO(K) by inputting the process name to the underlined portion. One example of the display output is as follows:

PROCESS NAME=N

$N_2$ PURGE

TIME=1234

FLOW OF $N_2$=55

$H_2$ PURGE

.

.

.

.

$N_2$ PURGE

FLOW OF $N_2$=55

In this manner, displayings are sequentially executed and when the content of the last $N_2$ PURGE is outputted the program is terminated.

Fig. 20 shows a detailed flow chart of the subroutine ST19 shown in Fig. 13. Thus, at step ST19-1, a head process program PP(i) of the given PPG(K) is set. Then at step ST19-2, the sequence number of the set PP(i) is checked. If the result of check is NO, at step ST19-3 the termination of the VERIFY PROGRAM is checked. If not terminated, at step ST19-4 it is displayed to the operator on the assumption that not present sequence number has appeared.

When the result of step ST19-2 is YES, the time data (sequence time) in the data of PP(i) is transferred to CRT RAM 25. Then at step ST19-6, the time data is displayed on CRT 29. After that, at ST19-7 a check is made whether there are temperature data in the PP(i) data, and when there are temperature data, at step ST19-8, the temperature data are displayed on CRT29. Then at step ST19-9, a check is made whether there are flow quantity data regarding used gas in the data of PP(i), and if there are the data, the flow quantity data are displayed on CRT29 at step ST19-10.

Then at step ST19-11 i is incremented by one for preparing the next sequence PP(i+1). Thereafter, the program is returned to the junction ① to repeat steps ST19-2 through ST19-11.

The system program DIAGNOSIS shown in Fig. 4 will now be described.

Thus, when a $ DIAGNOSIS is inputted with the key, whether there is an abnormal of the process at the present time or not is checked.

An example of a fault message is as follows.

| $ DIAGNOSIS | | | |
|---|---|---|---|
| | A0 | A1 | A2 |
| *FLOW ERROR | $N_2$ | □□ | □□ |

in which A0 shows a specific flow quantity controller, A1 a set flow quantity and A2 an actual flow quantity during the abnormal.

Fig. 21-(1) is a detailed flow chart of the subroutine ST21 shown in Fig. 13. At step ST21-1 a check is made whether there is an error registration or not. This check is made by checking an error code registration region (Fig. 21-(3)) of RAMs 26 and 53 by executing the self-diagnosis program shown in Fig. 21-(2). When the result of step ST21-1 is YES, at step ST21-2, the number K (Fig. 21(3)) of the registered error is taken out. Then, at step ST21-3, error codes are taken out and at step ST21-4, taken out error codes are connected into fault messages which are displayed on CRT.

Then, at step ST21-5, the number of registered errors is subtracted with 1 and at step ST21-6, a check is made whether there is an error registration number (number of not displayed errors) or not. If the number is not zero the program is returned to step ST21-3. If zero, the system program terminates.

Fig. 21(2) shows the flow chart showing aforementioned self-diagnosis routine, in which at step ST21-10, a check is made as to whether there is an abnormal or not. The checked items includes temperature, flow quantity voltages supplied to various valves, etc. When the result of step ST21-10 is YES, at step ST21-11 instructions necessary to remove abnormal conditions of furnaces R1 and R2 and their peripheral apparatus are given. Such removal can be made, for example, by temporarily stopping the progress of the sequence.

Then at step ST21-12, an alarm is displayed to give an alarm to the operator and at step ST21-13, error codes are registered or stored in corresponding regions of RAM26.

The system program of USED TIME shown in Fig. 4 will be described as follows. USED TIME represents the time spent by reaction furnaces R1 and R2 until present time.

When $ USED TIME is inputted by the key

| | DAYS | HOURS | MIN. | SEC. |
|---|---|---|---|---|
| LEFT USE TIME= | □□ | □□ | □□ | □□ |
| RIGHT USE TIME= | □□ | □□ | □□ | □□ |

are displayed on CRT29. In this example, LEFT shows furnace R1, and RIGHT furnace R2.

Fig. 22 shows a flow chart of a second processing program in the system program stored in ROM24, and the content of the USED TIME described above are given as a result of execution of the subroutines ST2 and ST4.

In Fig. 22, when the execution of the second processing program is instructed, at step ST1S (S means second), the start switch of the reaction furnace R1 is turned ON. Then at step ST2S, the sequence time of the program is decremented. When the result of step ST1S is NO or when the processing at step ST2S has been completed, at step ST3S a check is made whether the start switch of R2 has been turned ON or not. If ON, the decrement of the sequence time of R2 is done in the same manner as in R2. This second process program is inserted at each second into the main system program of ROM24.

The TEST system program shown in Fig. 4 is as follows. The TEST performance is utilized for the maintenance of the control device of this invention.

TEST PERFORMANCE is divided into 6 items and constructed such that each performance can be called like a conversation for execution.

Respective performances are as follows.

① EV performance

For the purpose of operating process control valves (Electromagnetic Valves), the operator operates keys of E, V and CR after CRT29 has displayed "NAME=".

Then CRT29 displays "OPEN (Y, *N)=". So the operator operates keys of Y and CR where Y means "YES" and CR means Carriage Return.

In a case of setting the valves to be closed, CRT 29 displays as follows and the operator inputs each key shown with a underline.

NAME=Ⓔ Ⓥ (CR)

OPEN (Y, *N)=Ⓝ (CR) or (CR)

NO=(valve member) (CR)

The setting operations terminate when key of "E" is inputted as follows.

NO=Ⓔ (CR)

CRT29 displays

"NAME=".

Aforementioned key operations by the operator are shown as the following underlined portions.

NAME=Ⓔ Ⓥ Ⓒⓡ

OPEN (Y, *N)=Ⓨ Ⓒⓡ

Then, CRT29 displays and requests the operator to input the valve number

NO=(valve number) Ⓒⓡ

The setting operations for opening the electromagnetic valves are terminated by inputting keys "E" and "CR" after CRT29 has displayed "NO=". Valves whose numbers have been designated remain in the closed or opened states.

Actual examples are as follows:

$ Ⓣ Ⓔ Ⓒⓡ (Ⓣ, Ⓔ mean tests)

NAME=Ⓔ Ⓥ Ⓒⓡ

NO=⑤ Ⓒⓡ
NO=① ⓪ Ⓒⓡ } EV5 and 10 close
NO=Ⓔ Ⓒⓡ

NAME=Ⓔ Ⓥ Ⓒⓡ

OPEN (Y, *N)=Ⓨ Ⓒⓡ

NO=⑦ Ⓒⓡ } EV7 close
NO=Ⓔ Ⓒⓡ

NAME=other performances are called.

② MF performance

The purpose of this performance is to operate a mass flow paper riser controller for process control. According to

NAME=Ⓜ Ⓕ Ⓒⓡ

INPUT (Y, *N)=(________),

an interrogation is made whether an input operation is desired or an output operation (displaying) is desired.

At the time of inputting operation, Ⓨ and Ⓒⓡ are inputted.

NO=mass flow valve number Ⓡ

DATA=*__* where * * represents data value

NO= ________

By sequentially designating mass flow valve numbers, data at the time of inputting are displayed for only one minute. At the end of display, CRT29 displays

NO=Ⓔ Ⓒⓡ.

In a case of outputting operation Ⓝ Ⓒⓡ or Ⓒⓡ are inputted.

NO=mass flow valve number Ⓒⓡ

DATA=flow quantity Ⓒⓡ

NO= ________________

By sequentially designating mass flow valve numbers, flow quantities can be set. Termination is designated by Ⓔ (CR).

Example

$ TEST

NAME=Ⓜ Ⓕ (CR)

INPUT (Y, *N)=Ⓝ (CR) or (CR)

NO=⑤ (CR)

DATA=① ⑤ (CR) (15l is designated, MFC5)

NO=⑧ (CR)

DATA=③ ⓪ ⓪ (CR) (300 cc is designated, MFC8)

NO=Ⓔ (CR)

NAME=Ⓜ Ⓕ (CR)

INPUT (Y, *N)=Ⓨ (CR)

NO=⑤ (CR)

DATA=* * process for one minute (MFC5)

NO=⑧ (CR)

DATA=* * process for one minute (MFC8)

NO=Ⓔ (CR)

NAME= __________

③ CRT performance

All characters generated by a character generator is supplied. When outputting of one page (80 characters×25 lines) is completed, the page is cleared.

NAME=Ⓒ Ⓡ (CR)

character service

NAME= ________ other performances are called.

④ Lamp performance

Lamps, LED's and buzzers on the operating panel and control panel are sequentially operated. When all outputs are made, the program is cleared and this cycle is repeated five times.

NAME=Ⓛ Ⓐ (CR)

outputting

NAME= ________ (other performances are called).

⑤ SOL (solenoid valve) performance

Electromagnet valves utilized for transfer switches, R1 clamping device, R1 locking device, R1 sealing device, R1 exhaust device, R2 clamping device, R2 locking device, R2 sealing device and R2 exhaust device are ON/OFF controlled.

NAME=Ⓢ Ⓞ (CR)

ON (Y, *N)= __________

Thus, an interrogation is made as to whether valves are to be opened or closed.

At the time of opening, Ⓨ (CR) are inputted whereas at the time of closing Ⓝ, (CR) or (CR) are inputted. Then, according to NO=valve number (CR) designated valves are ON/OFF controlled.

⑥ ATC (Automatic Temperature Control)

This performance is used for a temperature rise test, a uniform heating test, etc.

NAME=Ⓐ Ⓣ (CR)

BELL—JAR= ____________

Which one of the bell jars (furnaces R1, R2) is used is interrogated. When characters other than Ⓡ and Ⓒ are inputted, it is judged that these characters are used for «2. Then, the gas system is transferred to a $N_2$ purge line to seal the bell-jar. When sealed, an exhaust valve is opened. At this time, evacuation is not made because the bell-jar is being evacuated. Thus, the system enables execution of the processes for a selected bell-jar. However, when an abnormal condition is found, the ATC control is cancelled.

Fig. 23 is a detailed flow chart for calculating the waiting time at the time of alternate running shown in Fig. 10 and corresponds to one of the system programs stored in ROM24 shown in Fig. 4. More particularly, at step ST1S, a check is made as to whether the start switch of the reaction furnace R1 is ON or not. When the result is NO, the program is jumped to step ST7S, whereas when the result is YES, at step ST2S, a check is made as to whether the process of the other furnace R2 is under execution or not. When the result is YES, at step ST3S, the waiting time of furnace R1 is calculated.

When the result of step ST2S is NO, in other words, the start switch of R2 has not yet been closed, at step ST4S, a check is made again as to whether the process of R1 is under execution or not, and when the result is YES, the program is jumped to step ST7S. When the result of step ST4S is NO, at step ST5S, a process control flag is set for executing the process of R1. Then at step ST6S, the sequence time of PP(i), that is the first process program PP(i) of the process group PPG to be executed for R1 is made to zero. After that, contents of steps ST1S through ST12S correspond as follows: ST1S→ST7S, ST2S→ST8S, ST3S→ST9S, ST4S→ST10S, ST5S→ST11S, ST6S→ST12S for respective furnaces R1 and R2.

In the foregoing description, reaction furnaces R1 and R2 were in the form of induction heating coils, and the furnaces were alternately operated for efficiently utilizing the source of heating power. However, heating can also be made with lamps as shown in Fig. 24.

In Fig. 24, 201 designates a source of various gases supplied to a reaction furnace 207 and the gases are admitted into the furnace 207 through a conduit as shown by arrows. A frusto-conical shaped support 209 is supported from above to be rotatable. Substrates or wafers on which semiconductors are to be grown in vapor phase are mounted on the peripheral surface of the support. Temperature sensors 210 are secured to the rotary shaft of the support 209 and signals from the temperature sensors 210 are applied to a temperature controller 204 over a conductor 203. The temperature controller 204 supplies a control signal to a power converter 205 which supplies electric power to incandescent lamps 206 disposed on the outer periphery of the furnace 207. Accordingly, light emitted by the lamps 206 reaches the wafers 208 through an outer wall or casing made of quartz or the like. With this lamp heating type, since the wafers 208 are heated by the lamps 206 through the outer wall so that power consumption is smaller than the induction coil heating. When a plurality of lamp heated furnaces are connected in parallel with the source of gases, ech furnace can operate independently of the processing executed in the other furnaces.

As above described, the vapor phase growing apparatus of this invention can obviate various problems of the prior art pin board type. Especially for the automatic operation, the gas flow quantity data and the temperature instruction data among output instruction data can be beforehand included in the process program so that the operator is not required to issue any construction instruction for the vapor phase growth reaction.

The principal feature of a modification of this invention is to raise the furnace temperature to about 1200°C most suitable for the vapor phase growth in a minimum interval, while preventing slip of the wafers especially liable to occur at the time of quick temperature rise.

To this end, according to this modification the control program is prepared in the following manner and executed by the CPU to control the furnace temperature.

More particularly, according to this modification, by taking into consideration the fact that the slip occurs at about 1000°C, it is advantageous to control the temperature in a range of from 800°C to 1200°C and to make short one ramp interval as far as possible. Accordingly, the temperature reference is changed slightly during the sequence time so as to linearly rise the furnace temperature.

Fig. 28 shows a flow chart inputting a ramp (temperature raising and lowering) showing only two examples of temperature raising and lowering of sequence numbers PPNO4 and PPNO15.

Designations of the temperature slope and ramping time are sufficient for effecting highly accurate ramping.

For a sequence in which the ramping is effected, it is necessary to determine whether the ramping is to be made or not, and when the ramping is to be made it is necessary to preset its contents. The chart shown in Fig. 28 is used for such procedures.

More particularly, as the execution of the program of the control unit is commenced the routine for ramp control information input routine is started to execute step 1.

In this example, it is supposed that the sequences for raising and lowering the temperature are PPNO4 and PPNO15. Then, at step 1, a check is made whether the procedure is ramp up (temperature rise) or not in the sequence PPNO4. This procedure is done by supplying a message to the CRT. According to the processing content, ramp up is not made, so that in the case of ramp up an information for it is inputted with the keyboard KB, and the information is inputted to the CPU for executing step 1. When the result of this step is YES, at step 2 a ramp control flag for the PPNO4 sequence is set. Since step 3 is a routine for displaying the preregistered temperature rise time of the sequence PPNO4, the CPU executes this routine to read out the ramping time or the temperature rise control time for one sequence and gives the read out time to the CRT to display its content. At step 4, check is made as to whether it is necessary to correct or not. If correction is necessary, a message is sent to the CRT to know the extent of correction.

Depending upon whether correction is necessary or not, a signal YES or NO is inputted from the keyboard and the CPU judges that whether the signal is YES or NO at step 4. When the result of this step is YES, at step 5 a new extent of temperature rise control time inputted from the keyboard KB is registered in RAM and the program is transferred to step 6. When no correction is necessary the program is jumped from step 4 to step 6. At step 6, the extent of temperature rise in one ramping time is displayed on the CRT. Then, at step 7, a check is made as to whether it is necessary to correct the temperature rise to what extent or not. The result of check at step 7 is displayed on the CRT by the CPU and necessary extent of correction is inputted by the keyboard KB.

When the result of step 7 is YES, at step 8, the newly inputted extent of temperature rise is stored in RAM. When the result of step 7 is NO, the program is jumped to step 10.

When the result of step 1 is NO, at step 9, the ramp control flag of the sequence PPNO4 is cleared and then the program is transferred to step 10. However, when the ramp control flag has been cleared the RAMP control is omitted.

At step 10, a judgement is made as to whether the RAMP down (temperature lowering) is necessary in sequence PPNO15 or not. The result of judgement is also displayed on the CRT and keyboard KB is operated to satisfy the result of judgement.

When the result of judgement at step 10 is NO, at step 11, the ramp control flag of the sequence PPNO15 is cleared so as to register that the RAMP control is unnecessary, thereby terminating the routine regarding the ramp control information.

When the result of judgement of step 10 is YES, a ramp control flag for the sequence PPNO15 is set. Then at step 13, stored one ramp time, that is the temperature lowering extent control time for sequence PPNO15 is read out and displayed on the CRT. Then at step 15, a check is made as to whether it is necessary to correct the control time by what extent, and the result is also displayed on the CRT. The operator operates the keyboard to perform the required correction.

When the result of step 14 is YES, at step 15, the newly inputted temperature lowering extent control time is stored in RAM and the program is advanced to step 16. When the result of step 14 is NO, at step 16 the extent of temperature lowering for one ramping time which is stored at sequence PPNO15 is read out and displayed on the CRT. Then at step 17, a check is made as to whether it is necessary to correct the extent of temperature lowering to determine the amount of correction. This amount is also displayed on the CRT and inputted with the keyboard KB.

When the result of step 17 is NO, the program is jumped to step 19, whereas when the result is YES, at step 18, the inputted value is stored as a new extent of temperature lowering.

At step 19, the final value of the lowered temperature of the sequence PPNO15 is read out and displayed on the CRT. Then at step 20 a judgement is made as to whether it is necessary to correct the final value of the lowered temperature and the result of the check is displayed on the CRT and corrected with the keyboard KB. When the result of step 20 is NO, the ramp control information inputting procedure is terminated.

When the result of step 20 is YES, at step 21, the newly inputted finally lowered temperature is stored, thus terminating the ramp control information input procedure.

When the above described routine has been executed, informations regarding execution of the ramping or not, the temperature gradient, and the ramping time of the sequences PPNO4 and PPNO15 are stored.

Upon completion of the ramp control information routine, the main program having the content as shown in Fig. 9 is executed. When the program enters into the sequence of PPNO4 the ramp control routine as shown in Fig. 29 is commenced to effect the ramp control.

More particularly, in the ramp control routine, step 22 is executed to check whether the sequence is a temperature raising sequence or not.

Since the main program contains a temperature raise sequence when the present sequence is PPNO4, whereas a temperature lowering sequence in the case of the sequence PPNO15, in the case of the temperature raising sequence, the program is transferred to step 23 from step 22, whereas in the case of the temperature lowering sequence the program is transferred to step 36. Since at step 2 or 9, a flag regarding ramping or not is set, at step 23 a check is made whether ramp control is to be made or not in accordance with the content of the flag. When the result of step 23 is YES, at step 24 a judgement is made

whether the ramping is to be started or the ramping is now being executed. When the ramping is to be started, at step 26 the output of the temperature sensor TS is read through a linearizer and an A/D converter to form the present temperature information of the wafers being heated, which is written in a portion indicating the previous output control quantity. At step 27, the remaining time of the sequence PPNO4 measured at the time of commencing the ramp control routine is compared with one ramping time assigned to sequence PPNO4. When the remaining time is large the program is advanced to step 28, whereas in the opposite case the step is transferred to step 25 because the remaining time is too small.

At step 25, a target temperature set for sequence PPNO4 is outputted. When the result of step 23 is NO, the step 25 is also executed. The outputted target temperature is applied to a digital display and adjuster through a D/A converter to control the furnace temperature to the target value.

At step 28, where the ramping is possible for a predetermined time in the remaining sequence time, the extent of temperature rise preset in one ramping time is added to the previous output control quantity to determine the extent of temperature rise, that is the target temperature in the present ramping time. Then at step 29 controlled extent of the temperature rise is compared with the target temperature of the sequence PPNO4. When the former is smaller than the latter the program is advanced to step 30, whereas in the opposite case, at step 25 the furnace temperature is maintained at the target temperature. At step 30 the controlled extent of temperature rise is outputted which is given to the digital display adjuster so as to control the high frequency generator such that the furnace temperature becomes the target temperature. Then at step 31, a temperature rise control time, that is one ramping time, for example, 3 or 6 seconds, is set. The one ramping time thus set is registered in a second processing program for supervizing each ramping time.

The detail of the second processing program is shown in Fig. 30 in which at step 32, a judgement is made whether the temperature rise control time is zero or not. When the result of judgement is NO, at step 34 the temperature rise time is decremented and at step 33 the second processing routine for lowering the temperature is executed.

The content of this routine is substantially the same as those of steps 32 and 34. Thus at step 33 a judgement is made whether the registered temperature lowering control time, that is one ramping time is zero or not, and when the result is NO, at step 35 the temperature lowering control time is decremented.

These processings are performed at a spacing of one second and when the temperature rise control time becomes zero, the ramp control routine is executed. In the same manner, when the temperature lowering control time becomes zero, the ramp control routine is executed.

In the second processing program supervisions of the times of temperature raising and lowering are performed independently because two reaction furnaces are controlled alternately. Where a single furnace is used, duplicate routines may be combined into a single routine.

In the second processing program, where one ramping time elapses, the ramp control routine is started again to repeat the procedures described.

Then, the result of step 24 becomes NO so that the step 26 is omitted, and at step 28 the previous extent of temperature rise is calculated as the previous output control quantity.

Because, since the furnace temperature at the time of starting the ramping has been set at the initial stage the temperature at the starting point has determined so that the desired temperature control can be realized by giving the extent of temperature rise at each ramping. It is also possible to store actual temperatures at respective rampings.

As above described, as the temperature rise control proceeds so that the remaining time of the sequence reduces, or when the temperature exceeds the target value, at step 25 the target temperature is given to the digital display adjuster so as to control the high frequency generator such that the furnace temperature will reach the target value.

When at step 25, the difference between the target temperatur and the actual furnace temperature is large enough to cause a slip of the wafers. This means that the extent of temperature rise or the temperature settings in the preceding sequences are not adequate, whereby temperature should be carefully set.

At the sequence PPNO15 in which the main program comprises temperature lowering sequences, the ramp control routine is executed again.

At step 22, when it is judged that the sequence is not the temperature raising sequence, at step 36 a judgement is made whether the sequence is a temperature lowering sequence or not. If the result of judgement is NO the program is returned to the main program, whereas when the result is YES, at step 37 a judgement is made whether it is necessary to effect ramp control or not. This step is executed by observing a flag set at steps 11 and 12. If the result of step 38 is NO, at step 43 the high frequency generator is stopped to terminate heating.

When the result of step 37 is YES, at step 38 the remaining time of the sequence PPNO15 independently supervized is compared with a preset one ramping time so as to judge whether the ramping completes or not in the remaining sequences. When the result is NO, the program is jumped to step 43 whereas when the result is YES, at step 39 the temperature of the wafers measured by the temperature sensor TS is stored as the previous output control quantity. More particularly, so long as the temperature raising or lowering control is not effected the furnace temperature is controlled to a value corresponding to the output control quantity which has been the temperature control reference up to the previous sequence

so that the detected temperature can be used as the previous output quantity. The preset extent of temperature lowering in one ramping time is subtracted from the previous output control quantity and the difference is used as the extent of temperature lowering, that is a temperature control reference.

Then at step 40, the finally lowered temperature, that is a preset final target temperature is compared with the lowered temperature. When the lowered temperature is higher than the target temperature, at step 41 the extent of temperature lowering control is outputted which is given to the digital display adjuster via a D/A converter, whereby the output of the high frequency generator is controlled to bring the furnace temperature to the controlled lowered temperature.

Then at step 42, the preset one ramping time or the temperature lowering control time (for example 6 seconds) is stored. After that, the second processing program is executed. When the stored time expires, the ramp control routine is executed again to lower temperature. Thus in each stored time, ramping is executed until a newly lowered temperature is reached.

As the remaining sequence time becomes less than one ramping time or when the extent of temperature lowering becomes smaller than the temperature at the end point of temperature lowering, the temperature lowering sequence is terminated at step 43.

After that, the program is returned to the main program to execute the next sequence.

As above described, in a sequence requiring ramping, the ramping control is repeated with a unit ramping time set shorter than an execution time assigned to the sequence and at a rate preset to be adequate to reach the final target value to reach the target temperature within the execution time of the sequence, so that it is possible to finely ramp with a small time unit. According to this ramping control, the furnace temperature can be increased linearly with a desired angle of inclination without accompanying the problem of slip of the wafers. Moreover, the temperature control is made with a program, the temperature control can be made accurately and readily. In other words, according to this invention, even in a temperature range in which the slip tends to occur, rapid temperature change does not occur with the result that the wafers are not subjected to severe heat shock and that the temperature gradient can be made to be a maximum, thus improving the productivity.

**Claims**

1. Semiconductor vapor phase growing apparatus, comprising:

a reaction furnace ($R_1$) for vapor phase growing a semiconductor (91) on a semiconductor substrate;

means (79) for heating said substrate;

sources (101, 102, 103, 104, 105, 106) of various gases necessary for vapor phase growth;

a pipe line network for interconnecting said reaction furnace ($R_1$) and said sources (101, 102, 103, 104, 105, 106);

valve means (MFC1, MFC2, ..., MFC10) connected in said pipe line network for supplying predetermined quantities of said gases to said reaction furnace ($R_1$); and

control means for supplying control signals to said valve means (MFC1, MFC2, ..., MFC10), characterized in that

said control means (21 to 54) includes a first memory region (24, 26) for storing a process program group comprising a group of process programs including information regarding a time for designating a process of vapor phase growth in said reaction furnace, gases utilized, flow quantities thereof and furnace temperature, and a second memory region (27) that stores a system program that decodes said process program group for producing control signals for said valve means.

2. The apparatus according to claim 1, wherein each group of process programs stored in the first memory region is formed with a plurality of process programs corresponding to a series of actual sequence processes defined by said stored process informations and divided by the time during one cycle of vapour phase growth in said reaction furnace.

3. The apparatus according to claim 1 wherein said control means comprises means (29) for displaying contents of said process programs, and key input means (31) whereby the contents of each of said process programs stored in said first memory region are displayed on said display means (29) in response to an operation of said key input means, and wherein said system program includes a modifying instruction program responsive to an input signal from said key input means, for modifying said process program group.

4. The apparatus according to claim 1 wherein said system program is further provided with a production instruction program for producing a process program group in accordance with a signal from said key input means, and displaying means.

5. The apparatus according to claim 1 wherein said second memory means further stores a decoding process program which sequentially decodes respective process programs in said process program group for forming the control signals respectively applied to said valve means and said heating means, and a modifying processing program for modifying the contents of the process programs displayed on said display means, said modifying process program having a capability of modifying data of said process programs in said process program group while executing the process.

6. The apparatus according to claim 1 wherein said process program contains an information effecting

a switching between a pipe line network leading to a vent port and a pipe line network leading to said reaction furnace.

7. The apparatus according to claim 6 wherein said switching is effected by a ETCH or DEPOSITION information.

8. The apparatus according to claim 1 wherein said second memory means further stores a VERIFY process program for displaying the data of the process programs in said process program group and for verifying an information that does not present.

9. The apparatus according to claim 1 wherein said second memory means further stores a STEP process program which registers or deletes a process program in said process program group for the purpose of changing the sequence of said process programs and for verifying an information which does not present.

10. The apparatus according to claim 1 wherein said second memory means further stores a TEST process program for effecting confirmation and maintenance of the operation of said valve means.

11. The apparatus according to claim 1 wherein said control means is provided with input means for process program group adapted to be supplied with process program groups stored in external memory medium.

12. The apparatus according to claim 11 wherein said external memory medium comprises a magnetic tape or a magnetic card.

13. The apparatus according to claim 1 which further comprises another reaction furnace ($R_2$), both of said reaction furnaces ($R_1$ and $R_2$) are provided with induction heating coils for heating said substrates, and wherein said control means includes a transfer switch for alternately connecting said induction heating coils to a common high frequency source.

14. The apparatus according to claim 1 wherein said memory region (24) stores said process program group including data regarding an interval of operation of said reaction furnace.

15. The apparatus according to claim 12 wherein said control means comprises arithmetic operating means which calculates a first interval between starting of a first process program group executed for operating one reaction furnace ($R_1$) and termination of said process, and a second interval between starting of a second process program group executed for operating another reaction furnace ($R_2$) and termination thereof.

16. The apparatus according to claim 12 further comprising a plurality of starting switches adapted to start first and second reaction furnaces ($R_1$, $R_2$) and arithmetic operation means which calculates a first process sequence starting time of said second furnace based on an interval T1 between closure of a starting switch of the first reaction furnace and termination of a process program group corresponding thereto, an interval T2 between starting of a second process program corresponding to said second furnace and a heating instruction, and a time T3 at which a starting switch of said second reaction furnace is operated thereby shortening an interval between termination of power supply to the first furnace and start of power supply to said second furnace.

17. The apparatus according to claim 16 wherein said arithmetic operation means comprises a counter set with an execution time of said first process program group regarding said first reaction furnace, means for decrementing content of said counter at each definite time, means for subtracting an execution time of the second process program group regarding said second reaction furnace from the count of said counter to produce a remaining time, and means for issuing an instruction for starting said second process program group when said counter completes counting of said remaining time.

18. The apparatus according to claim 17 which further comprises another counter set with a difference between an interval between starting of the first process program group regarding said first reaction furnace and termination of heating thereof, and an interval between starting of the second process program group regarding the second reaction furnace and issuance of a heating instruction thereto, means for decrementing count of said another counter at each definite time after starting of said first process program group, and means to start execution of said second process program group when the content of said another counter is reduced to zero.

19. The apparatus according to claim 1 wherein said reaction furnace ($R_1$) comprises a vertical rotary support for supporting a plurality of semiconductor substrates about a peripheral surface of said support, a transparent sealed casing surrounding said support, incandescent lamps disposed on the outside of said casing for heating said semiconductor substrates and means for introducing reaction gases into said casing for causing vapor phase growth of N or P type semiconductor layers on said semiconductor substrates.

20. The apparatus according to claim 1 which further comprises temperature detecting means (TS, 93) for detecting the temperature of the wafer in the reaction furance ($R_1$), and output control means controlling the output of said source of heating according to a given reference value, wherein said control means includes further memory region storing a program of executing said sequences and substantially linearly raising and lowering the wafer temperature at a predetermined temperature gradient in a plurality of divided time interval units by making different rates of temperature change in respective time units, and means for processing said program.

21. The apparatus according to claim 20 wherein at the time of executing sequences of varying the temperature, the temperature of said wafer is taken as a reference, said processing means determines a

temperature reference value by correcting said rates of temperature changes in amounts in respective time interval units adequate to reach last target temperature in respective sequences and wherein said processing means comprises means for applying said corrected rates of temperature changes to said source of heating.

22. The apparatus according to claim 20 wherein said memory means comprises a ROM storing a program storing program sequences for executing said temperature changes.

23. The apparatus according to claim 1 wherein said reaction furnace ($R_1$) comprises a rotary support (75) adapted to support a plurality of said semiconductor wafers (91), a high frequency induction coil (79) energized by said source for heating said wafers, and a temperature sensor (TS) for detecting the temperature of said wafers.

**Patentansprüche**

1. Vorrichtung zum Aufwachsen von Halbleitermaterial aus der Dampfphase, aufweisend:

einen Reaktionsofen ($R_1$) zum Dampfphasen-Aufwachsen eines Halbleitermaterials (91) auf einem Halbleitersubstrat;

eine Vorrichtung (79) zum Erwärmen des Substrats;

Quellen (101, 102, 103, 104, 105, 106) unterschiedlicher, für das Dampfphasen-Aufwachsen nötiger Gase;

ein Rohrleitungsnetzwerk zur Zusammenschaltung des Reaktionsofens ($R_1$) und der Quellen (101, 102, 103, 104, 105, 106);

Ventileinrichtungen (MFC1, MFC2, ..., MFC10), die im Rohrleitungsnetzwerk zum Einspeisen vorbestimmter Gasmengen in den Reaktionsofen ($R_1$) angeschlossen sind; und

eine Steuervorrichtung, die den Ventileinrichtungen (MFC1, MFC2, ..., MFC10) Steuersignale zuführt, dadurch gekennzeichnet, daß die Steuereinrichtung (21 bis 54) einen ersten Speicherbereich (24, 26) zum Speichern einer Prozeßprogrammgruppe, die eine Gruppe von Prozeßprogrammen umfaßt, welche Information hinsichtlich einer Zeit zur Kennzeichnung eines Dampfphasen-Aufwachsprozesses im Reaktionsofen, verwendeter Gase, deren Strömungsmengen und der Ofentemperatur einschließen, und einen zweiten Speicherbereich (27) umfaßt, der ein Systemprogramm speichert, das die Prozeßprogrammgruppe zum Erzeugen von Steuersignalen für die Ventileinrichtungen decodiert.

2. Vorrichtung nach Anspruch 1, in welcher jede im ersten Speicherbereich gespeicherte Gruppe von Prozeßprogrammen mit mehreren Prozeßprogrammen gebildet wird, die einer Serie von tatsächlichen Folgeprozessen entsprechen, die durch die gespeicherten Prozeßinformationen definiert sind und die durch die Zeit während eines Dampfphasen-Aufwachszyklusses im Reaktionsofen unterteilt sind.

3. Vorrichtung nach Anspruch 1, in welcher die Steuervorrichtung Einrichtungen (29) zur Darstellung von Inhalten dieser Prozeßprogramme und eine Tastatureingabevorrichtung (31) aufweist, wobei der Inhalt jedes der im ersten Speicherbereich gespeicherten Prozeßprogramme auf den Darstellungseinrichtungen (29) ansprechend auf eine Betätigung der Tastatureingabevorrichtung dargestellt wird, und in welcher das Systemprogramm ein Modifizerinstruktionsprogramm, das auf ein Eingangssignal von der Tastatureingabevorrichtung anspricht, zur Modifikation der Prozeßprogrammgruppe aufweist.

4. Vorrichtung nach Anspruch 1, in welcher das Systemprogramm ferner mit einem Produktionsinstruktionsprogramm zur Erzeugung einer Prozeßprogrammgruppe in Übereinstimmung mit einem Signal von der Tastatureingabevorrichtung und mit einer Darstellungseinrichtung versehen ist.

5. Vorrichtung nach Anspruch 1, in welcher die zweite Speichereinrichtung darüber hinaus ein Decodierprozeßprogramm, das sequentiell entsprechende Prozeßprogramme in der Prozeßprogrammgruppe zur Bildung der Steuersignale, die jeweils den Ventileinrichtungen und der Vorrichtung zum Erwärmen zugeführt werden, decodiert, und ein Modifizierprozeßprogramm speichert zur Modifikation der Inhalte der auf den Darstellungseinrichtungen dargestellten Prozeßprogramme, wobei das Modifizerprozeßprogramm die Fähigkeit besitzt, Daten von Prozeßprogrammen in der Prozeßprogrammgruppe während der Ausführung des Prozesses zu modifizieren.

6. Vorrichtung nach Anspruch 1, in welcher das Prozeßprogramm eine Information enthält, die eine Umschaltung zwischen einem zu einem Ventilport führenden Rohrleitungsnetzwerk und einem zum Reaktionsofen führenden Rohrleitungsnetzwerk bewirkt.

7. Vorrichtung nach Anspruch 6, in welcher die Umschaltung durch eine ÄTZ- oder ANLAGERUNGS-Information bewirkt wird.

8. Vorrichtung nach Anspruch 1, in welcher die zweite Speichereinrichtung ferner ein VERIFIZIER-Prozeßprogramm speichert, um die Daten der Prozeßprogramme in der Prozeßprogrammgruppe darzustellen und eine sich nicht darstellende Information zu verifizieren.

9. Vorrichtung nach Anspruch 1, in welcher die zweite Speichereinrichtung ferner ein SCHRITT-Prozeßprogramm speichert, das ein Prozeßprogramm in der Prozeßprogrammgruppe einträgt oder löscht, um die Folge der Prozeßprogramme zu ändern und um eine sich nicht darstellende Information zu verifizieren.

10. Vorrichtung nach Anspruch 1, in welcher die zweite Speichereinrichtung darüber hinaus ein TEST-Prozeßprogramm speichert, um eine Bestätigung und Bestandsführung der Funktion der Ventileinrichtungen zu bewirken.

11. Vorrichtung nach Anspruch 1, in welcher die Steuervorrichtung eine Eingabeeinrichtung für Prozeßprogrammgruppen aufweist, die dazu ausgelegt ist, daß ihr in einem externen Speichermedium gespeichert Prozeßprogrammgruppen zugeführt werden.

12. Vorrichtung nach Anspruch 11, in welcher das externe Speichermedium ein Magnetband oder eine Magnetkarte aufweist.

13. Vorrichtung nach Anspruch 1, welcher ferne einen weiteren Reaktionsofen ($R_2$) aufweist, wobei beide der Reaktionsofen ($R_1$ und $R_2$) mit Induktionsheizspulen zum Erwärmen der Substrate versehen sind, und in welcher die Steuervorrichtung einen Transferschalter zum wechselweisen Anschließen der Induktionsheizspulen an eine gemeinsame Hochfrequenzquelle enthält.

14. Vorrichtung nach Anspruch 1, in welcher der Speicherbereich (24) die Prozeßprogrammgruppe speichert, die Daten hinsichtlich eines Operationsintervalls des Reaktionsofens einschließt.

15. Vorrichtung nach Anspruch 12, in welcher die Steuervorrichtung eine arithmetische Operationseinrichtung aufweist, die ein erstes Intervall zwischen dem Beginn einer ersten Prozeßprogrammgruppe, die zum Betrieben eines Reaktionsofens ($R_1$) ausgeführt wird, und der Beendigung dieses Prozesses und ein zweites Intervall zwischen dem Beginn einer zweiten Prozeßprogrammgruppe, die zum Betreiben des anderen Reaktionsofens ($R_2$) ausgeführt wird, und deren Beendigung berechnet.

16. Vorrichtung nach Anspruch 12, die ferner mehrere Startschalter aufweist, die dazu ausgelegt sind, einen ersten und einen zweiten Reaktionsofen ($R_1$, $R_2$) zu starten, und eine arithmetische Operationseinrichtung aufweist, die eine Startzeit für eine erste Prozeßfolge des zweiten Ofens auf der Grundlage eines Intervalls T1 zwischen dem Schließen eines Startschalters des ersten Reaktionsofens und der Beendigung einer diesem entsprechenden Prozeßprogrammgruppe, eines Intervalls T2 zwischen dem Start eines zweiten Prozeßprogramms, das dem zweiten Ofen entspricht, und einer Heizanweisung, und einer Zeit T3 berechnet, bei der ein Startschalter des zweiten Reaktionsofens betätigt wird, wodurch ein Intervall zwischen der Beendigung der Stromzufuhr zum ersten Ofen und dem Beginn der Stromzufuhr zum zweiten Ofen verkürzt wird.

17. Vorrichtung nach Anspruch 16, in welcher die arithmetische Operationseinrichtung einen Zähler, der mit einer Ausführungszeit der ersten Prozeßprogrammgruppe hinsichtlich des ersten Reaktionsofens gesetzt wird, eine Vorrichtung zum Dekrementieren des Zählerinhalts zu jedem definierten Zeitpunkt, eine Vorrichtung zum Subtrahieren einer Ausführungszeit de zweiten Prozeßprogrammgruppe hinsichtlich des zweiten Reaktionsofens vom Zählwert des Zählers, um eine Restzeit zu gewinnen, und eine Vorrichtung aufweist, um eine Anweisung zum Starten der zweiten Prozeßprogrammgruppe auszugeben, wenn der Zähler den Zählvorgang hinsichtlich der Restzeit abgeschlossen hat.

18. Vorrichtung nach Anspruch 17, welche ferner einen weiteren Zähler, der mit einer Differenz zwischen einem Intervall zwischen dem Beginn der ersten Prozeßprogrammgruppe in bezug auf den ersten Reaktionsofen und dem Ende dessen Heizung und zwischen einem Intervall, das zwischen dem Beginn der zweiten Prozeßprogrammgruppe in bezug auf den zweiten Reaktionsofen und der Ausgabe einer Heizanweisung hierfür liegt, gesetzt wird, eine Vorrichtung zum Dekrementieren des Zählstandes dieses weiteren Zählers bei jede definierten Zeit nach Beginn der erste Prozeßprogrammgruppe und eine Vorrichtung aufweist, um die Ausführung der zweiten Prozeßprogrammgruppe zu starten, wenn der Inhalt dieses weiteren Zählers auf Null herabgesetzt worden ist.

19. Vorrichtung nach Anspruch 1, in welcher der Reaktionsofen ($R_1$) eine vertikale drehbare Tragvorrichtung zum Haltern mehrerer Halbleitersubstrate über einer Umfangsfläche dieser Tragvorrichtung, ein transparentes abgedichtetes Gehäuse, das die Tragvorrichtung umgibt, weißglühende Lampen, die außerhalb dieses Gehäuses zum Erwärmen der Halbleitersubstrate angeordnet sind, und eine Vorrichtung aufweist, um Reaktionsgase in das Gehäuse zum Hervorrufen des Aufwachsens von N oder P Halbleiterschichten aus der Dampfphase auf den Halbleitersubstraten einzuleiten.

20. Vorrichtung nach Anspruch 1, welche ferner eine Temperaturdetektoreinrichtung (TS, 93) zum Erfassen der Temperatur des Wafers im Reaktionsofen ($R_1$) und eine Ausgangssteuervorrichtung aufweist, die den Ausgang der Heizquelle in Übereinstimmung mit einem vorgegebenen Bezugswert steuert, wobei diese Steuervorrichtung einen weiteren Speicherbereich, der ein Programm speichert, um diese Folgen auszuführen und die Wafertemperatur mit einem vorbestimmten Temperaturgradienten in einer Vielzahl von unterteilten Zeitintervalleinheiten im wesentlichen linear anzuheben und abzusenken, indem unterschiedliche Temperaturänderungsraten in entsprechenden Zeiteinheiten gemacht werden, und eine Vorrichtung zum Verarbeiten dieses Programms aufweist.

21. Vorrichtung nach Anspruch 20, in welcher zum Zeitpunkt des Ausführens von Temperaturänderungsfolgen die Temperatur des Wafers als Bezug genommen wird, die Prozeßvorrichtung einen Temperaturbezugswert bestimmt, indem sie die Temperaturänderungsraten in den jeweiligen Zeitintervalleinheiten auf adäquate Beträge korrigiert, um in den jeweiligen Folgen die letzte Targettemperatur zu erreichen, und in welcher die Verarbeitungsvorrichtung eine Einrichtung aufweist, um die korrigierten Temperaturänderungsraten der Heizquelle zuzuführen.

22. Vorrichtung nach Anspruch 20, in welcher die Speichervorrichtung einen ROM aufweist, der ein Programm speichert, welches die Programmsequenzen zum Ausführen der Temperaturänderungen speichert.

23. Vorrichtung nach Anspruch 1, in welcher der Reaktionsofen ($R_1$) eine drehbare Tragvorrichtung (75), die dazu ausgelegt ist, mehrere Halbleiterwafer (91) zu haltern, eine Hochfrequenzinduktionsspule

(79), die von der Quelle zum Heizen dieser Wafer erregt wird, und einem Temperaturfühler (TS) aufweist, der die Temperatur der Wafer erfaßt.

## Revendications

1. Appareil de croissance en phase vapeur d'un semiconducteur comprenant:

un four de réaction ($R_1$) pour faire croître en phase vapeur en semi-conducteur (91) sur un substrat de semi-conducteur;

des moyens (79) servant à chauffer ledit substrat;

des sources (101, 102, 103, 104, 105, 106) de différents gaz nécessaires pour la croissance en phase vapeur;

un réseau de conduites servant à interconnecter ledit four de réaction ($R_1$) et lesdites sources (101, 102, 103, 104, 105, 106);

des moyens du type soupapes (MFC1, MFC2, . . ., MFC10) connectés dans ledit réseau de conduites pour fournir des quantités prédéterminées desdits gaz audit four de réaction ($R_1$); et

des moyens de commande servant à envoyer des signaux de commande auxdits moyens du type soupapes (MFC1, MFC2, . . ., MFC10), caractérisé en ce que

lesdits moyens de commande (21 à 54) comprennent une première région de mémoire (24, 26) servant à mémoriser un groupe de programmes de traitement qui comprend un groupe de programmes de traitement incluant des informations relatives à un temps pour désigner un processus de croissance en phase gazeuse dans ledit four de réaction, au gaz utilisés, aux débits de ces gaz et à la température du four, et une deuxième région de mémoire (27) qui mémorise un programme de système qui décode ledit groupe de programmes de traitement en produisant des signaux de commande pour lesdits moyens du type soupape.

2. Appareil selon la revendication 1, caractérisé en ce que chaque groupe de programmes de traitement mémorisés dans la première zone de mémoire est formé d'une pluralité de programmes de traitements qui correspondent à une série de traitements en séquence réelle définie par lesdites informations de traitement mémorisées et divisées par le temps pendant un cycle de croissance en phase vapeur dans ledit four de réaction.

3. Appareil selon la revendication 1, caractérisé en ce que lesdits moyens de commande comprennent des moyens (29) destinés à afficher le contenu desdits programmes de traitement, et des moyens d'entrée à touches (31) sous l'action desquels le contenu de chacun desdits programmes de traitement mémorisés dans ladite première zone de mémoire s'affichent sur lesdits moyens d'affichage (29) en réponse à une manoeuvre desdits moyens d'entrée à touches, et en ce que ledit programme de système comprend un programme d'instruction de modification qui répond à un signal d'entrée issu desdits moyens d'entrée à touches en modifiant ledit groupe de programmes de traitement.

4. Appareil selon la revendication 1, caractérisé en ce que ledit programme de système est en outre équipé d'un programme d'instruction de production destiné à produire un groupe de programmes de traitement en fonction d'un signal émis par lesdits moyens d'entrée à touches, et des moyens d'affichage.

5. Appareil selon la revendication 1, caractérisé en ce que lesdits moyens de mémoire mémorisent en outre un programme de traitements de décodage qui décodent séquentiellement des programmes de traitements respectifs contenus dans ledit groupe de programmes de traitements pour former les signaux de commande qui sont respectivement appliqués auxdits moyens du type vannes et auxdits moyens de chauffage, et un programme de traitements modificateurs destiné à modifier le contenu des programmes de traitements affichés sur lesdits moyens d'affichage, ledit programme de traitements modificateurs étant capable de modifier les données desdits programmes de traitements contenus dans ledit groupe de programmes de traitements pendant l'exécution du traitement.

6. Appareil selon la revendication 1, caractérisé en ce que ledit programme de traitement contient une information qui effectue une commutation entre un réseau de conduites qui mène à un orifice d'échappement et un réseau de conduites qui mène audit four de réaction.

7. Appareil selon la revendication 6, caractérisé en ce que ladite commutation s'effectue par une information de GRAVURE ou DEPOSITION;

8. Appareil selon la revendication 1, caractérisé en ce que lesdits deuxièmes moyens de mémoire mémorisent en outre un programme de traitement VERIFICATION destiné à afficher les données des programmes de traitements contenus dans ledit groupe de programme de traitement et pour vérifier une information qui n'est pas présente.

9. Appareil selon la revendication 1, dans lequel lesdits deuxièmes moyens de mémoire mémorisent en outre un programme de traitements PHASE qui enregistre ou efface un programme de traitements contenu dans ledit groupe de programmes de traitement pour changer la séquence desdits programmes de traitement et pour vérifier une information qui n'est pas présente.

10. Appareil selon la revendication 1, caractérisé en ce que lesdits deuxièmes moyens de mémoire mémorisent en outre un programme de traitements ESSAI destiné à effectuer la confirmation et le maintien de l'opération desdits moyens du type vanne.

11. Appareil selon la revendication 1, caractérisé en ce que lesdits moyens de commande sont munis

de moyens d'entrée pour le groupe de programmes de traitement, qui sont adaptés pour être alimentés à l'aide de groupes de programmes mémorisés dans un milieu de mémoire extérieur.

12. Appareil selon la revendication 11, caractérisé en ce que ledit milieu de mémoire extérieur comprend une bande magnétique ou une carte magnétique.

13. Appareil selon la revendication 1, caractérisé en ce qu'il comprend en outre un autre four de réaction ($R_2$), les deux fours de réaction ($R_1$ et $R_2$) étant munis de bobines de chauffage par induction servant à chauffer lesdits substrats, et dans lequel lesdits moyens de commande comprennent un commutateur de transfert servant à connecter alternativement lesdites bobines de chauffage à induction à une source de haute fréquence commune.

14. Appareil selon la revendication 1, caractérisé en ce que ladite région de mémoire (24) mémorise ledit groupe de programmes de traitement qui contient des données relatives à un intervalle de fonctionnement dudit four de réaction.

15. Appareil selon la revendication 12, caractérisé en ce que lesdits moyens de commande comprennent des moyens de travail arithmétiques qui calculent un premier intervalle compris entre le départ d'un premier groupe de programmes de traitement, exécuté pour commander un four de réaction ($R_1$) et la fin dudit traitement, et un deuxième intervalle compris entre le début d'un deuxième groupe de programmes de traitement, exécuté pour commander un autre four de réaction ($R_2$) et la fin de ce groupe.

16. Appareil selon la revendication 12, caractérisé en ce qu'il comprend en outre une pluralité de commutateurs de mise en marche adaptés pour mettre en marche le premier et le deuxième four ($R_1$, $R_2$) et des moyens d'opération arithmétiques qui calculent un premier instant de début de séquence de traitement dudit deuxième four sur la base d'un intervalle (T1) compris entre la fermeture d'un interrupteur de mise en marche du premier four de traitement et la fin d'un groupe de programmes de traitement qui lui correspond, un intervalle (T2) compris entre le début d'un deuxième programme de traitement qui correspond audit deuxième four et à une instruction de chauffe, et un instant (T3) auquel un interrupteur de mise en marche dudit deuxième four de réaction est actionné, pour raccourcir de cette façon l'intervalle de temps qui s'écoule entre la fin de l'alimentation en puissance dudit premier four et le début de l'alimentation en puissance dudit deuxième four.

17. Appareil selon la revendication 16, caractérisé en ce que lesdits moyens d'opérations arithmétiques comprennent un compteur réglé sur un temps d'exécution dudit premier groupe de programmes de traitement relatif audit premier four de réaction, des moyens pour décrémenter le contenu dudit compteur à chaque instant défini, des moyens servant à soustraire un temps d'exécution du deuxième groupe de programmes de traitement relatif audix deuxième four de réaction du compte dudit compteur pour produire un temps restant, et des moyens qui émettent l'instruction pour la mise en marche dudit deuxième groupe de programmes de traitement lorsque le compteur termine le comptage dudit temps restant.

18. Appareil selon la revendication 17, caractérisé en ce qu'il comprend en outre un autre compteur réglé sur la différence d'un intervalle compris entre le début du premier groupe de programmes de traitement relatif audit premier four de réaction et la fin du chauffage de ce dernier, et d'un intervalle entre le second groupe de programmes de traitement relatif au second four de réaction et la fin d'une instruction de chauffage de ce dernier, des moyens pour décrémenter le compte dudit autre compteur à chaque moment défini après le début dudit premier groupe de programmes de traitement, et des moyens pour enclencher l'exécution dudit second groupe de programmes de traitement lorsque le contenu dudit autre compteur est réduit à zéro.

19. Appareil selon la revendication 1, caractérisé en ce que ledit four de réaction ($R_1$) comprend un support vertical rotatif (75) destiné à supporter une pluralité de substrats semi-conducteurs sur une surface périphérique dudit support, un boîtier transparent et étanche (90) entourant ledit support, des lampes incandescentes disposées à l'extérieur du boîtier afin de chauffer les substrats semi-conducteurs et des moyens (72) pour introduire des gaz de réaction dans le boîtier (90) pour causer la croissance en phase vapeur de couches semi-conducteurs du type N ou P sur les substrats semi-conducteurs.

20. Appareil selon la revendication 1, caractérisé en ce qu'il comprend en outre des moyens de détection de la température (TS, 93) qui détectent la température de la tranche contenue dans le four de réaction ($R_1$), et des moyens de commande de sortie qui commandent la sortie de ladite source de chauffage en fonction d'une valeur de référence donnée, et en ce que lesdits moyens de commande comprennent une autre région de mémoire qui contient un programme d'exécution desdites séquences et qui élève et abaisse la température de la tranche sensiblement linéairement avec un gradient de température prédéterminé, dans une pluralité d'unités d'intervalles de temps divisés, en provoquant des vitesses différentes de variation de la température dans les unités de temps respectives, et des moyens qui traitent ledit programme.

21. Appareil selon la revendication 20, caractérisé en ce qu'au moment de l'exécution de séquences de variation de la température, la température de ladite tranche est prise comme référence, lesdits moyens de traitement déterminent une valeur référence de température en corrigeant lesdites vitesses de variation de température en unités d'intervalles de temps appropriés pour atteindre la dernière température cible et des séquences respectives, et en ce que ledits moyens de traitement comprennent des moyens pour appliquer lesdites vitesses corrigées des variations de température à ladite source de chauffage.

22. Appareil selon la revendication 20, caractérisé en ce que lesdits moyens de mémoire comprennent

une ROM qui mémorise un programme comprenant des références de programme pour exécuter lesdites variations de température.

23. Appareil selon la revendication 1, caractérisé en ce que ledit four de réaction ($R_1$) comprend un support rotatif (75) conçu pour supporter une pluralité de tranches de semi-conducteurs (91), une bobine d'induction à haute fréquence (79) mise sous tension par ladite source pour chauffer les tranches, et un capteur de température (TS) pour détecter la température desdites tranches.

FIG. 1
PRIOR ART

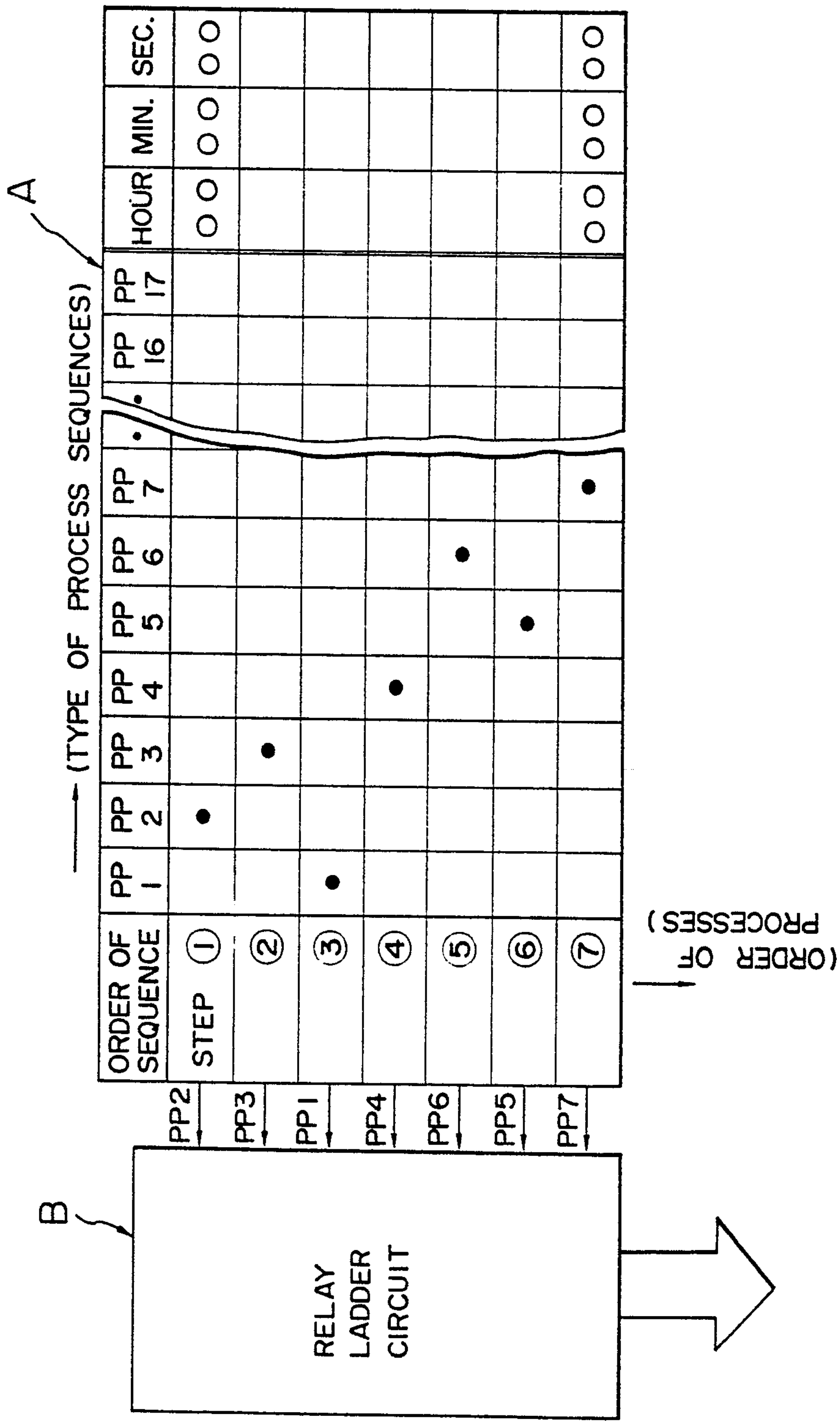

FIG. 2

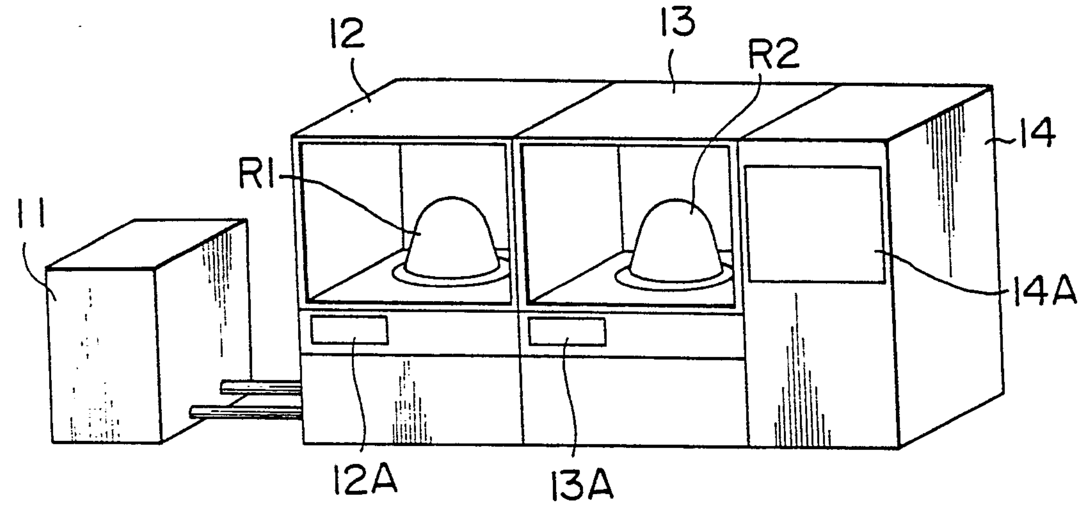
12
13
R2
14
R1
11
14A
12A
13A

FIG. 3

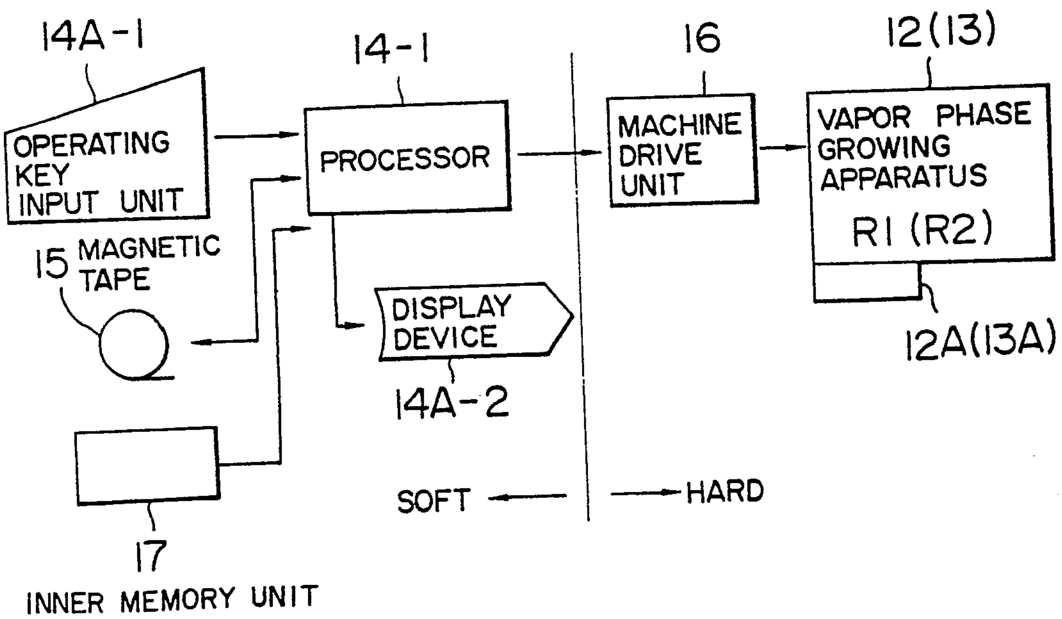
14A-1
OPERATING KEY INPUT UNIT
14-1
PROCESSOR
16
MACHINE DRIVE UNIT
12(13)
VAPOR PHASE GROWING APPARATUS
R1 (R2)
12A(13A)
15 MAGNETIC TAPE
DISPLAY DEVICE
14A-2
SOFT
HARD
17
INNER MEMORY UNIT

FIG. 4

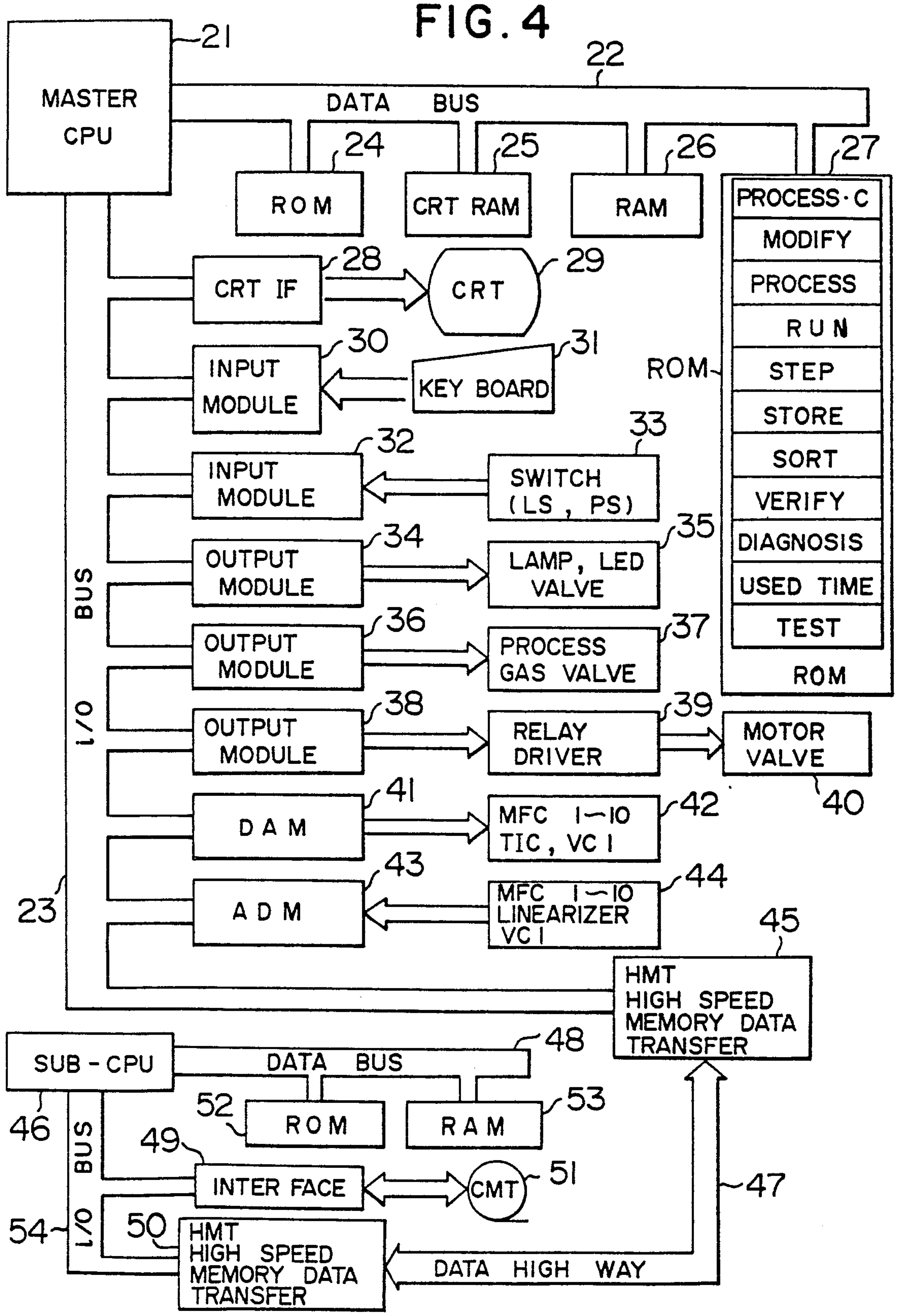
21
MASTER CPU
22
DATA BUS
24
ROM
25
CRT RAM
26
RAM
27
PROCESS·C
MODIFY
PROCESS
RUN
STEP
STORE
SORT
VERIFY
DIAGNOSIS
USED TIME
TEST
ROM
ROM
28
CRT IF
29
CRT
30
INPUT MODULE
31
KEY BOARD
32
INPUT MODULE
33
SWITCH (LS, PS)
34
OUTPUT MODULE
35
LAMP, LED VALVE
36
OUTPUT MODULE
37
PROCESS GAS VALVE
38
OUTPUT MODULE
39
RELAY DRIVER
MOTOR VALVE
40
41
D A M
42
MFC 1—10 TIC, VC 1
43
A D M
44
MFC 1—10 LINEARIZER VC 1
45
HMT HIGH SPEED MEMORY DATA TRANSFER
I/O BUS
23
SUB - CPU
DATA BUS
48
46
52
ROM
RAM
53
49
INTER FACE
CMT
51
47
BUS
I/O
54
50
HMT HIGH SPEED MEMORY DATA TRANSFER
DATA HIGH WAY

FIG. 5

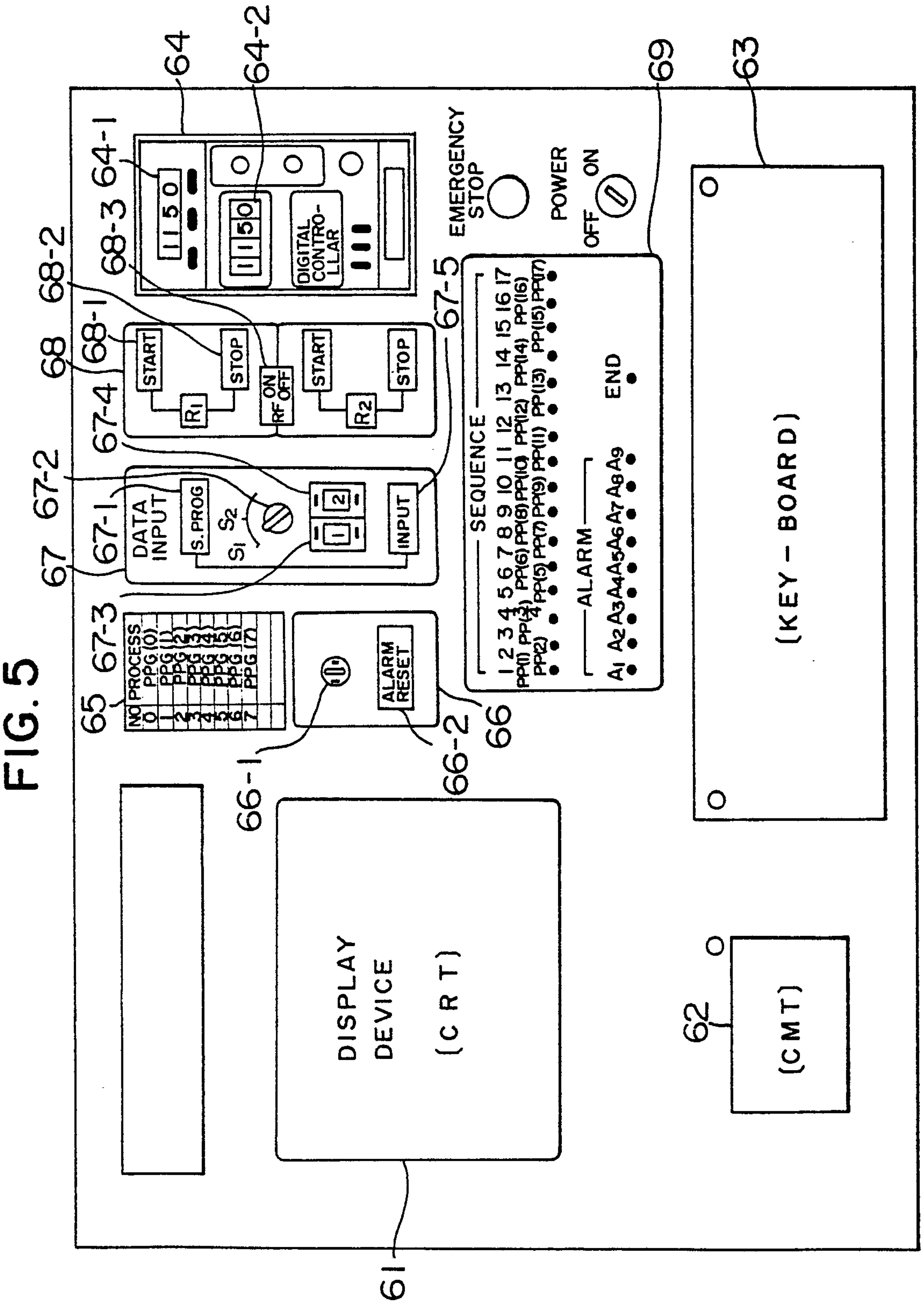
DIGITAL CONTRO-LLAR
EMERGENCY STOP
POWER
ON
OFF
START
STOP
RF ON OFF
DATA INPUT
S.PROG
INPUT
ALARM RESET
NO PROCESS
SEQUENCE
ALARM
END
(KEY - BOARD)
DISPLAY DEVICE (CRT)
(CMT)
61
62
63
64
64-1
64-2
65
66
66-1
66-2
67
67-1
67-2
67-3
67-4
67-5
68
68-1
68-2
68-3
69

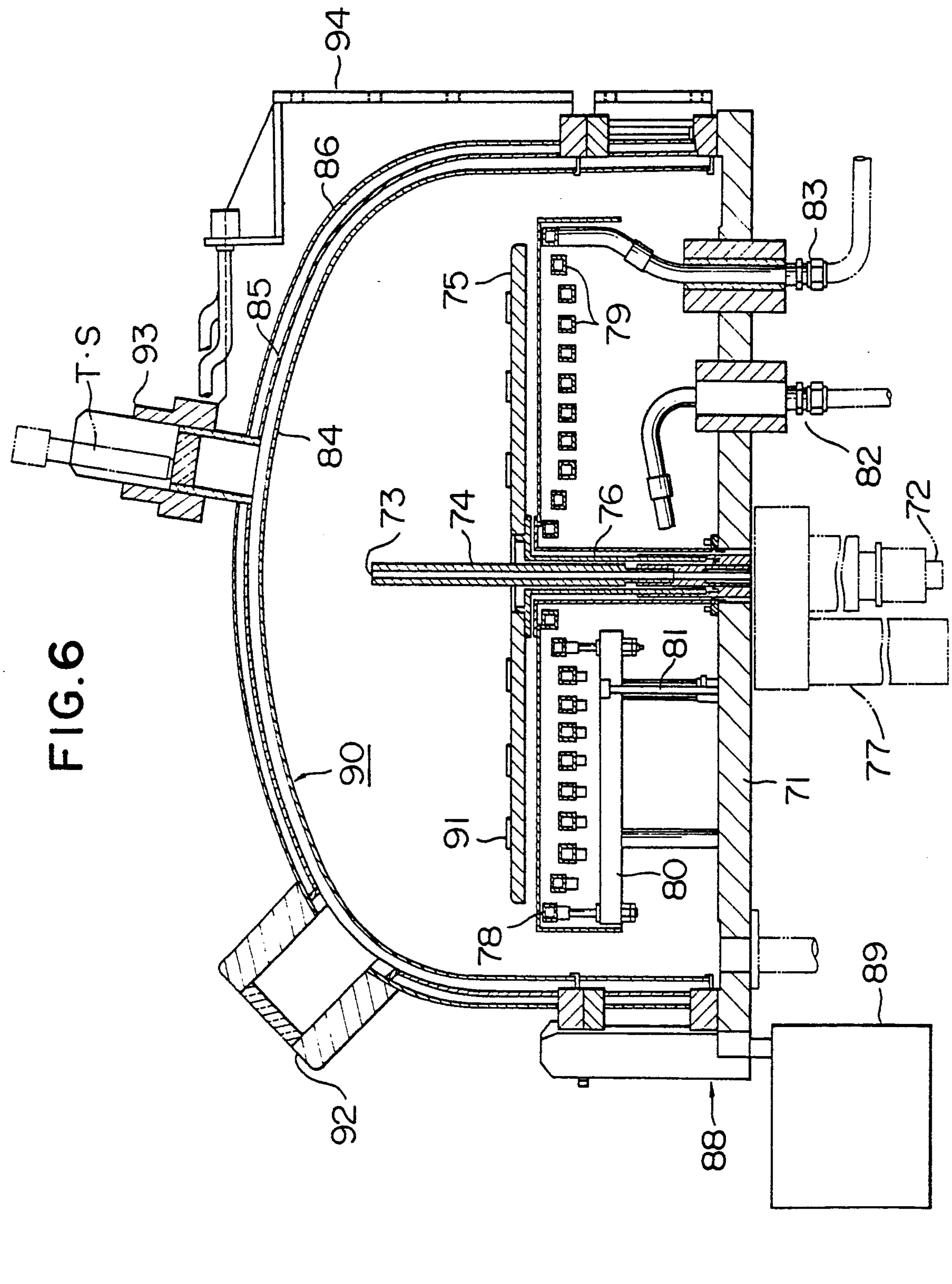


FIG.6

FIG. 7

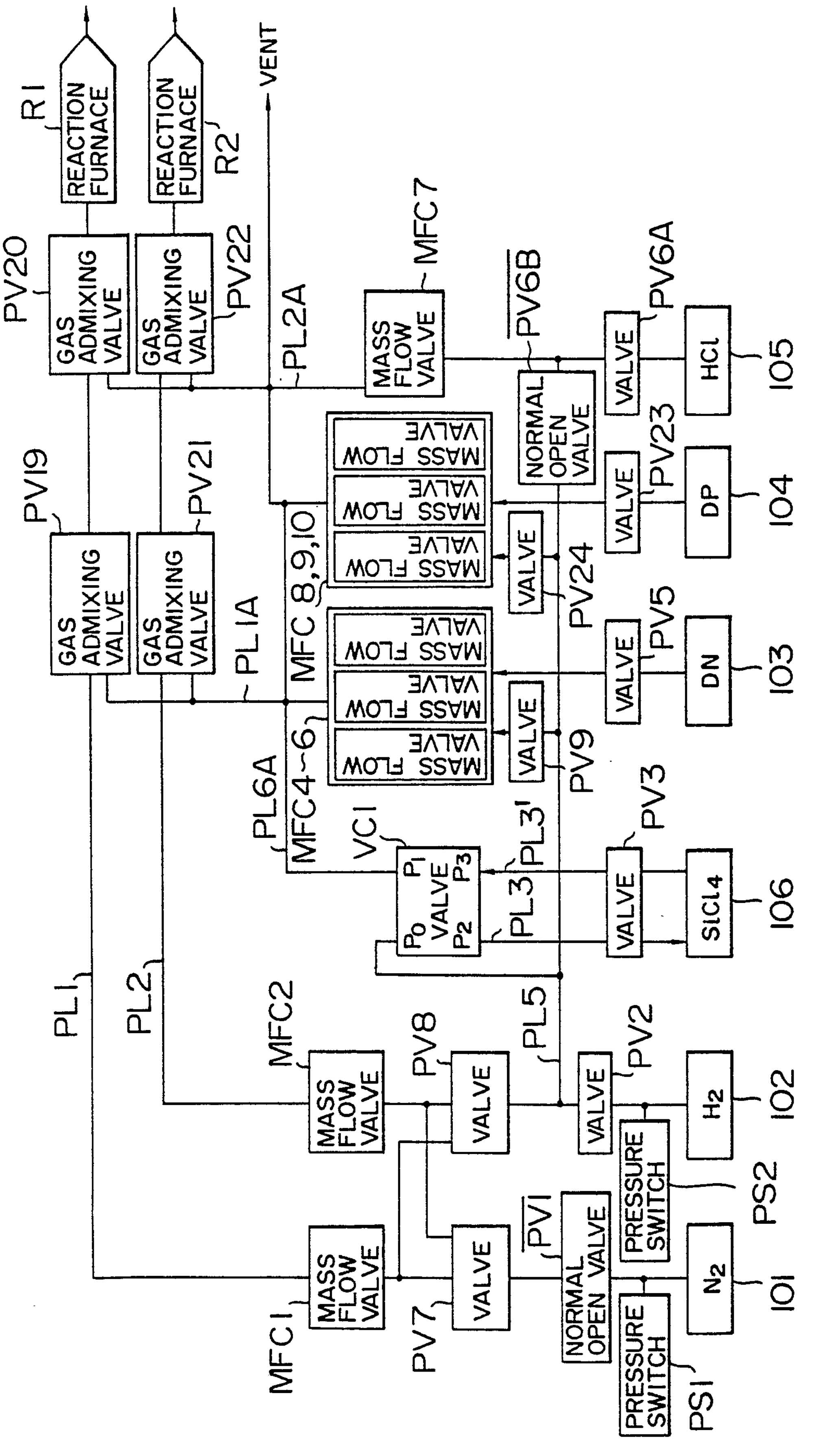
R1
REACTION FURNACE
REACTION FURNACE
R2
VENT
PV20
GAS ADMIXING VALVE
GAS ADMIXING VALVE
PV22
PL2A
MASS FLOW VALVE
MFC7
PV19
GAS ADMIXING VALVE
GAS ADMIXING VALVE
PV21
PL1A
MFC 8,9,10
MASS FLOW VALVE
MASS FLOW VALVE
MASS FLOW VALVE
NORMAL OPEN VALVE
PV6B
VALVE
PV6A
HCl
105
VALVE
PV23
DP
104
VALVE
PV24
VALVE
PV5
DN
103
MASS FLOW VALVE
MASS FLOW VALVE
MASS FLOW VALVE
VALVE
PV9
PL6A
MFC4~6
VC1
P0 VALVE P2 P1 P3
PL3'
PL3
VALVE
PV3
SiCl4
106
PL1
PL2
MFC2
MASS FLOW VALVE
PV8
VALVE
PL5
VALVE
PV2
H2
102
PRESSURE SWITCH
PS2
MASS FLOW VALVE
MFC1
VALVE
PV7
NORMAL OPEN VALVE
PV1
PRESSURE SWITCH
N2
101
PRESSURE SWITCH
PS1

FIG.8

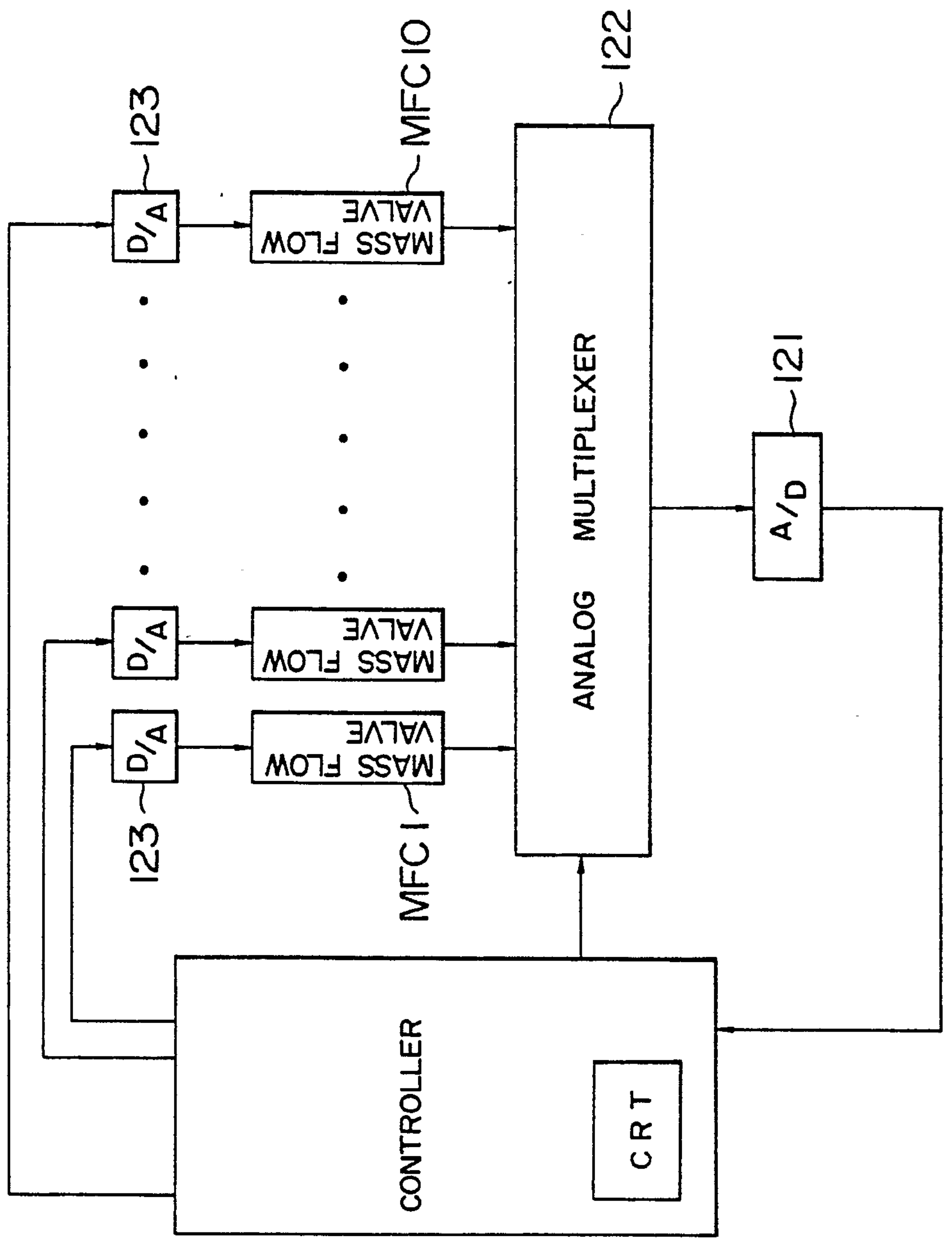
123
D/A
MASS FLOW VALVE
MFC10
MFC1
122
ANALOG MULTIPLEXER
A/D
121
CONTROLLER
CRT

# FIG. 9

PROCESS NAME PPG (4)

| PP NO. | TIME | GAS FLOW $N_2$ | $H_2$ | $D_N$ | $D_P$ | $SiCl_4$ | HCl | θ °C TEMPERATURE |
|---|---|---|---|---|---|---|---|---|
| 1 | 3:00 | FN1L | | | | | | |
| 2 | 3:00 | | FH2L | | | | | |
| 3 | 3:00 | | ↓ | | | | | θ1 |
| 4 | 3:00 | | ↓ | | | | | θ2 |
| 5 | 3:00 | | ↓ | | | | FNHCL | ↓ |
| 6 | 3:00 | | ↓ | | | | ↓ | ↓ |
| 7 | 3:00 | | ↓ | | | | | ↓ |
| 8 | 3:00 | | ↓ | | | | | θ3 |
| 9 | 3:00 | | ↓ | | FDP | FS1 | | ↓ |
| 10 | 3:00 | | ↓ | | ↓ | ↓ | | ↓ |
| 11 | 3:00 | | ↓ | | | | | ↓ |
| 12 | | | | | | | | ↓ |
| 13 | | | | | | | | ↓ |
| 14 | | | | | | | | ↓ |
| 15 | 3:00 | | ↓ | | | | | |
| 16 | 3:00 | | ↓ | | | | | |
| 17 | 3:00 | FN17L | | | | | | |
| (END) | | | | | | | | |

FIG. 10

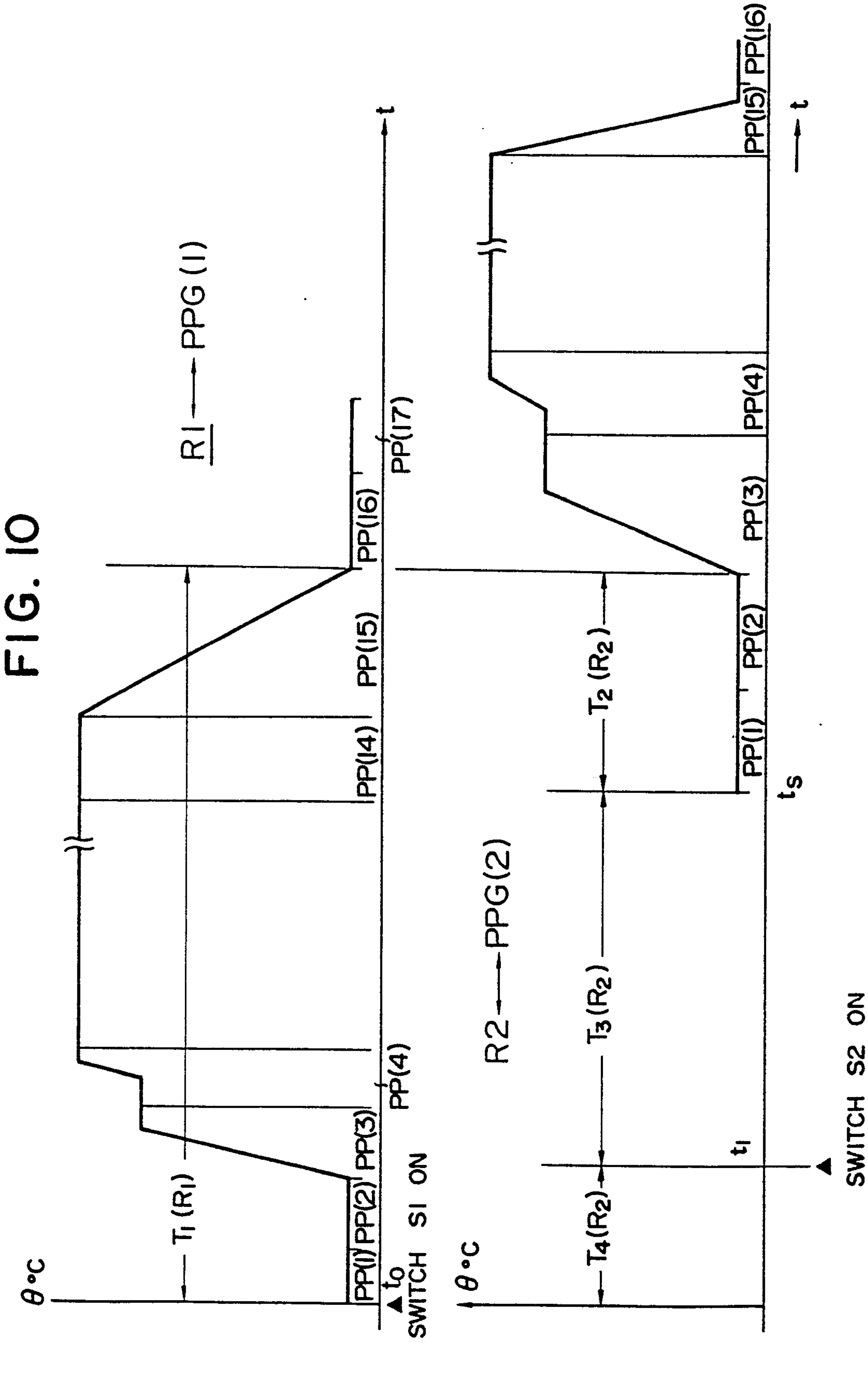

R1 ⟷ PPG (1)
θ °C
T1 (R1)
PP(1) PP(2) PP(3) PP(4) PP(14) PP(15) PP(16) PP(17)
t0
SWITCH S1 ON
t
R2 ⟷ PPG(2)
θ °C
T4(R2)
T3(R2)
T2 (R2)
t1
tS
PP(1) PP(2) PP(3) PP(4) PP(15) PP(16)
SWITCH S2 ON
t

FIG. 11

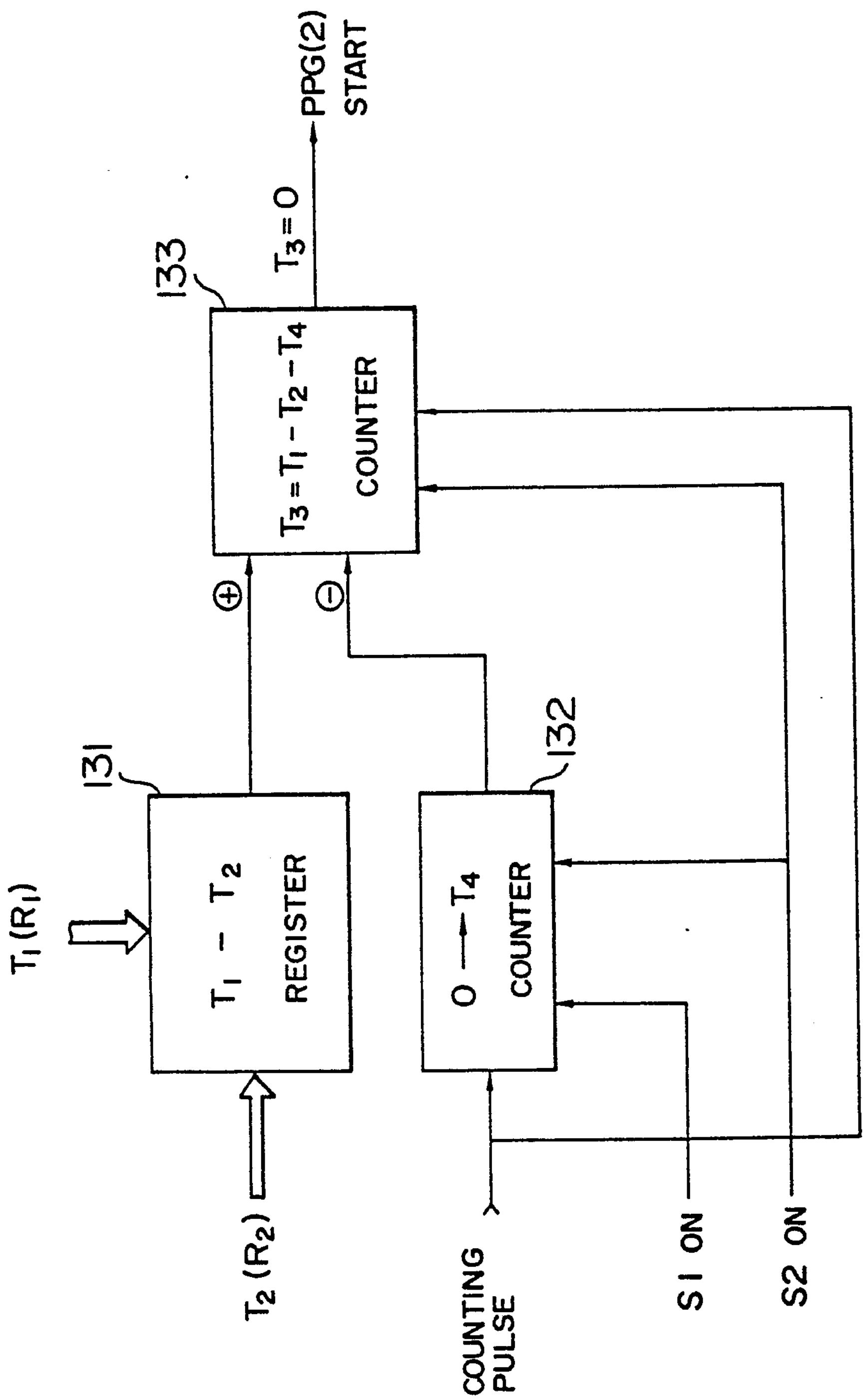

PPG(2) START
$T_3 = 0$
133
$T_3 = T_1 - T_2 - T_4$
COUNTER
⊕
⊖
131
$T_1(R_1)$
$T_1 - T_2$
REGISTER
$T_2(R_2)$
132
$0 \longrightarrow T_4$
COUNTER
COUNTING PULSE
S1 ON
S2 ON

FIG.12a

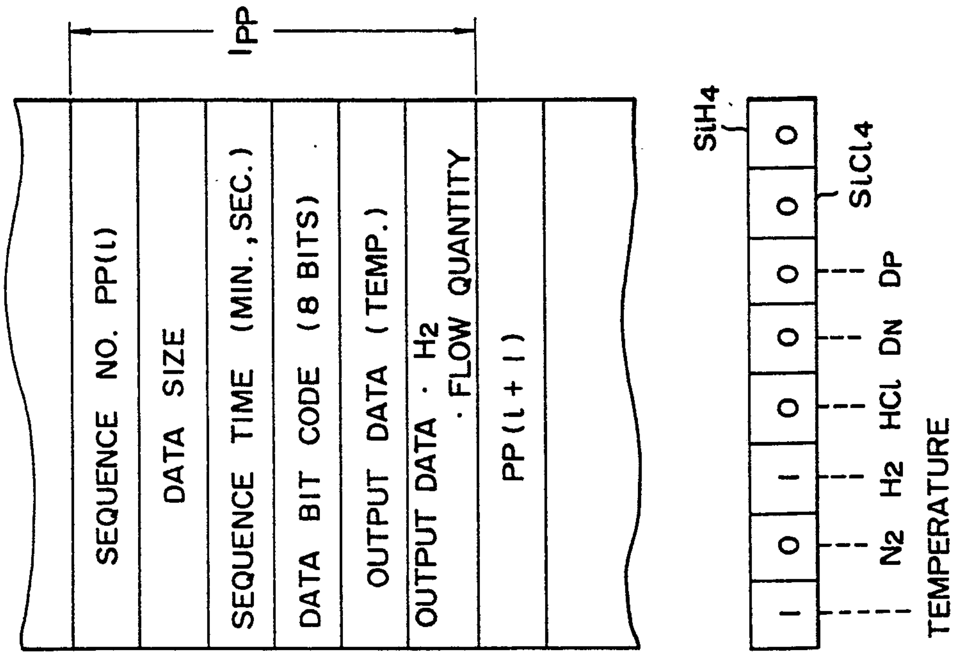


FIG.12b

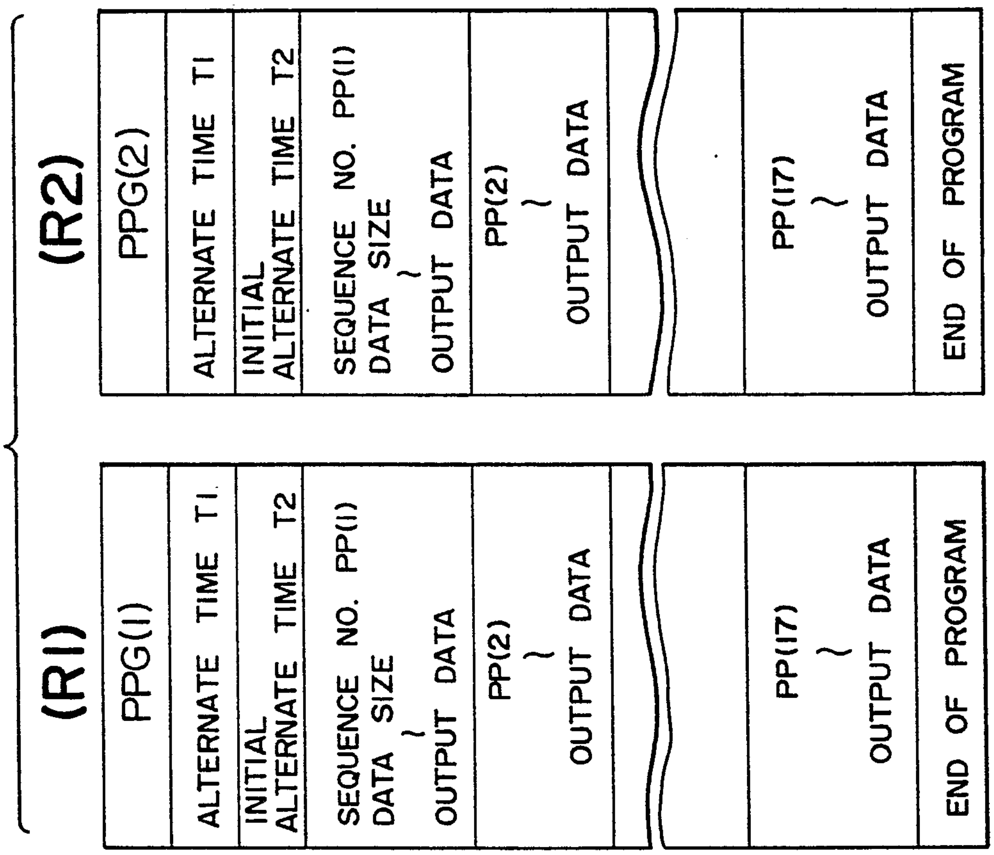

FIG.13

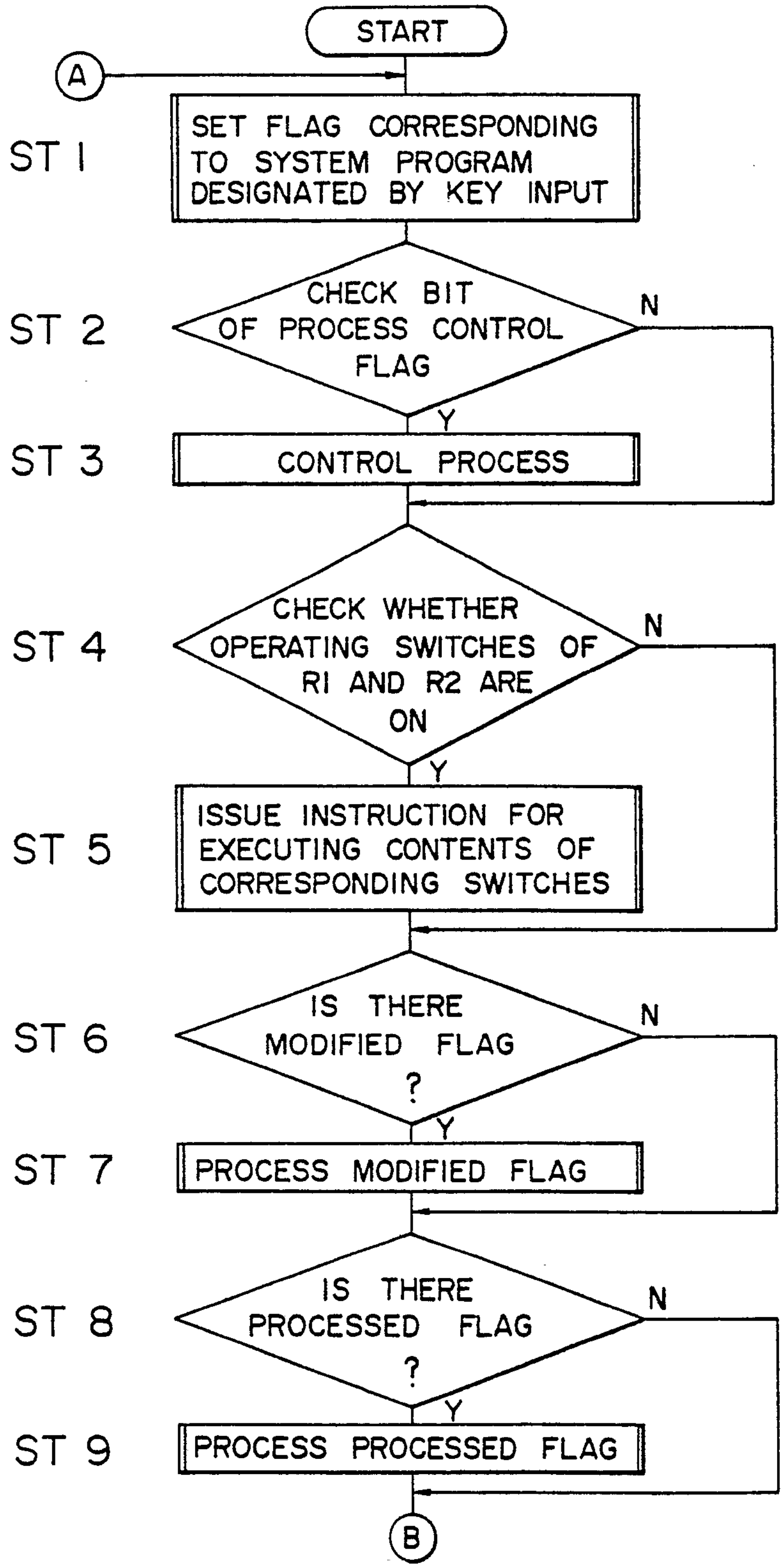
START
A
ST 1
SET FLAG CORRESPONDING TO SYSTEM PROGRAM DESIGNATED BY KEY INPUT
ST 2
CHECK BIT OF PROCESS CONTROL FLAG
N
Y
ST 3
CONTROL PROCESS
ST 4
CHECK WHETHER OPERATING SWITCHES OF R1 AND R2 ARE ON
N
Y
ST 5
ISSUE INSTRUCTION FOR EXECUTING CONTENTS OF CORRESPONDING SWITCHES
ST 6
IS THERE MODIFIED FLAG ?
N
Y
ST 7
PROCESS MODIFIED FLAG
ST 8
IS THERE PROCESSED FLAG ?
N
Y
ST 9
PROCESS PROCESSED FLAG
B

FIG. 13

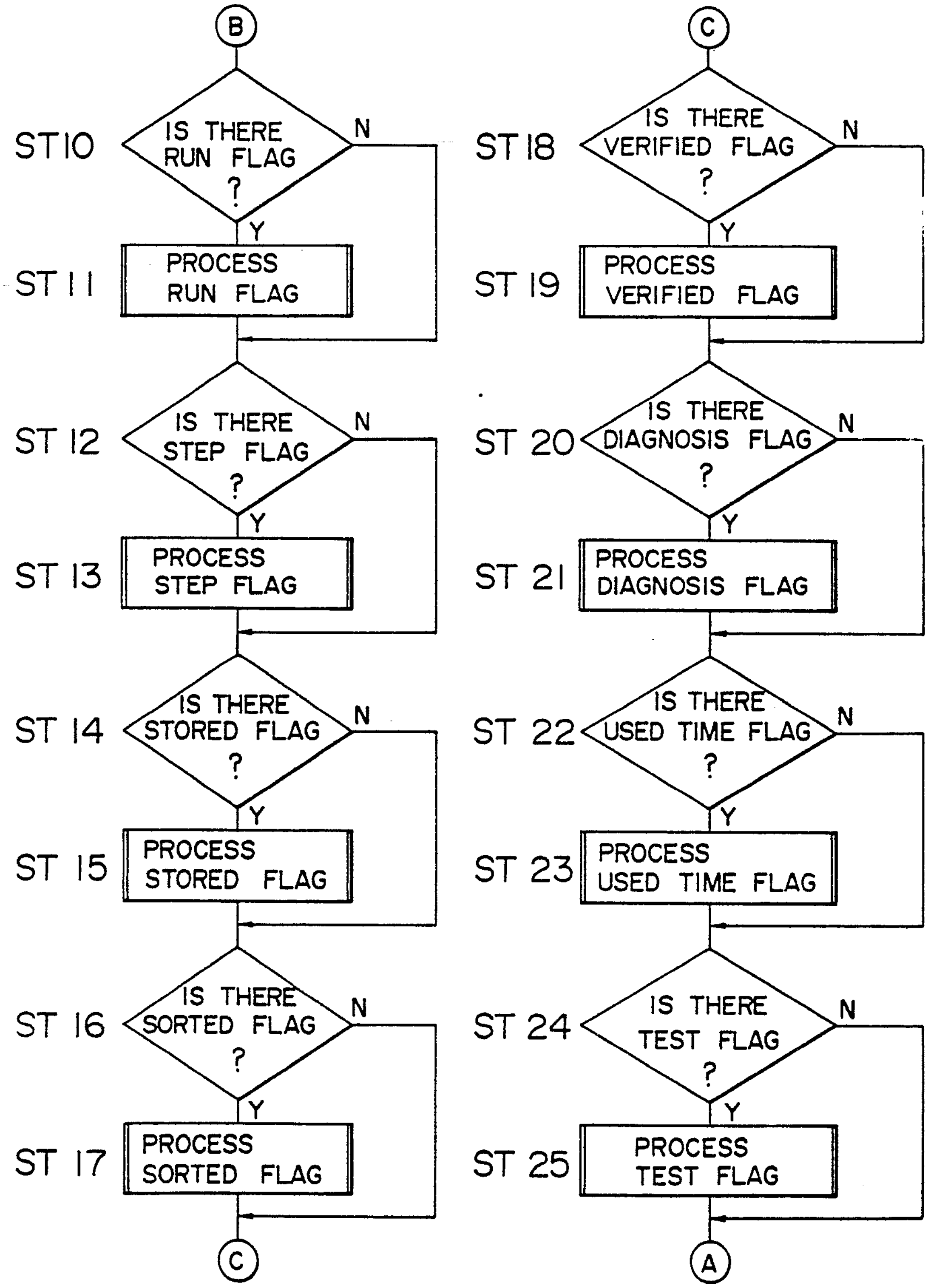
B
ST10
IS THERE RUN FLAG ?
N
Y
ST 11
PROCESS RUN FLAG
ST 12
IS THERE STEP FLAG ?
N
Y
ST 13
PROCESS STEP FLAG
ST 14
IS THERE STORED FLAG ?
N
Y
ST 15
PROCESS STORED FLAG
ST 16
IS THERE SORTED FLAG ?
N
Y
ST 17
PROCESS SORTED FLAG
C
C
ST 18
IS THERE VERIFIED FLAG ?
N
Y
ST 19
PROCESS VERIFIED FLAG
ST 20
IS THERE DIAGNOSIS FLAG ?
N
Y
ST 21
PROCESS DIAGNOSIS FLAG
ST 22
IS THERE USED TIME FLAG ?
N
Y
ST 23
PROCESS USED TIME FLAG
ST 24
IS THERE TEST FLAG ?
N
Y
ST 25
PROCESS TEST FLAG
A

FIG. 14

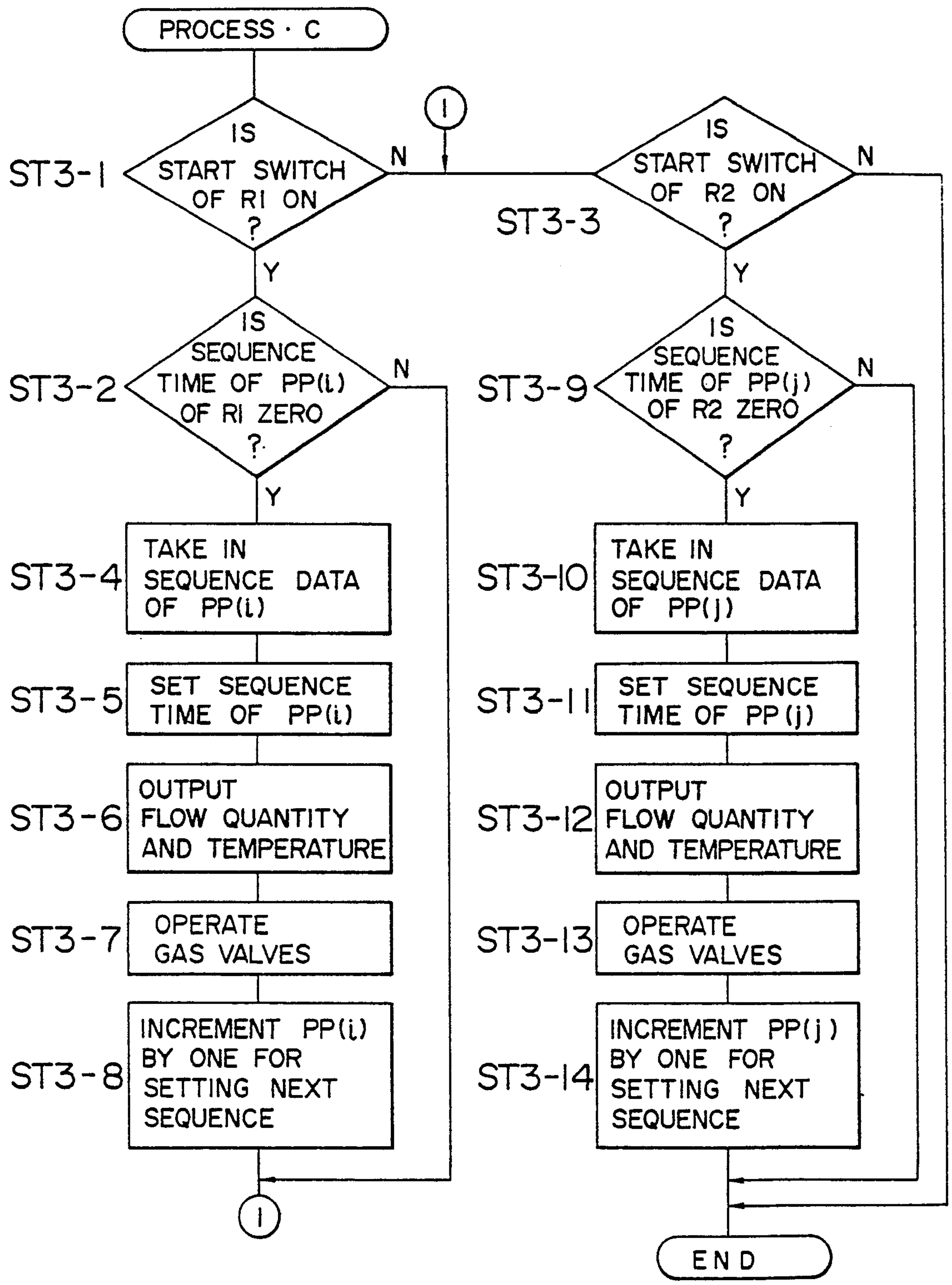
PROCESS · C
ST3-1
IS START SWITCH OF R1 ON ?
N
Y
ST3-2
IS SEQUENCE TIME OF PP(i) OF R1 ZERO ?
ST3-4
TAKE IN SEQUENCE DATA OF PP(i)
ST3-5
SET SEQUENCE TIME OF PP(i)
ST3-6
OUTPUT FLOW QUANTITY AND TEMPERATURE
ST3-7
OPERATE GAS VALVES
ST3-8
INCREMENT PP(i) BY ONE FOR SETTING NEXT SEQUENCE
1
ST3-3
IS START SWITCH OF R2 ON ?
ST3-9
IS SEQUENCE TIME OF PP(j) OF R2 ZERO ?
ST3-10
TAKE IN SEQUENCE DATA OF PP(j)
ST3-11
SET SEQUENCE TIME OF PP(j)
ST3-12
OUTPUT FLOW QUANTITY AND TEMPERATURE
ST3-13
OPERATE GAS VALVES
ST3-14
INCREMENT PP(j) BY ONE FOR SETTING NEXT SEQUENCE
END

FIG.15

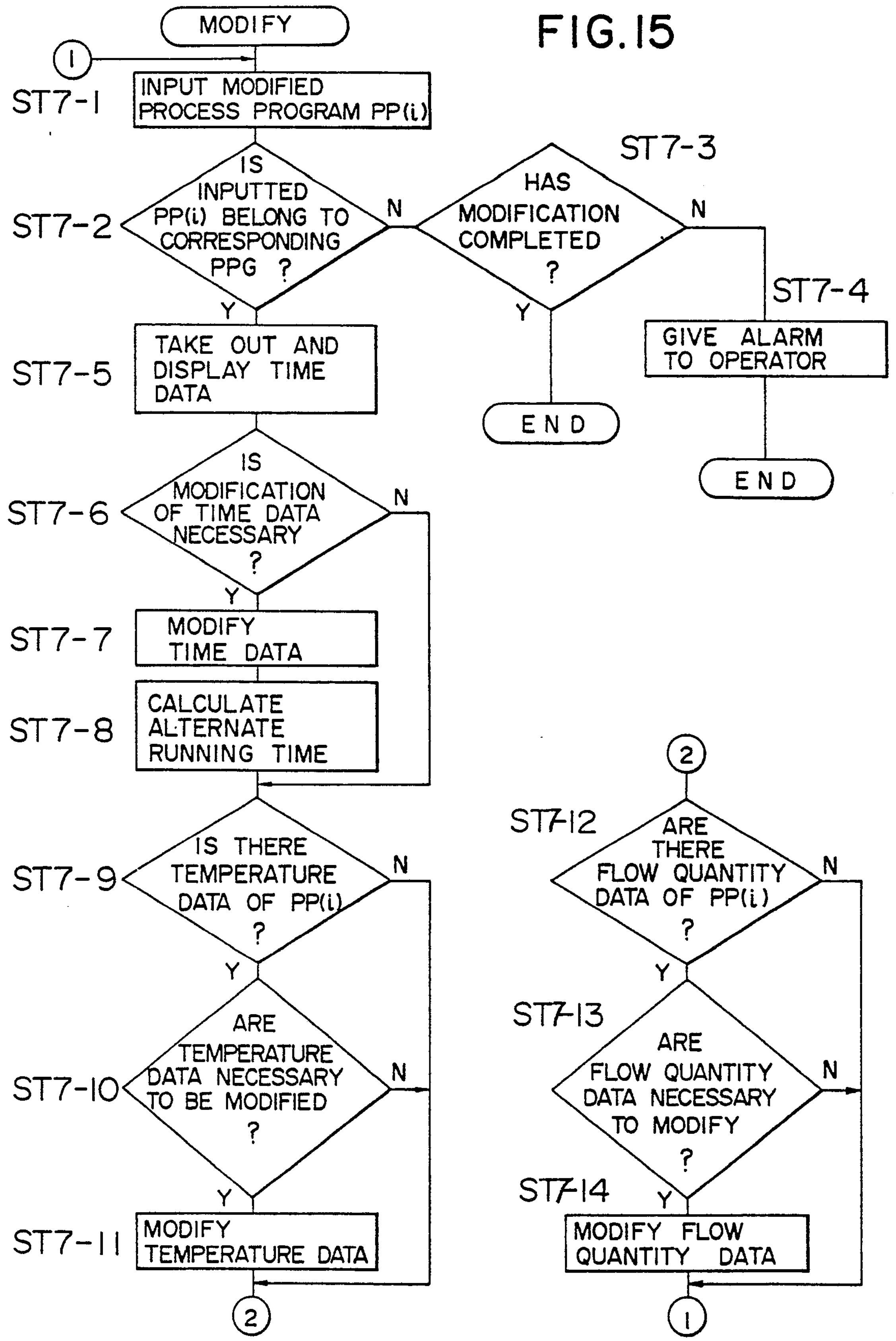
MODIFY
1
ST7-1
INPUT MODIFIED PROCESS PROGRAM PP(i)
ST7-2
IS INPUTTED PP(i) BELONG TO CORRESPONDING PPG ?
N
Y
ST7-3
HAS MODIFICATION COMPLETED ?
N
Y
END
ST7-4
GIVE ALARM TO OPERATOR
END
ST7-5
TAKE OUT AND DISPLAY TIME DATA
ST7-6
IS MODIFICATION OF TIME DATA NECESSARY ?
N
Y
ST7-7
MODIFY TIME DATA
ST7-8
CALCULATE ALTERNATE RUNNING TIME
ST7-9
IS THERE TEMPERATURE DATA OF PP(i) ?
N
Y
ST7-10
ARE TEMPERATURE DATA NECESSARY TO BE MODIFIED ?
N
Y
ST7-11
MODIFY TEMPERATURE DATA
2
2
ST7-12
ARE THERE FLOW QUANTITY DATA OF PP(i) ?
N
Y
ST7-13
ARE FLOW QUANTITY DATA NECESSARY TO MODIFY ?
N
Y
ST7-14
MODIFY FLOW QUANTITY DATA
1

FIG.16

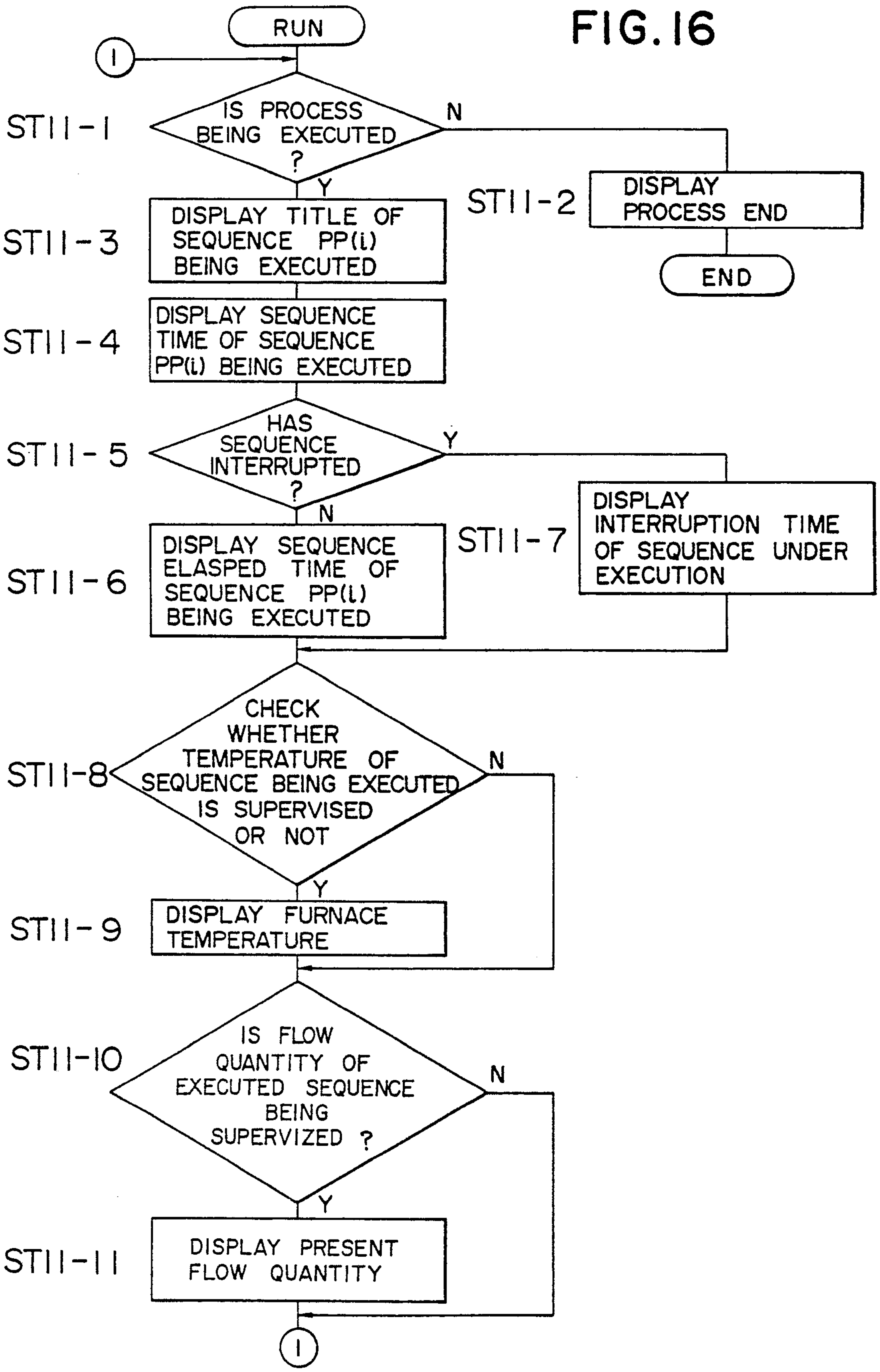
RUN
1
ST11-1
IS PROCESS BEING EXECUTED ?
N
Y
ST11-2
DISPLAY PROCESS END
END
ST11-3
DISPLAY TITLE OF SEQUENCE PP(i) BEING EXECUTED
ST11-4
DISPLAY SEQUENCE TIME OF SEQUENCE PP(i) BEING EXECUTED
ST11-5
HAS SEQUENCE INTERRUPTED ?
Y
N
ST11-7
DISPLAY INTERRUPTION TIME OF SEQUENCE UNDER EXECUTION
ST11-6
DISPLAY SEQUENCE ELASPED TIME OF SEQUENCE PP(i) BEING EXECUTED
ST11-8
CHECK WHETHER TEMPERATURE OF SEQUENCE BEING EXECUTED IS SUPERVISED OR NOT
N
Y
ST11-9
DISPLAY FURNACE TEMPERATURE
ST11-10
IS FLOW QUANTITY OF EXECUTED SEQUENCE BEING SUPERVIZED ?
N
Y
ST11-11
DISPLAY PRESENT FLOW QUANTITY
1

FIG. 17

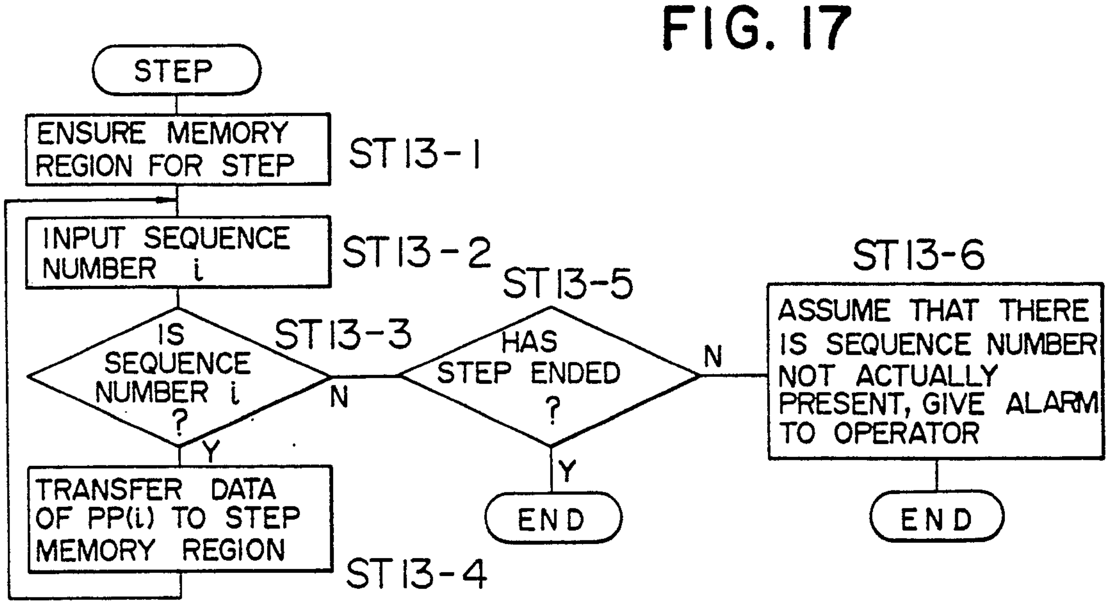
STEP
ENSURE MEMORY REGION FOR STEP
ST13-1
INPUT SEQUENCE NUMBER i
ST13-2
IS SEQUENCE NUMBER i ?
ST13-3
Y
N
TRANSFER DATA OF PP(i) TO STEP MEMORY REGION
ST13-4
HAS STEP ENDED ?
ST13-5
Y
N
END
ST13-6
ASSUME THAT THERE IS SEQUENCE NUMBER NOT ACTUALLY PRESENT, GIVE ALARM TO OPERATOR
END

FIG. 18

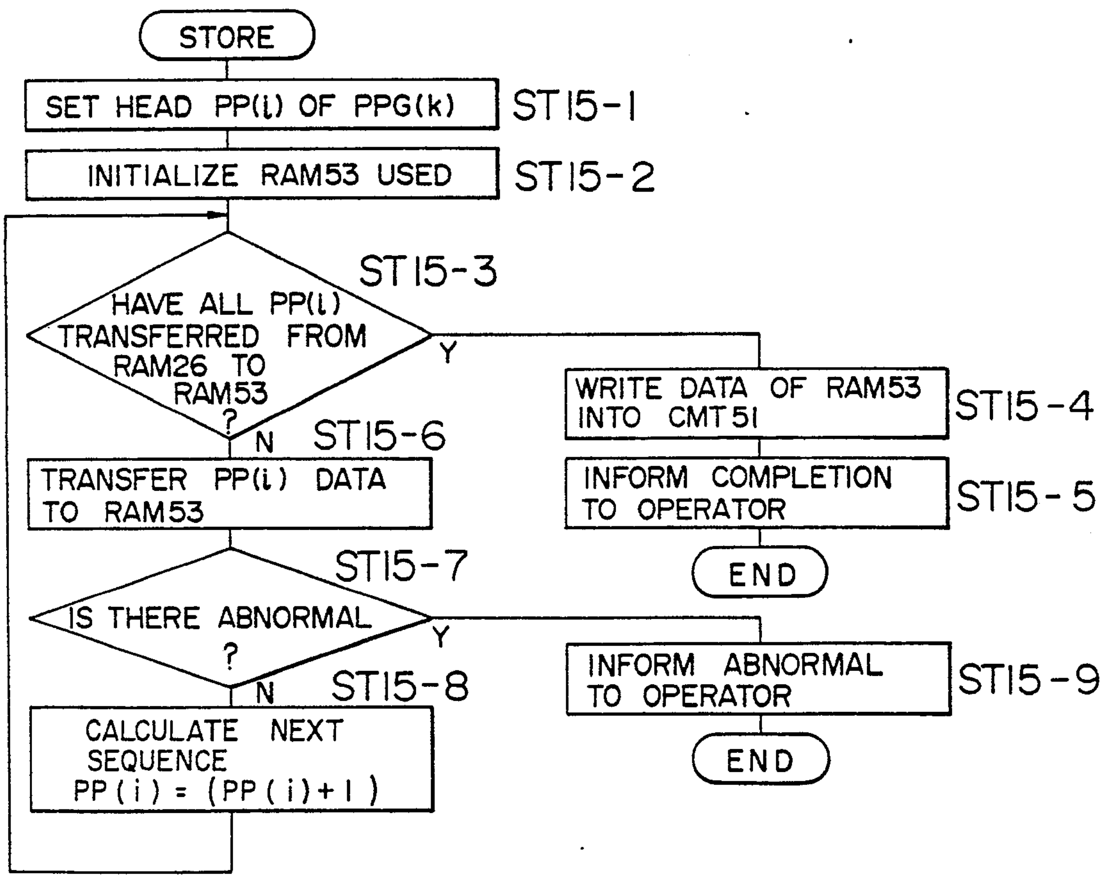
STORE
SET HEAD PP(i) OF PPG(k)
ST15-1
INITIALIZE RAM53 USED
ST15-2
HAVE ALL PP(i) TRANSFERRED FROM RAM26 TO RAM53 ?
ST15-3
Y
N
ST15-6
TRANSFER PP(i) DATA TO RAM53
WRITE DATA OF RAM53 INTO CMT51
ST15-4
INFORM COMPLETION TO OPERATOR
ST15-5
END
IS THERE ABNORMAL ?
ST15-7
Y
N
ST15-8
CALCULATE NEXT SEQUENCE PP(i) = (PP(i)+1)
INFORM ABNORMAL TO OPERATOR
ST15-9
END

FIG.19

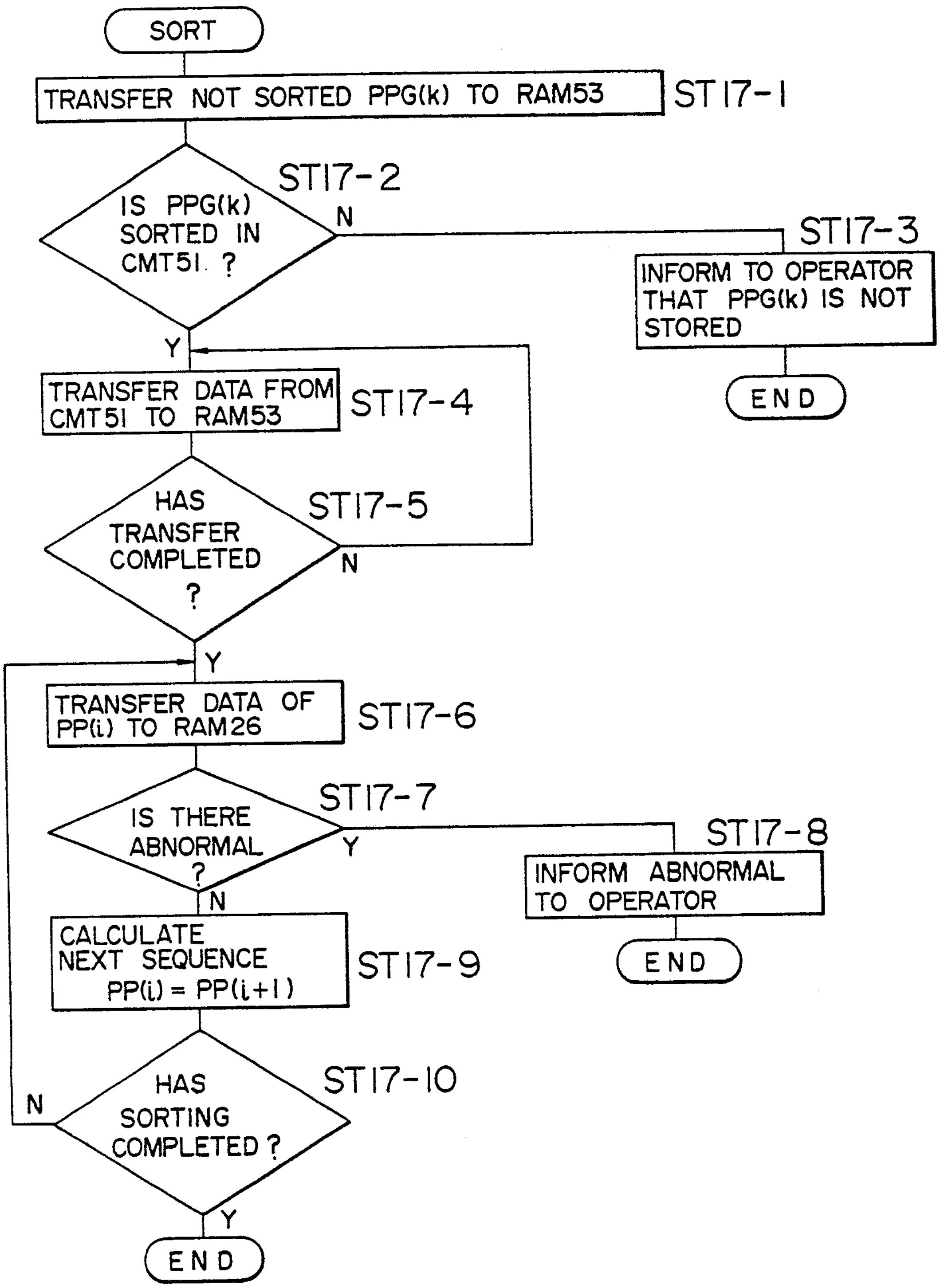
SORT
TRANSFER NOT SORTED PPG(k) TO RAM53
ST17-1
IS PPG(k) SORTED IN CMT51 ?
ST17-2
N
Y
ST17-3
INFORM TO OPERATOR THAT PPG(k) IS NOT STORED
END
TRANSFER DATA FROM CMT51 TO RAM53
ST17-4
HAS TRANSFER COMPLETED ?
ST17-5
N
Y
TRANSFER DATA OF PP(i) TO RAM26
ST17-6
IS THERE ABNORMAL ?
ST17-7
Y
N
ST17-8
INFORM ABNORMAL TO OPERATOR
END
CALCULATE NEXT SEQUENCE PP(i) = PP(i+1)
ST17-9
HAS SORTING COMPLETED ?
ST17-10
N
Y
END

FIG. 20

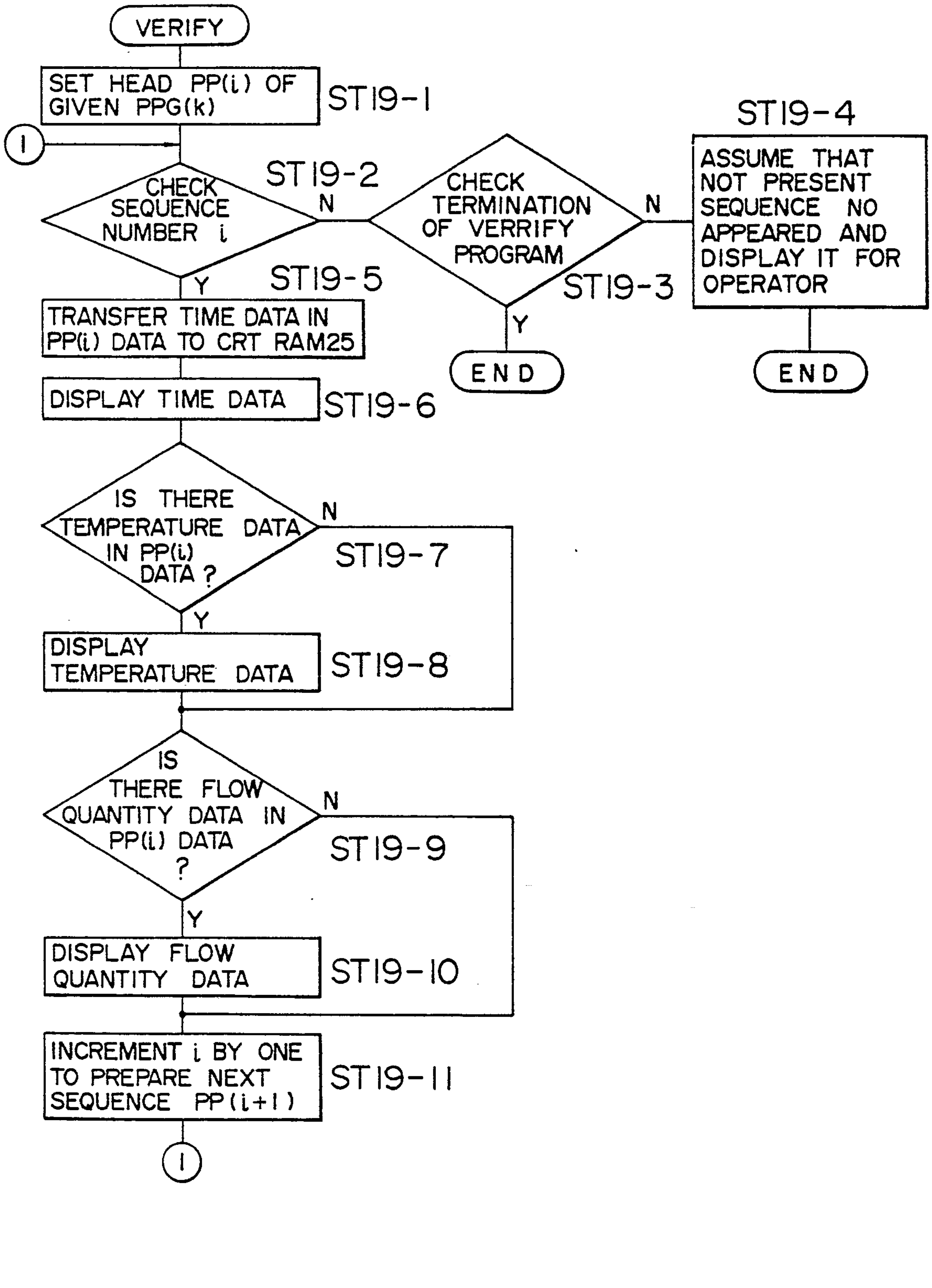
VERIFY
SET HEAD PP(i) OF GIVEN PPG(k)
ST19-1
1
CHECK SEQUENCE NUMBER i
ST19-2
N
CHECK TERMINATION OF VERRIFY PROGRAM
N
ST19-3
ST19-4
ASSUME THAT NOT PRESENT SEQUENCE NO APPEARED AND DISPLAY IT FOR OPERATOR
Y
END
END
Y
ST19-5
TRANSFER TIME DATA IN PP(i) DATA TO CRT RAM25
DISPLAY TIME DATA
ST19-6
IS THERE TEMPERATURE DATA IN PP(i) DATA ?
N
ST19-7
Y
DISPLAY TEMPERATURE DATA
ST19-8
IS THERE FLOW QUANTITY DATA IN PP(i) DATA ?
N
ST19-9
Y
DISPLAY FLOW QUANTITY DATA
ST19-10
INCREMENT i BY ONE TO PREPARE NEXT SEQUENCE PP(i+1)
ST19-11
1

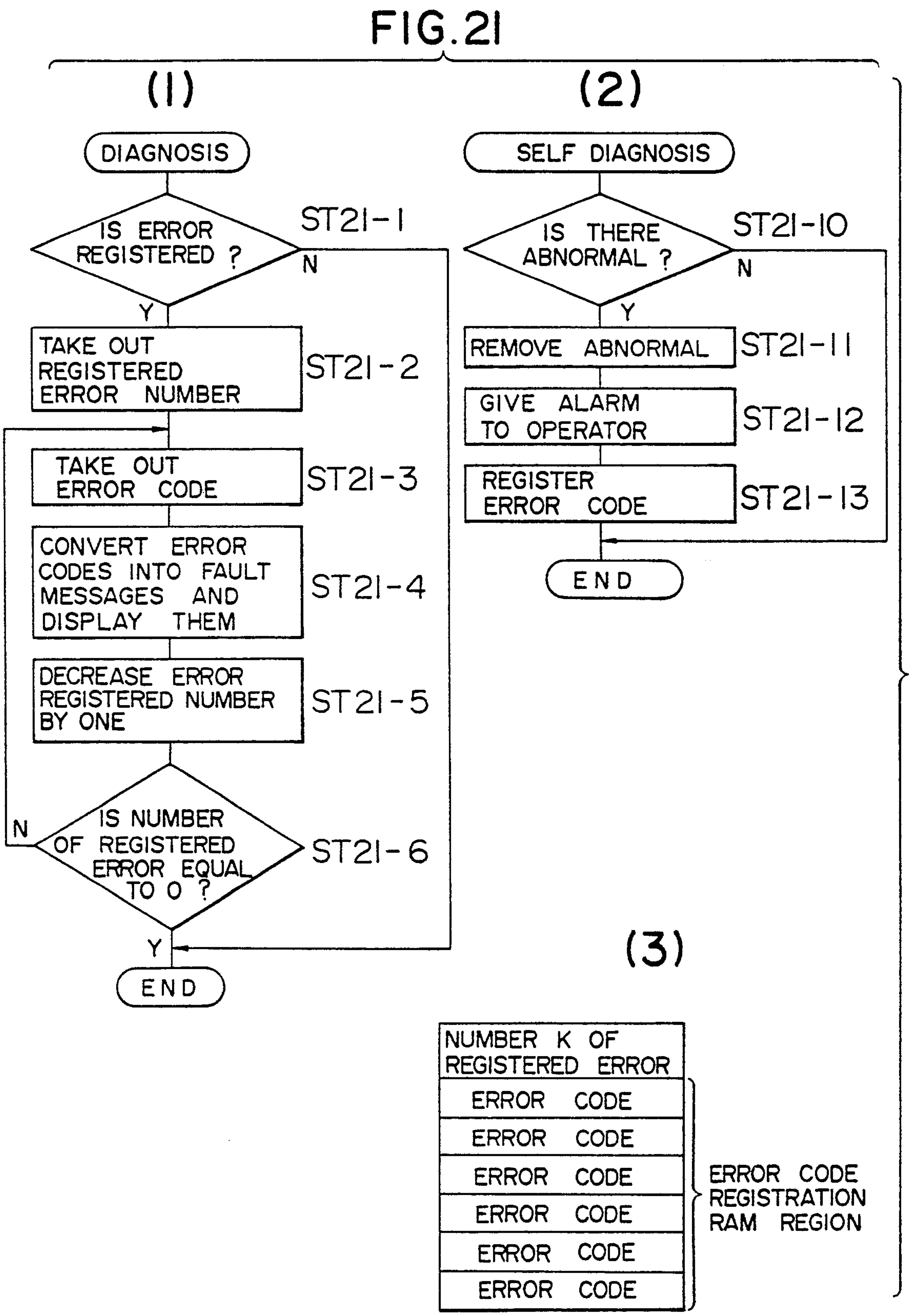
FIG.21
(1)
DIAGNOSIS
IS ERROR REGISTERED ?
ST21-1
N
Y
TAKE OUT REGISTERED ERROR NUMBER
ST21-2
TAKE OUT ERROR CODE
ST21-3
CONVERT ERROR CODES INTO FAULT MESSAGES AND DISPLAY THEM
ST21-4
DECREASE ERROR REGISTERED NUMBER BY ONE
ST21-5
IS NUMBER OF REGISTERED ERROR EQUAL TO 0 ?
ST21-6
N
Y
END
(2)
SELF DIAGNOSIS
IS THERE ABNORMAL ?
ST21-10
N
Y
REMOVE ABNORMAL
ST21-11
GIVE ALARM TO OPERATOR
ST21-12
REGISTER ERROR CODE
ST21-13
END
(3)
NUMBER K OF REGISTERED ERROR
ERROR CODE
ERROR CODE
ERROR CODE
ERROR CODE
ERROR CODE
ERROR CODE
ERROR CODE REGISTRATION RAM REGION

FIG.22

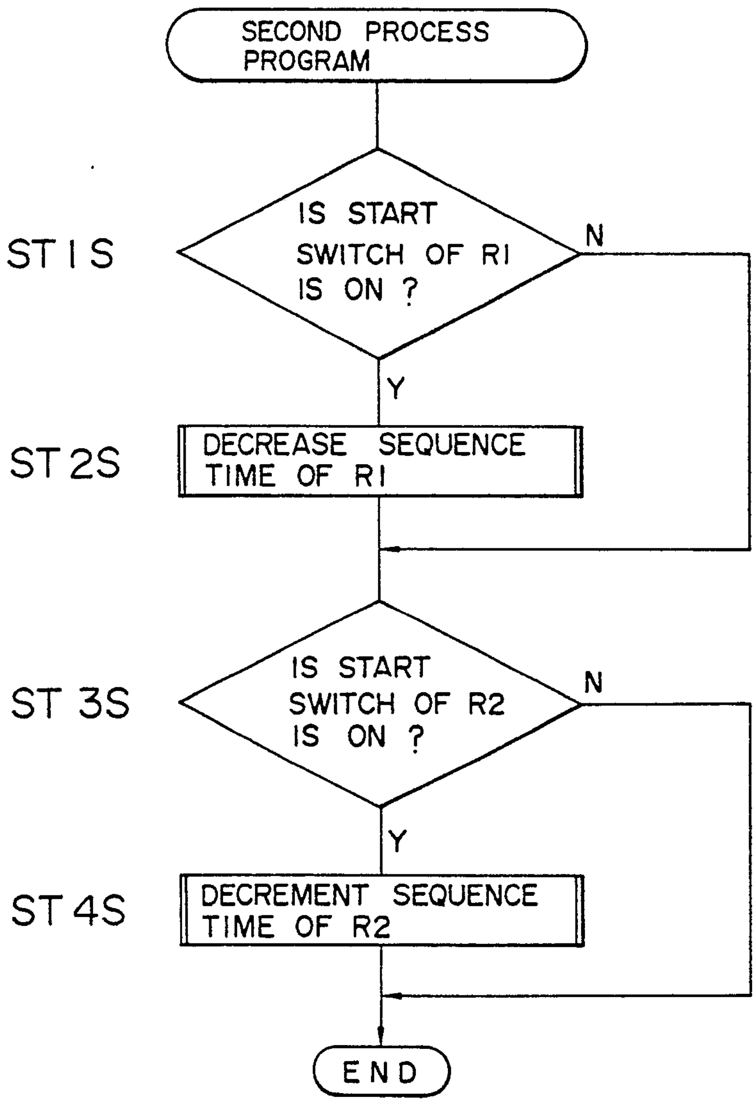
SECOND PROCESS PROGRAM
ST1S
IS START SWITCH OF R1 IS ON ?
N
Y
ST2S
DECREASE SEQUENCE TIME OF R1
ST3S
IS START SWITCH OF R2 IS ON ?
N
Y
ST4S
DECREMENT SEQUENCE TIME OF R2
END

FIG. 23

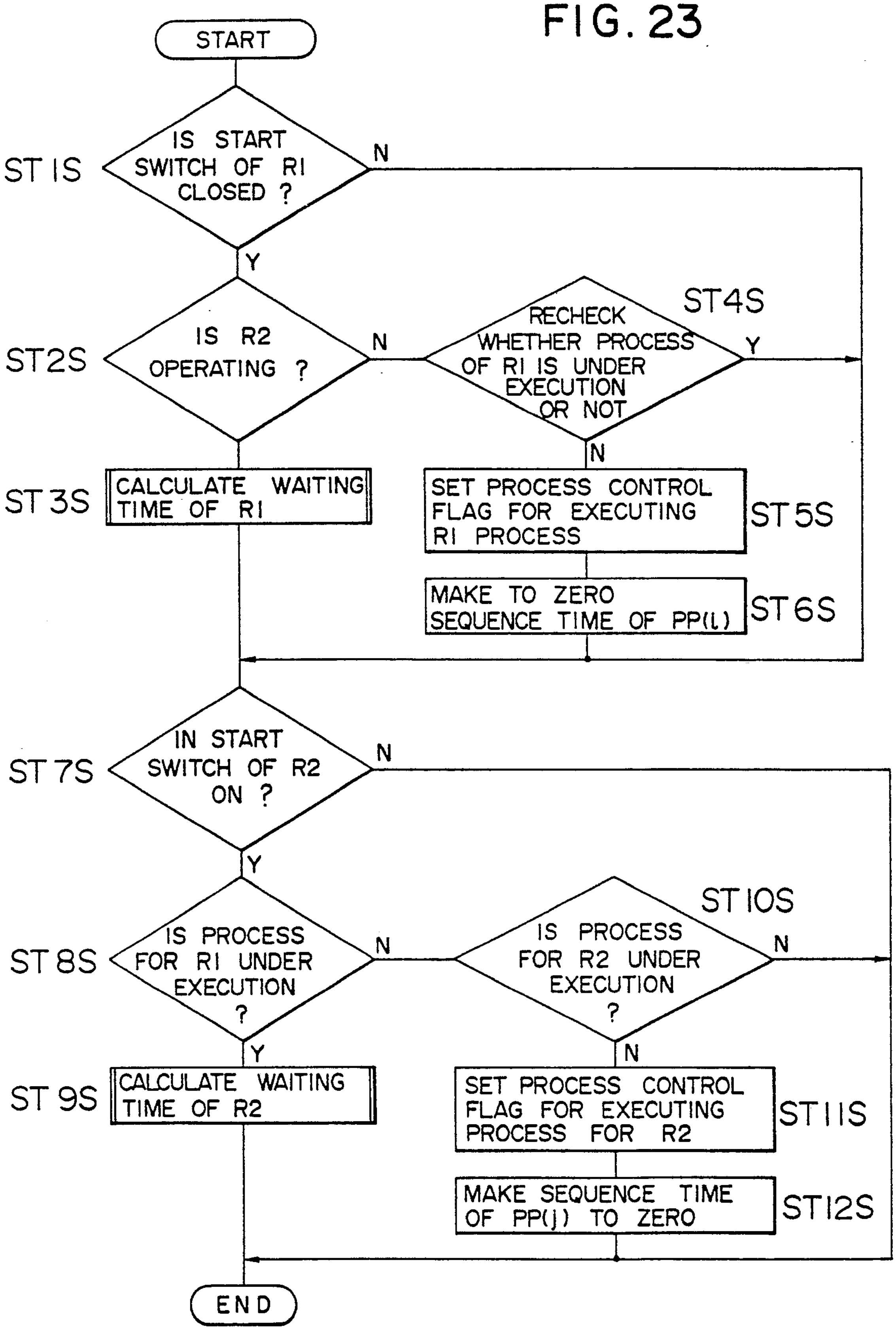
START
ST1S
IS START SWITCH OF R1 CLOSED ?
N
Y
ST2S
IS R2 OPERATING ?
N
ST4S
RECHECK WHETHER PROCESS OF R1 IS UNDER EXECUTION OR NOT
Y
N
ST3S
CALCULATE WAITING TIME OF R1
SET PROCESS CONTROL FLAG FOR EXECUTING R1 PROCESS
ST5S
MAKE TO ZERO SEQUENCE TIME OF PP(l)
ST6S
ST7S
IN START SWITCH OF R2 ON ?
N
Y
ST8S
IS PROCESS FOR R1 UNDER EXECUTION ?
N
ST10S
IS PROCESS FOR R2 UNDER EXECUTION ?
N
Y
N
ST9S
CALCULATE WAITING TIME OF R2
SET PROCESS CONTROL FLAG FOR EXECUTING PROCESS FOR R2
ST11S
MAKE SEQUENCE TIME OF PP(j) TO ZERO
ST12S
END

FIG. 24

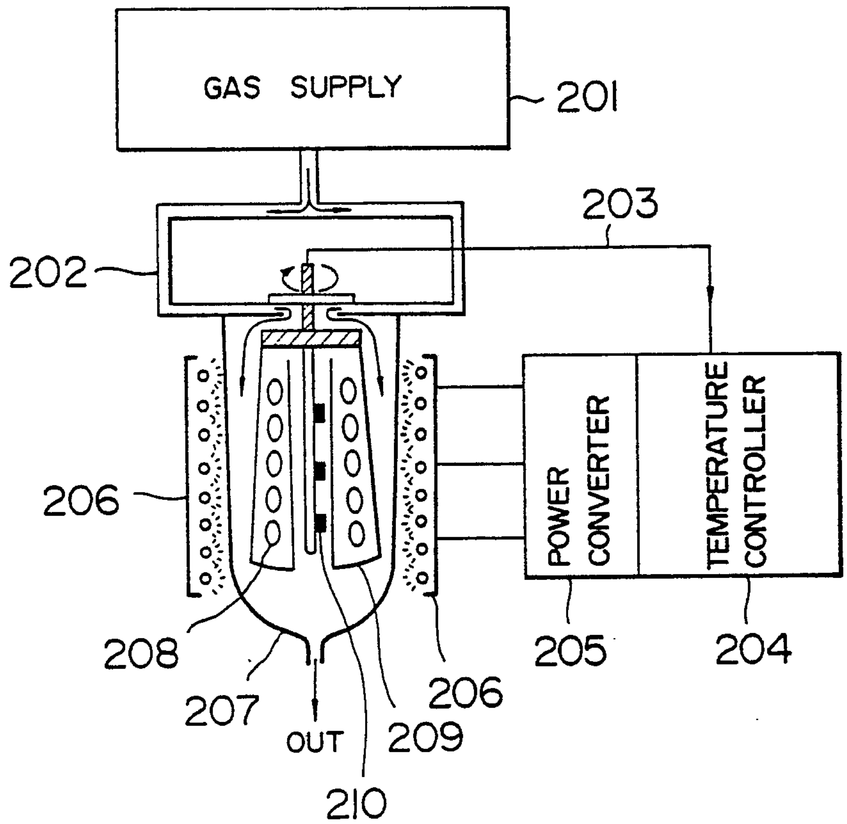
GAS SUPPLY
201
203
202
POWER CONVERTER
TEMPERATURE CONTROLLER
206
208
207
OUT
206
209
210
205
204

FIG. 25

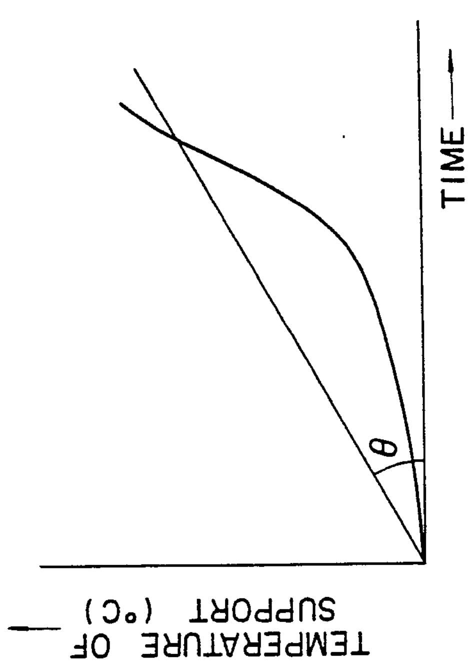


FIG. 26
PRIOR ART

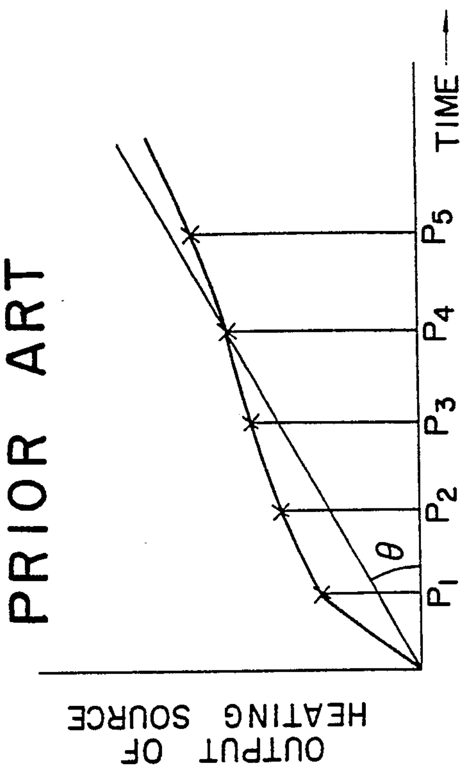


FIG. 27

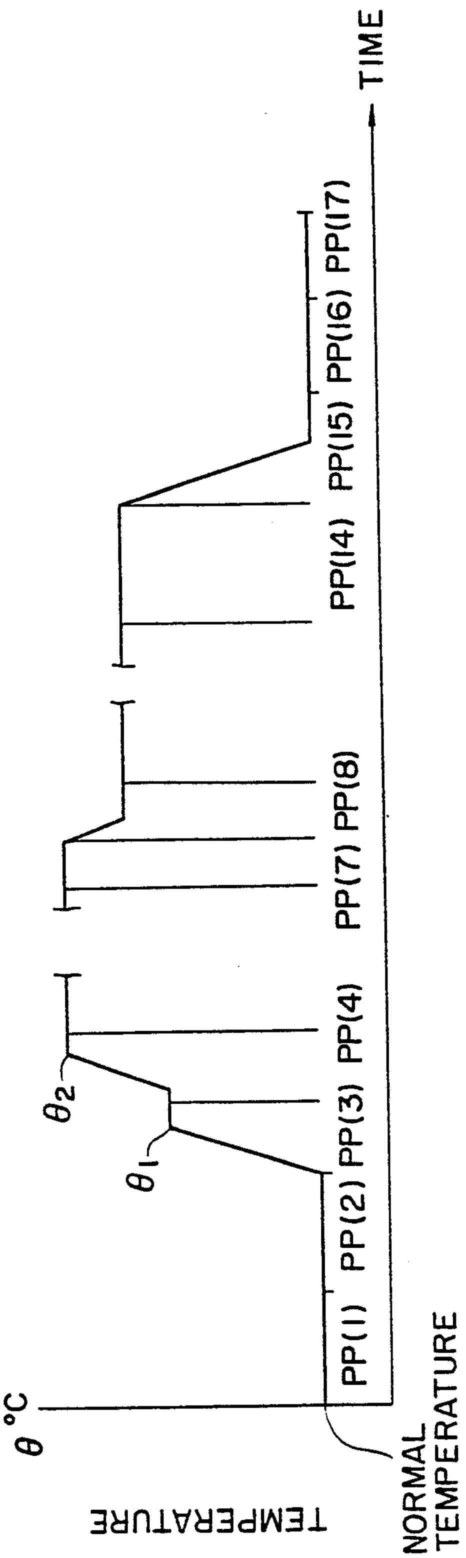

FIG. 28

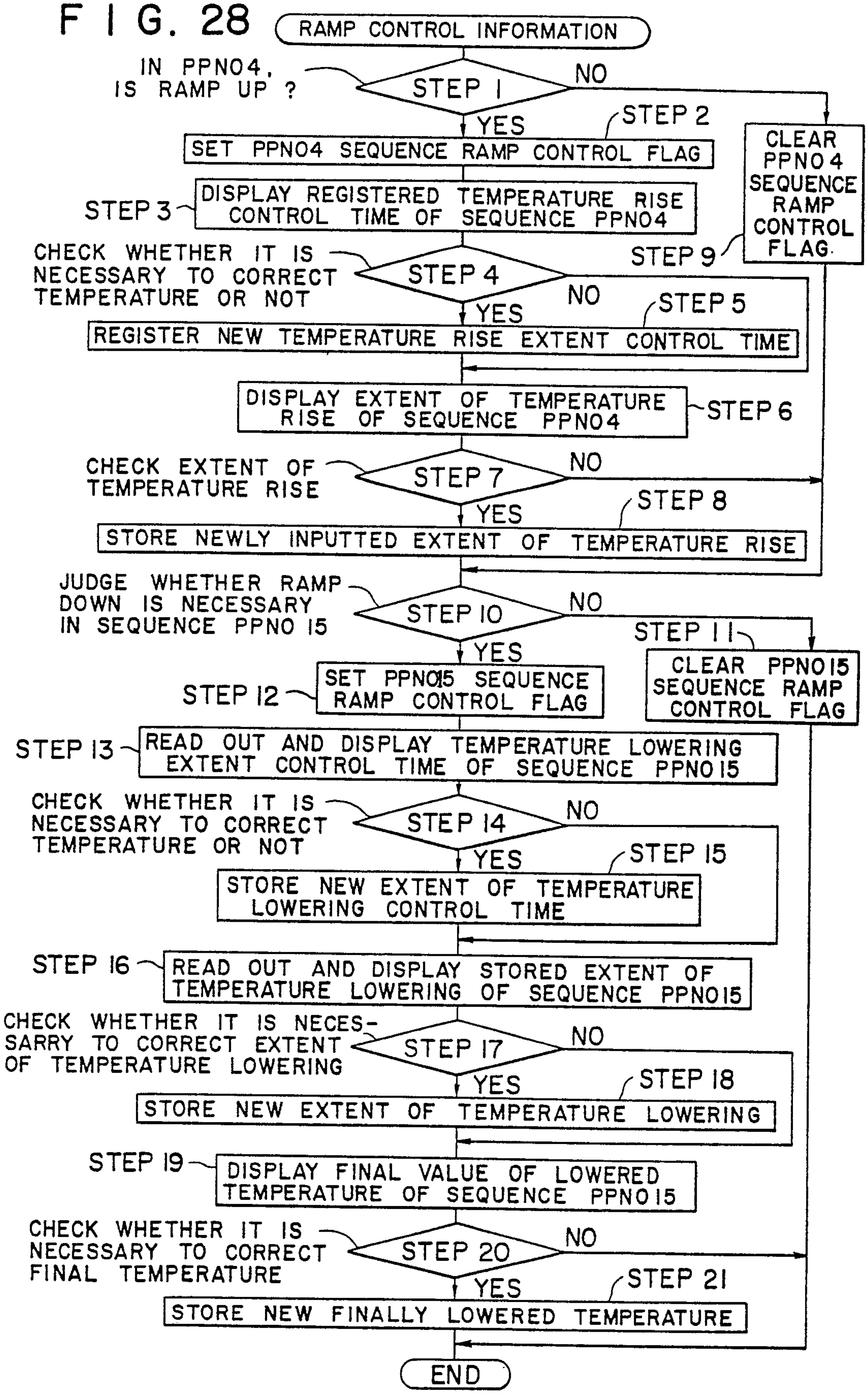
RAMP CONTROL INFORMATION
IN PPNO4, IS RAMP UP ?
STEP 1
NO
YES
STEP 2
SET PPNO4 SEQUENCE RAMP CONTROL FLAG
CLEAR PPNO4 SEQUENCE RAMP CONTROL FLAG
STEP 3
DISPLAY REGISTERED TEMPERATURE RISE CONTROL TIME OF SEQUENCE PPNO4
STEP 9
CHECK WHETHER IT IS NECESSARY TO CORRECT TEMPERATURE OR NOT
STEP 4
NO
YES
STEP 5
REGISTER NEW TEMPERATURE RISE EXTENT CONTROL TIME
DISPLAY EXTENT OF TEMPERATURE RISE OF SEQUENCE PPNO4
STEP 6
CHECK EXTENT OF TEMPERATURE RISE
STEP 7
NO
YES
STEP 8
STORE NEWLY INPUTTED EXTENT OF TEMPERATURE RISE
JUDGE WHETHER RAMP DOWN IS NECESSARY IN SEQUENCE PPNO 15
STEP 10
NO
STEP 11
YES
SET PPNO15 SEQUENCE RAMP CONTROL FLAG
CLEAR PPNO15 SEQUENCE RAMP CONTROL FLAG
STEP 12
STEP 13
READ OUT AND DISPLAY TEMPERATURE LOWERING EXTENT CONTROL TIME OF SEQUENCE PPNO15
CHECK WHETHER IT IS NECESSARY TO CORRECT TEMPERATURE OR NOT
STEP 14
NO
YES
STEP 15
STORE NEW EXTENT OF TEMPERATURE LOWERING CONTROL TIME
STEP 16
READ OUT AND DISPLAY STORED EXTENT OF TEMPERATURE LOWERING OF SEQUENCE PPNO15
CHECK WHETHER IT IS NECES-SARRY TO CORRECT EXTENT OF TEMPERATURE LOWERING
STEP 17
NO
YES
STEP 18
STORE NEW EXTENT OF TEMPERATURE LOWERING
STEP 19
DISPLAY FINAL VALUE OF LOWERED TEMPERATURE OF SEQUENCE PPNO15
CHECK WHETHER IT IS NECESSARY TO CORRECT FINAL TEMPERATURE
STEP 20
NO
YES
STEP 21
STORE NEW FINALLY LOWERED TEMPERATURE
END

FIG. 29

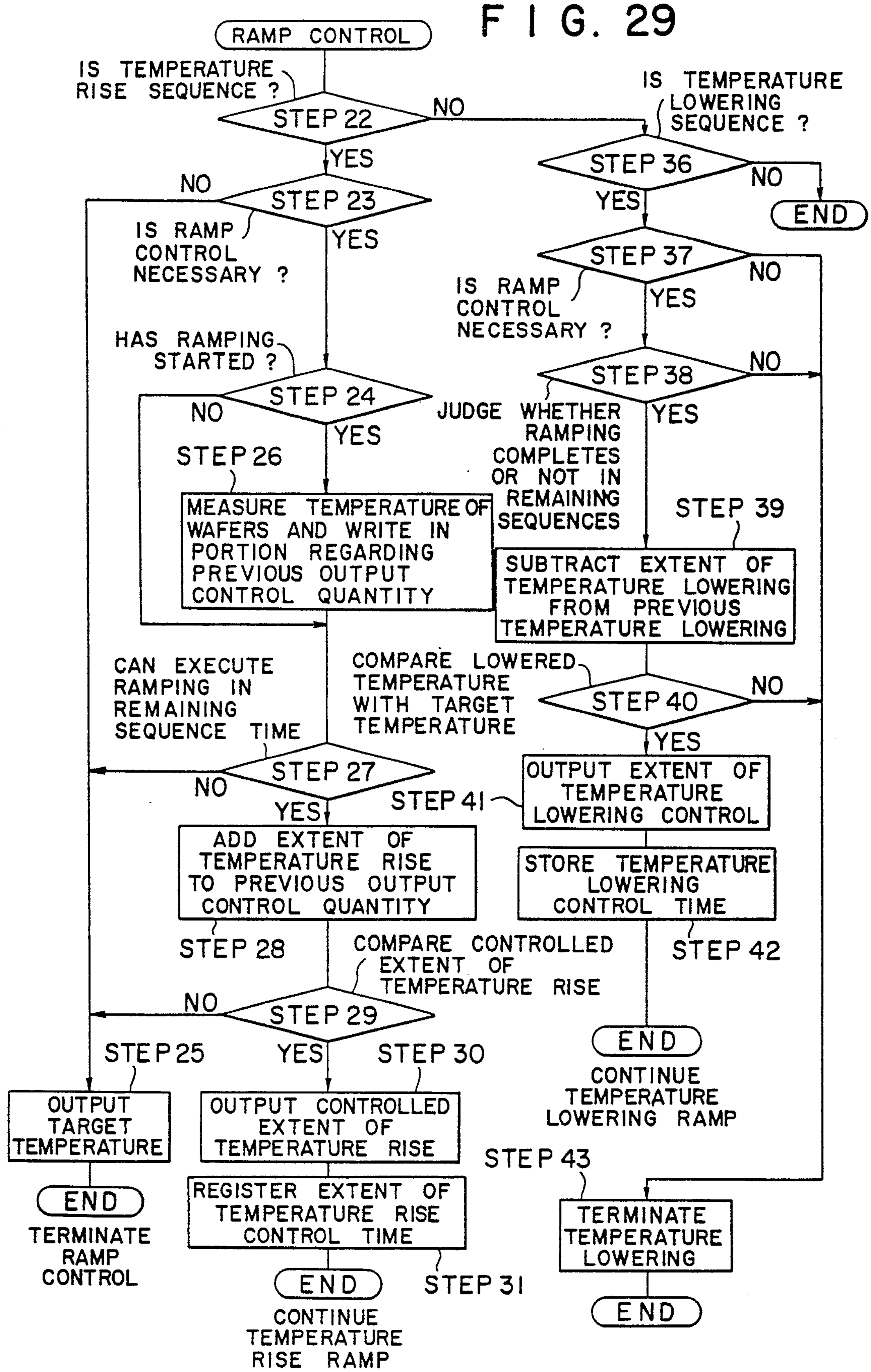
RAMP CONTROL
IS TEMPERATURE RISE SEQUENCE ?
STEP 22
NO
IS TEMPERATURE LOWERING SEQUENCE ?
YES
STEP 36
NO
END
NO
STEP 23
YES
IS RAMP CONTROL NECESSARY ?
YES
STEP 37
NO
IS RAMP CONTROL NECESSARY ?
YES
HAS RAMPING STARTED ?
STEP 38
NO
STEP 24
NO
YES
JUDGE WHETHER RAMPING COMPLETES OR NOT IN REMAINING SEQUENCES
YES
STEP 26
MEASURE TEMPERATURE OF WAFERS AND WRITE IN PORTION REGARDING PREVIOUS OUTPUT CONTROL QUANTITY
STEP 39
SUBTRACT EXTENT OF TEMPERATURE LOWERING FROM PREVIOUS TEMPERATURE LOWERING
CAN EXECUTE RAMPING IN REMAINING SEQUENCE TIME
COMPARE LOWERED TEMPERATURE WITH TARGET TEMPERATURE
STEP 40
NO
YES
STEP 27
NO
YES
STEP 41
OUTPUT EXTENT OF TEMPERATURE LOWERING CONTROL
ADD EXTENT OF TEMPERATURE RISE TO PREVIOUS OUTPUT CONTROL QUANTITY
STORE TEMPERATURE LOWERING CONTROL TIME
STEP 28
COMPARE CONTROLLED EXTENT OF TEMPERATURE RISE
STEP 42
NO
STEP 29
STEP 25
YES
STEP 30
END
CONTINUE TEMPERATURE LOWERING RAMP
OUTPUT TARGET TEMPERATURE
OUTPUT CONTROLLED EXTENT OF TEMPERATURE RISE
STEP 43
END
TERMINATE RAMP CONTROL
REGISTER EXTENT OF TEMPERATURE RISE CONTROL TIME
TERMINATE TEMPERATURE LOWERING
END
STEP 31
CONTINUE TEMPERATURE RISE RAMP
END

FIG. 30

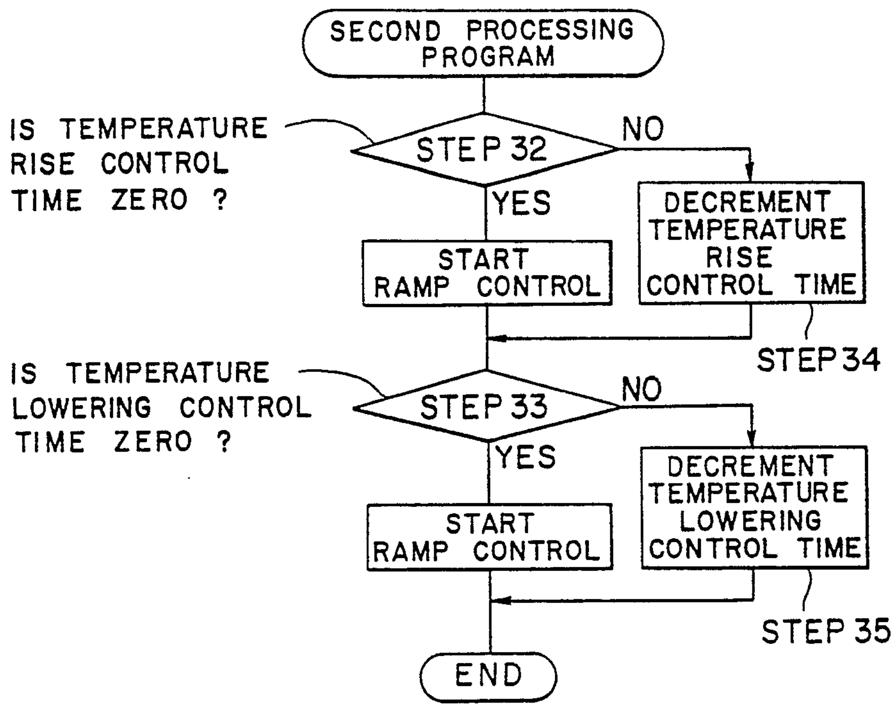
SECOND PROCESSING PROGRAM
IS TEMPERATURE RISE CONTROL TIME ZERO ?
STEP 32
NO
YES
DECREMENT TEMPERATURE RISE CONTROL TIME
START RAMP CONTROL
STEP 34
IS TEMPERATURE LOWERING CONTROL TIME ZERO ?
STEP 33
NO
YES
DECREMENT TEMPERATURE LOWERING CONTROL TIME
START RAMP CONTROL
STEP 35
END